(19) Europäisches Patentamt
European Patent Office
Office européen des brevets

(11) EP 2 650 121 A1

(12) **EUROPEAN PATENT APPLICATION**
published in accordance with Art. 153(4) EPC

(43) Date of publication:
**16.10.2013 Bulletin 2013/42**

(21) Application number: **11846279.5**

(22) Date of filing: **30.11.2011**

(51) Int Cl.:
***B32B 9/00*** *(2006.01)*

(86) International application number:
**PCT/JP2011/077668**

(87) International publication number:
**WO 2012/077553 (14.06.2012 Gazette 2012/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.12.2010 JP 2010271234**

(71) Applicant: **Konica Minolta, Inc.**
**Tokyo 100-7015 (JP)**

(72) Inventors:
- **HONDA, Makoto**
**Hino-shi**
**Tokyo 191-8511 (JP)**
- **TAKEMURA, Chiyoko**
**Hino-shi**
**Tokyo 191-8511 (JP)**

(74) Representative: **Henkel, Breuer & Partner**
**Patentanwälte**
**Maximiliansplatz 21**
**80333 München (DE)**

# (54) GAS-BARRIER FILM, METHOD FOR PRODUCING GAS-BARRIER FILM, AND ELECTRONIC DEVICE

(57) There is provided a gas barrier film which has high barrier performance and is excellent in bending resistance and smoothness as well as cutting processing suitability; a method for producing the gas barrier film; and an electronic device in which the gas barrier film is used. A gas barrier film, comprising a gas barrier layer unit on at least one surface side of a base, wherein the gas barrier layer unit comprises a first barrier layer formed by a chemical vapor deposition method, a second barrier layer obtained by performing conversion treatment to a coating film formed by coating a silicon compound onto the first barrier layer and an intermediate layer between the first barrier layer and the base.

FIG.1

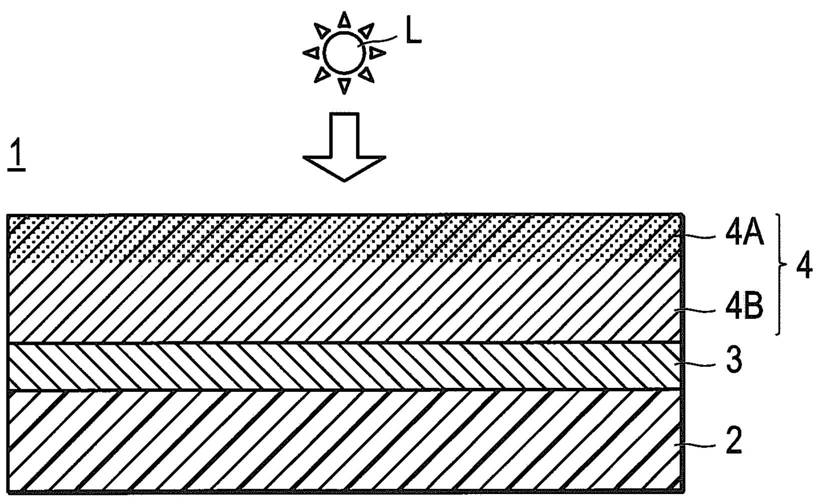


EP 2 650 121 A1

## Description

### TECHNICAL FIELD

The present invention relates to gas barrier films, methods for producing the gas barrier films, and electronic devices in which the gas barrier films are used, and, more specifically, to a gas barrier film used in a package generally for an electronic device or the like, a solar cell, or a display material such as a plastic substrate for an organic EL element, a liquid crystal, or the like, a method for producing the gas barrier film, and an electronic device in which the gas barrier film is used.

### BACKGROUND ART

Conventionally, gas barrier films in which thin films of metal oxides such as aluminum oxide, magnesium oxide, and silicon oxide are formed on plastic substrate and film surfaces have been widely used for purposes of packaging articles needing to be shielded against various gases such as moisture vapor and oxygen and for applications of packaging for preventing food products, industrial products, and pharmaceutical products from deteriorating. Further, in addition to the above- described packaging applications, they have been used in liquid crystal display elements, solar batteries, organic electroluminescence (EL) substrates, and the like.

As a method for producing such a gas barrier film, a method of forming a gas barrier layer by a plasma CVD method (Chemical Vapor Deposition: chemical vapor growth method, chemical vapor deposition method), a method of coating a coating liquid containing polysilazane as a main component, followed by performing surface treatment, or a method of using them in combination is generally known (e.g., see Patent Literatures 1 to 3).

The invention according to Patent Literature 1 discloses that compatibility between increase in thickness for a high gas barrier property and the suppression of cracking is achieved by a lamination formation method by forming a polysilazane film with a film thickness of 250 nm or less by a wet method and then repeating irradiation with vacuum-ultraviolet light twice or more.

However, simply repeated lamination for obtaining a higher gas barrier property has caused a problem that flexibility is not always sufficient to remain in the method according to Patent Literature 1. Furthermore, it has been newly revealed that there is a problem that a phenomenon that a cut end is vigorously cracked together with a film as in the case of glass by stress applied by cutting processing occurs, an effective area for a product is reduced due to cracking of a cut plane, and productivity is poor.

Further, the invention according to Patent Literature 2 discloses a method of further enhancing barrier performance by laminating and coating polysilazane on a gas barrier layer formed on a resin base by a vacuum plasma CVD method and repairing the gas barrier layer by heat treatment. However, its function is insufficient as a gas barrier layer for an organic photoelectric conversion element or the like, so that there has been currently demanded the development of a gas barrier layer having a gas barrier property with a level of a moisture vapor transmission rate of far less than $1\times10^{-2}$ g/m$^2$ ·day. In addition, there has been a drawback that, since the heat treatment of polysilazane for as long as 1 hour at 160°C is required, the scope of its application is limited to a resin base excellent in heat resistance.

Further, the invention according to Patent Literature 3 discloses a production method of coating and smoothing polysilazane to a gas barrier layer obtained by an atmospheric pressure plasma CVD method and thereafter producing a conductive film. As for this manner, although compatibility between a high barrier property and surface smoothness can be achieved, there has been in a current situation a drawback that stress applied during flexure concentrates on the formed gas barrier layer and the gas barrier layer is broken by the unrelaxed stress, so that flexibility is poor.

Citation List

Patent Literature

Patent Literature 1: Japanese Patent Laid-Open No. 2009-255040
Patent Literature 2: Patent No. 3511325
Patent Literature 3: Japanese Patent Laid-Open No. 2008-235165

### SUMMARY OF INVENTION

The present invention is accomplished with respect to the above-described problems and an object thereof is to provide a gas barrier film which has high barrier performance, is excellent in bending resistance and smoothness,

and has cutting processing suitability, a method for producing the gas barrier film, and an electronic device in which the gas barrier film is used.

The above-described object of the present invention is achieved by the following constitutions:

1. A gas barrier film, comprising a gas barrier layer unit on at least one surface side of a base, wherein the gas barrier layer unit comprises a first barrier layer formed by a chemical vapor deposition method, a second barrier layer obtained by performing conversion treatment to a coating film formed by coating a silicon compound onto the first barrier layer and an intermediate layer between the first barrier layer and the base.

2. The gas barrier film according to 1 described above, wherein the first barrier layer formed by the chemical vapor deposition method includes at least one selected from silicon oxide, silicon oxynitride, and silicon nitride.

3. The gas barrier film according to 1 or 2 described above, wherein the second barrier layer formed on the first barrier layer is obtained by performing conversion treatment of a coating film formed by coating a polysilazane-containing liquid and includes a non-conversion region in the base surface side and a conversion region in a surface layer side.

4. The gas barrier film according to 3 described above, wherein a thickness ratio of the thickness of the conversion region located in the surface layer side of the second barrier layer to the total film thickness of the second barrier layer is 0.2 or more and 0.9 or less.

5. The gas barrier film according to 3 or 4 described above, wherein the first barrier layer formed by the chemical vapor deposition method includes silicon oxide or silicon oxynitride; and, assuming that the elasticity modulus of the first barrier layer is E1, the elasticity modulus of the conversion region in the second barrier layer is E2, and the elasticity modulus of the non-conversion region in the second barrier layer is E3, a relationship of E1>E2>E3 is satisfied.

6. A method for producing a gas barrier film according to any one of 3 to 5 described above, wherein the conversion treatment performed when the second barrier layer is formed is treatment of irradiation with a vacuum ultraviolet ray including a wavelength component of 180 nm or less.

7. An electronic device, wherein the gas barrier film according to any one of 1 to 5 described above is used.

Advantageous Effects of Invention

The present invention has made it possible to provide a gas barrier film which is improved in adhesiveness between a barrier layer and a base, has high barrier performance, is excellent in bending resistance and smoothness, and has cutting processing suitability, a method for producing the gas barrier film, and an electronic device in which the gas barrier film is used.

## BRIEF DESCRIPTION OF THE DRAWINGS

[Figure 1] Figure 1 is a schematic cross-sectional view illustrating an example of the preferred layer constitution of the gas barrier film of the present invention.

[Figure 2] Figure 2 is a schematic cross-sectional view illustrating an example of a plasma CVD apparatus usable in accordance with the present invention.

[Figure 3] Figure 3 is a cross-sectional view illustrating an example of the constitution of a solar cell including a bulk heterojunction type organic photoelectric conversion element.

[Figure 4] Figure 4 is a cross-sectional view illustrating an example of the constitution of a solar cell including an organic photoelectric conversion element including a tandem-type bulk heterojunction layer.

[Figure 5] Figure 5 is a cross-sectional view illustrating another example of the constitution of a solar cell including an organic photoelectric conversion element including a tandem-type bulk heterojunction layer.

## DETAILED DESCRIPTION

Embodiments according to the present invention will be described in detail below.

As a result of conducting extensive research with respect to the above-described problems, the present inventors found that a gas barrier film which is improved in adhesiveness between a barrier layer and a base, further has high barrier performance, is excellent in bending resistance and smoothness, and has cutting processing suitability can be realized by the gas barrier film including: a gas barrier layer unit on at least one surface side of a base, the gas barrier layer unit including a first barrier layer formed by a chemical vapor deposition method, a second barrier layer obtained by performing conversion treatment to a coating film formed by coating a silicon compound onto the first barrier layer; and an intermediate layer between the first barrier layer and the base, and the present invention was thus accomplished.

In accordance with an aspect of the present invention, there is preferred a constitution including: a gas barrier

layer unit on at least one surface side of a substrate, the gas barrier layer unit including a first barrier layer formed by a chemical vapor deposition method and a second barrier layer which is formed on the first barrier layer by coating a polysilazane-containing liquid and is thereafter subjected to conversion treatment; and an intermediate layer between the first barrier layer and the base, wherein the second barrier layer further includes a non-conversion region in the base surface side and a conversion region in a surface layer side. As a result, there can be realized a gas barrier film which further has high barrier performance, is excellent in bending resistance and smoothness, and has cutting processing suitability.

Further, the chemical vapor deposition method according to the present invention may be an atmospheric pressure plasma CVD method, a vacuum plasma CVD method or a catalytic chemical vapor phase deposition method and may be selected appropriately. Furthermore, the first barrier layer formed by the chemical vapor deposition method according to the present invention preferably includes at least one selected from silicon oxide, silicon oxynitride, and silicon nitride.

Furthermore, the first barrier layer more preferably has a two- layer constitution formed by a method of laminating a SiN layer formed at a film- formation starting temperature of 170°C or less and containing silicon nitride as a main component on a SiN layer formed at a film- formation starting temperature of 50°C or more and containing silicon nitride as a main component by the chemical vapor deposition method, since barrier performance is greatly improved when a polysilazane- containing liquid is coated onto the barrier layer to form the second barrier layer subj ected to conversion treatment.

The constitution of the gas barrier film according to the present invention will be described below with reference to the drawings.

Figure 1 is a schematic cross-sectional view which illustrating an example of the layer constitution of the gas barrier film of the present invention.

In Figure 1, the gas barrier film 1 of the present invention includes a constitution including an intermediate layer 3 on a base 2; and a gas barrier layer unit 4 constituted by a first barrier layer 4B formed on the intermediate layer 3 by a chemical vapor deposition method and a second barrier layer 4A formed thereon by coating a polysilazane-containing liquid and thereafter performing conversion treatment.

The second barrier layer 4A is obtained by being formed on the first barrier layer 4B and thereafter subjected to conversion treatment using conversion treatment means L such as irradiation with a vacuum ultraviolet ray having a wavelength component of 180 nm or less from an upper part.

In the secondbarrier layer 4A subj ected to the conversion treatment, conversion proceeds in the surface layer side closer to the conversion treatment means L and conversion does not proceed or occur in the first barrier layer 4B surface side, so that a conversion region which is subjected to conversion and a non-conversion region which is not subjected to conversion are formed in the layer.

In accordance with the present invention, as a method of subjecting the second barrier layer 4A to the conversion treatment and thereafter confirming the conversion region which is subjected to the conversion and the non-conversion region which is not subjected to the conversion, while trimming the second barrier layer 4A in a depth direction, its characteristic values such as a density, an elasticity modulus, and a composition ratio (e.g., a ratio of x in $SiO_x$) can be sequentially measured to determine the inflection points of the characteristic values as the interface between the conversion region and the non-conversion region. Furthermore, as the most effective method, the cross section of the produced gas barrier film is cut by a microtome and the obtained ultra-thin section is observed with a transmission electron microscope. In this case, the interface between the conversion region and the non-conversion region is made to be clearly appear by irradiation with an electron beam during the observation and the thickness of the conversion region and the thickness of the non-conversion region can be easily determined by defining the position thereof. A method of confirming the conversion region by the observation with the transmission electron microscope will be described below.

In a preferred aspect of the gas barrier layer according to the present invention, there are included the first barrier layer 4B formed by the chemical vapor deposition method and the second barrier layer 4A which is subj ected to the conversion treatment and includes the non-conversion region and the conversion region. It was found that the constitution in which the non-conversion region is present between the first barrier layer 4B which is dense and the conversion region of the second barrier layer 4A enables suppression of stress concentration on a specific layer during bending to significantly improve bending resistance, and the present invention was thus accomplished.

Furthermore, a film thickness ratio of the thickness of the conversion region formed in the surface side of the second barrier layer 4A according to the present invention to the total film thickness of the second barrier layer 4A is preferably 0.2 or more and 0.9 or less, more preferably 0.3 or more and 0.9 or less, further preferably 0.4 or more and 0.8 or less.

Further, the first barrier layer 4B formed by the chemical vapor deposition method according to the present invention preferably includes silicon oxide or silicon oxynitride, wherein, assuming that the elasticity modulus of the first barrier layer 4B is E1, the elasticity modulus of the conversion region in the second barrier layer 4A is E2, and the

elasticity modulus of the non- conversion region in the second barrier layer 4A is E3, a relationship of E1>E2>E3 is satisfied.

In a method for producing the gas barrier film of the present invention, conversion treatment, to which a second barrier layer is subjected, preferably includes treatment of irradiation with a vacuum ultraviolet ray including a wavelength component of 180 nm or less.

In the electronic device according to the present invention, the gas barrier film of the present invention is used.

Now, a detailed description is made of the components of the gas barrier film of the present invention.

«Gas Barrier Film»

The gas barrier film of the present invention includes a gas barrier layer unit on at least one surface side of a base.

The gas barrier layer unit as used herein includes a first barrier layer formed by a chemical vapor deposition method and a second barrier layer prepared by coating a polysilazane-containing liquid onto the first barrier layer and performing conversion treatment. A gas barrier property can be further improved by constituting a plurality of such gas barrier layer units. In this case, the plurality of gas barrier layer units may be the same or different. Further, in accordance with the present invention, there is preferred a constitution in which gas barrier layer units are placed on both surfaces of a base. In this case, the gas barrier layer units formed on both surfaces of the base may also be the same or different. The formation of the gas barrier units on both surfaces results in suppression of dimensional change due to moisture absorption and desorption by a base film in itself under severe conditions of high temperature and high humidity, reduction in stress on the gas barrier units, and improvement in the durability of a device. Further, the case of using a heat-resistant resin in the base is preferred since the effect of disposing the gas barrier units on both front and back surfaces is large. More specifically, the heat-resistant resin represented by polyimide or polyetherimide, because of being noncrystalline, has a high water absorption percentage, compared with PET or PEN which is crystalline, to result in greater dimensional change of the base due to humidity. The dimensional change of the base due to both high temperature and high humidity can be suppressed by disposing the gas barrier units on both front and back surfaces of the base.

Process temperature may be more than 200°C in an array production step particularly in the case of use for flexible display applications and it is preferable to use a base with high heat resistance. Furthermore, in addition to the base with high heat resistance, a thermosetting resin is particularly preferably used as the intermediate layer according to the present invention.

Further, as for "gas barrier property" according to the present invention, the case of a moisture vapor transmittance (moisture vapor transmission rate) ($60\pm0.5$°C, relative humidity ($90\pm2$) % RH), measured by a method according to JIS K 7129- 1992, of $1\times10^{-3}$ g/ ($m^2\cdot24$ h) or less, is defined as the presence of a gas barrier property. Further, the gas barrier film preferably has an oxygen transmittance (oxygen transmission rate), measured by a method according to JIS K 7126- 1987, of $1\times10^{-3}$ ml/$m^2\cdot24$ h·atm or less (1 atm is $1.01325\times10^5$ Pa) .

[First Barrier Layer]

As one characteristic in accordance with the present invention, a first barrier layer which constitutes the gas barrier film of the present invention is formed by a chemical vapor deposition method. The presence of the first barrier layer enables inhibition of migration of water from a base, so that conversion treatment during forming a second barrier layer proceeds easily.

Generally, examples of methods of forming a functionalized thin film on a base roughly include physical vapor growth methods and chemical vapor growth methods (chemical vapor deposition methods), the physical vapor growth methods are methods of depositing a substance of interest, for example, a thin film such as a carbon film, on a surface of a substance in a vapor phase by a physical procedure, and these methods are vapor deposition (resistance heating method, electron beam deposition, molecular beam epitaxy) methods, ion plating methods, sputtering methods, and the like. On the other hand, the chemical vapor growth methods (chemical vapor deposition methods, Chemical Vapor Deposition) are methods of supplying a source gas containing the components of a thin film of interest onto a base to deposit a film by a chemical reaction on a base surface or in a vapor phase. Further, there are, e.g., methodsofgenerating plasma for the purpose of activating a chemical reaction, examples thereof include known CVD manners such as heat CVD methods, catalytic chemical vapor growth methods, photo CVD methods, plasma CVD methods, and atmospheric pressure plasma CVD methods; and the like, and all thereof may be advantageously used in the present invention. Without particular limitation, it is preferable to apply a plasma CVD method from the viewpoint of a film production rate and a treatment area. Formation of a first barrier layer by a chemical vapor deposition method is advantageous in view of a gas barrier property.

A gas barrier layer obtained by a plasma CVD method or a plasma CVD method under atmospheric pressure or near atmospheric pressure is preferred since a metal carbide, a metal nitride, a metal oxide, a metal sulfide, a metal halide, or a mixture thereof (such as a metal oxynitride, a metal oxide-halide, or a metal nitride-carbide) can be separately

produced by selecting conditions of a metal compound which is a raw material (also referred to as source material), a decomposition gas decomposition temperature, an input power, and the like.

Silicon oxide is generated, for example, by using a silicon compound as a source compound and oxygen as a decomposition gas. Further, zinc sulfide is generated by using a zinc compound as a source compound and carbon disulfide as a decomposition gas. This is because very active charged particles/active radicals are present at high density in plasma space, a multi-stage chemical reaction is therefore promoted at a very high speed in the plasma space, and elements present in the plasma space are converted into a thermodynamically stable compound in a very short time.

Such a source material may be in any gas, liquid, or solid state under ordinary temperature and normal pressure as long as it includes a main group or transition metal element. It can be introduced without being processed into discharge space when it is gas whereas it is vaporized by means such as heating, bubbling, decompression, or ultrasonic irradiation and is used when it is liquid or solid. Further, it may also be diluted with a solvent and used, and, as the solvent, organic solvents such as methanol, ethanol and n-hexane, and mixed solvents thereof may be used. Since these diluent solvents are decomposed in a molecular or atomic state during plasma discharge treatment, their influences can be almost disregarded.

However, a compound having a vapor pressure in a temperature range of 0°C to 250°C under atmospheric pressure is preferred, and a compound that exhibits a liquid state in a temperature range of 0°C to 250°C is more preferred. This is because the inside of a plasma film production chamber has a near atmospheric pressure, it is therefore difficult to feed a gas into the plasma film production chamber when vaporization under atmospheric pressure is impossible, and a feeding amount into the plasma film production chamber can be managed with greater accuracy in the case where a source compound is liquid. When the heat resistance of a plastic film with which a gas barrier layer is produced is 270°C or less, a compound having a vapor pressure at not more than a temperature that is less than the heat- resistant temperature of the plastic film by 20°C is preferred.

Examples of such metal compounds include, but are not particularly limited to, silicon compounds, titanium compounds, zirconium compounds, aluminum compounds, boron compounds, tin compounds, organometallic compounds, and the like.

Among them, examples of the silicon compounds include silane, tetramethoxysilane, tetraethoxysilane, tetra-n- propoxysilane, tetraisopropoxysilane, tetra- n- butoxysilane, tetra- t- butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3, 3, 3- trifluoropropyl) trimethoxysilane, hexamethyldisiloxane, bis (dimethylamino) dimethylsilane, bis (dimethylamino) methylvinylsilane, bis (ethylamino) dimethylsilane, N, O- bis (trimethylsilyl) acetamide, bis (trimethylsilyl) carbodiimide, diethylaminotrimethylsilane, dimethylaminodimethylsilane, hexamethyldisilazane, heaxamethylcyclotrisilazane, heptamethyldisilazane, nonamethyltrisilazane, octamethylcyclotetrasilazane, tetrakisdimethylaminosilane, tetraisocyanatesilane, tetramethyldisilazane, tris (dimethylamino) silane, triethoxyfluorosilane, allyldimethylsilane, allyltrimethylsilane, benzyltrimethylsilane, bis (trimethylsilyl) acetylene, 1, 4- bistrimethylsilyl- 1, 3- butadiine, di- t- butylsilane, 1, 3- disilabutane, bis (trimethylsilyl) methane, cyclopentadienyltrimethylsilane, phenyldimethylsilane, phenyltrimethylsilane, propargyltrimethylsilane, tetramethylsilane, trimethylsilylacetylene, 1- (trimethylsilyl)- 1- propine, tris (trimethylsilyl) methane, tris (trimethylsilyl) silane, vinyltrimethylsilane, hexamethyldisilane, octamethylcyclotetrasiloxane, tetramethylcyclotetrasiloxane, hexamethylcyclotetrasiloxane, M silicate 51, and the like.

Examples of the titanium compounds include titanium methoxide, titanium ethoxide, titanium isopropoxide, titanium tetraisopropoxide, titanium n- butoxide, titanium diisopropoxide (bis- 2, 4- pentanedionate), titanium diisopropoxide (bis- 2, 4- ethylacetoacetate), titanium di- n- butoxide (bis- 2, 4- pentanedionate), titanium acetylacetonate, butyl titanate dimer, and the like.

Examples of the zirconium compounds include zirconium n-propoxide, zirconium n-butoxide, zirconium t-butoxide, zirconium tri-n-butoxide acetylacetonate, zirconium di-n-butoxide bisacetylacetonate, zirconium acetylacetonate, zirconium acetate, zirconium hexafluoropentanedionate, and the like.

Examples of the aluminum compounds include aluminum ethoxide, aluminum triisopropoxide, aluminum isopropoxide, aluminum n- butoxide, aluminum s- butoxide, aluminum t- butoxide, aluminum acetylacetonate, triethyldialuminum tri- s- butoxide, and the like.

Examples of the boron compounds include diborane, tetraborane, boron fluoride, boron chloride, boron bromide, borane- diethyl ether complex, borane- THF complex, borane- dimethyl sulfide complex, boron trifluoride diethyl ether complex, triethylborane, trimethoxyborane, triethoxyborane, tri (isopropoxy) borane, borazol, trimethylborazol, triethylborazol, triisopropylborazol, and the like.

Examples of the tin compounds include tetraethyltin, tetramethyltin, diaceto- di- n- butyltin, tetrabutyltin, tetraoctyltin, tetraethoxytin, methyltriethoxytin, diethyldiethoxytin, triisopropylethoxytin, diethyltin, dimethyltin, diisopropyltin, dibutyltin, diethoxytin, dimethoxytin, diisopropoxytin, dibutoxytin, tin dibutylate, tin diacetoacetonate, ethyltin acetoacetonate, ethoxytin acetoacetonate, dimethyltin diacetoacetonate, and the like; tin hydride and the like; and tin halides such as tin dichloride and tin tetrachloride.

Further, examples of the organometallic compounds include antimony ethoxide, arsenic triethoxide, barium 2,2, 6, 6- tetramethylheptanedionate, beryllium acetylacetonate, bismuth hexafluoropentanedionate, dimethylcadmium, calcium 2, 2, 6, 6- tetramethylheptanedionate, chromium trifluoropentanedionate, cobalt acetylacetonate, copper hexafluoropentanedionate, magnesium hexafluoropentanedionate- dimethylether complex, gallium ethoxide, tetraethoxygermanium, tetramethoxygermanium, hafniumt- butoxide, hafniumethoxide, indium acetylacetonate, indium 2, 6- dimethylaminoheptanedionate, ferrocene, lanthanum isopropoxide, lead acetate, tetraethyllead, neodymium acetylacetonate, platinum hexafluoropentanedionate, trimethylcyclopentadienyl- platinum, rhodium dicarbonylacetylacetonate, strontium 2, 2, 6, 6- tetramethylheptanedionate, tantalum methoxide, tantalum trifluoroethoxide, tellurium ethoxide, tungsten ethoxide, vanadium triisopropoxideoxide, magnesium hexafluoroacetylacetonate, zinc acetylacetonate, diethylzinc, and the like.

Further, examples of decomposition gases for decomposing source gases containing these metals to obtain inorganic compounds include hydrogen gas, methane gas, acetylene gas, carbon monoxide gas, carbon dioxide gas, nitrogen gas, ammonium gas, nitrogen monoxide gas, nitrogen oxide gas, nitrogen dioxide gas, oxygen gas, moisture vapor, fluorine gas, hydrogen fluoride, trifluoroalcohol, trifluorotoluene, hydrogen sulfide, sulfur dioxide, carbon disulfide, chlorine gas, and the like. The above- described decomposition gases may also be mixed with inert gases such as argon gas and helium gas.

A desired barrier layer can be obtained by appropriately selecting a source gas containing a metallic element and a decomposition gas. A first barrier layer formed by a chemical vapor deposition method is preferably a metal carbide, a metal nitride, a metal oxide, a metal halide, a metal sulfide, or a composite compound thereof, from the viewpoint of transparency. Specifically, the first barrier layer is constituted by, e.g., silicon oxide, silicon oxynitride, silicon nitride, aluminum oxide, or the like, preferably contains at least one selected from silicon oxide, silicon oxynitride or silicon nitride in view of a gas barrier property and transparency, and preferably contains at least one selected from silicon oxide or silicon oxynitride. Further, it is desirable that the first barrier layer be formed substantially or completely as an inorganic layer.

The first barrier layer preferably has a film thickness of 50 to 600 nm, more preferably 100 to 500 nm, without particular limitation. Such a range results in excellent high gas barrier performance, bending resistance, and cutting processing suitability.

A plasma CVD method will be specifically described below.

Figure 2 is a schematic cross-sectional view illustrating an example of a plasma CVD apparatus usable in accordance with the present invention.

In Figure 2, a plasma CVD apparatus 101 includes a vacuum tank 102 and a susceptor 105 is placed on the bottom surface side of the inside of the vacuum tank 102.

A cathode electrode 103 is placed at a position, facing the susceptor 105, on the ceiling side of the inside of the vacuum tank 102.

A heat medium circulating system 106, a vacuum pumping system 107, a gas introduction system 108, and a high frequency power source 109 are placed outside the vacuum tank 102.

A heat medium is placed in the heat medium circulating system 106. A heating cooling apparatus 160 including a pump which moves the heat medium, a heating apparatus which heats the heat medium, a cooling apparatus which cools it, a temperature sensor with which the temperature of the heat medium is measured, and a memory apparatus which memorizes a set temperature for the heat medium is disposed in the heat medium circulating system 106.

The heating cooling apparatus 160 is constituted to measure the temperature of the heat medium, to heat or cool the heat medium to the memorized set temperature, and to supply the heat medium to the susceptor 105. The supplied heat medium flows into the susceptor 105, heats or cools the susceptor 105, and returns to the heating cooling apparatus 160. The temperature of the heat medium is higher or lower than the set temperature when this occurs, and the heating cooling apparatus 160 heats or cools the heat medium to the set temperature and supplies the heat medium to the susceptor 105. A cooling medium is circulated between the susceptor and the heating cooling apparatus 160 in this manner and the susceptor 105 is heated or cooled by the supplied heat medium at the set temperature.

The vacuum tank 102 is connected to the vacuum pumping system 107, and, prior to starting film formation treatment by the plasma CVD apparatus 101, the heat medium has been heated to increase its temperature from room temperature to the set temperature while preevacuating the inside of the vacuum tank 102 and the heat medium at the set temperature has been supplied to the susceptor 105. The susceptor 105 is at room temperature when beginning to be used and the supply of the heat medium at the set temperature results in increase in the temperature of the susceptor 105.

The heat medium at the set temperature is circulated for given time and a substrate 110 to be film-formed is thereafter conveyed into the vacuum tank 102 while maintaining vacuum atmosphere in the vacuum tank 102 and is placed on the susceptor 105.

A large number of nozzles (pore) are formed in the surface, facing the susceptor 105, of the cathode electrode 103.

The cathode electrode 103 is connected to the gas introduction system 108, and a CVD gas is spouted from

the nozzles of the cathode electrode 103 into the vacuum tank 102 with vacuum atmosphere by introducing the CVD gas from the gas introduction system 108 into the cathode electrode 103.

The cathode electrode 103 is connected to the high frequency power source 109 and the susceptor 105 and the vacuum tank 102 are connected to a ground potential.

Plasma of the introduced CVD gas is formed by supplying the CVD gas from the gas introduction system 108 into the vacuum tank 102, starting the high frequency power source 109 while supplying the heat medium at given temperature from the heating cooling apparatus 160 to the susceptor 105, and applying a high-frequency voltage to the cathode electrode 103.

When the CVD gas activated in the plasma arrives at the surface of the substrate 110 on the susceptor 105, a thin film grows on the surface of the substrate 110.

During the growth of the thin film, the thin film is formed in the state where the heat medium at the given temperature has been supplied from the heating cooling apparatus 160 to the susceptor 105 and the susceptor 105 is heated or cooled by the heat medium and maintained at given temperature. Generally, the lower limit temperature of growth temperature at which the thin film is formed depends on the film quality of the thin film while the upper limit temperature thereof depends on the permissible range of damage to the thin film that has been already formed on the substrate 110.

The lower limit temperature and the upper limit temperature depend on the material quality of the thin film to be formed, the material quality of the thin film that has been already formed, and/or the like, and the lower limit temperature is 50°C and the upper limit temperature is not more than the heat-resistant temperature of the base to secure the film quality when a SiN film or a SiON film, used in a high barrier film and/or the like, is formed.

The correlation between the film quality of the thin film formed by the plasma CVD method and film formation temperature and the correlation between damage to an article to be film-formed (substrate 110) and film formation temperature are predetermined. For example, during a plasma CVD process, the lower limit temperature of the substrate 110 is 50°C and the upper limit temperature thereof is 250°C.

Furthermore, when a high- frequency voltage of 13.56 MHz or more is applied to the cathode electrode 103 to formplasma, the relationship between the temperature of the heat medium supplied to the susceptor 105 and the temperature of the substrate 110 has been premeasured and the temperature of the heat medium supplied to the susceptor 105 has been determined to maintain the temperature of the substrate 110 at the lower limit temperature or more and the upper limit temperature or less during the plasma CVD process.

For example, it is set to memorize the lower limit temperature (50°C in this case) and to supply the heat medium, of which the temperature is controlled to the lower limit temperature or more, to the susceptor 105. The heat medium flowing back from the susceptor 105 is heated or cooled and the heat medium at the set temperature of 50°C is supplied to the susceptor 105. For example, a mixed gas of silane gas and ammonia gas with nitrogen gas or hydrogen gas is supplied as the CVD gas to form a SiN film in the state where the temperature of the substrate 110 is maintained at the lower limit temperature or more and the upper limit temperature or less.

Immediately after starting the plasma CVD apparatus 101, the susceptor 105 is at room temperature and the temperature of the heat medium flowing back from the susceptor 105 to the heating cooling apparatus 160 is lower than the set temperature. Thus, immediately after the start, the heating cooling apparatus 160 heats the heat medium flowing back to increase its temperature to the set temperature and supplies the heat medium to the susceptor 105. In this case, the susceptor 105 and the substrate 110 are heated by the heat medium to increase its temperature and the substrate 110 is maintained in the range of the lower limit temperature or more and the upper limit temperature or less.

The temperature of the susceptor 105 is increased due to heat flowing in from plasma by consecutively forming thin films on a plurality of substrates 110. In this case, the heat medium flowing back from the susceptor 105 to the heating cooling apparatus 160 has higher temperature than the lower limit temperature (50°C) and the heating cooling apparatus 160 therefore cools the heat medium and supplies the heat medium at the set temperature to the susceptor 105. As a result, the thin films can be formed while maintaining the substrates 110 in the range of the lower limit temperature or more and the upper limit temperature or less.

As described above, the heating cooling apparatus 160 heats the heat medium in the case in which the temperature of the heat medium flowing back is lower than the set temperature and cools the heat medium in the case in which the temperature thereof is higher than the set temperature, the heat medium at the set temperature is supplied to the susceptor in both cases, and the substrate 110 is therefore maintained in the temperature range of the lower limit temperature or more and the upper limit temperature or less.

After formation of the thin film with a predetermined film thickness, the substrate 110 is conveyed outside the vacuum tank 102, a substrate 110 on which no film has been formed is conveyed into the vacuum tank 102, and a thin film is formed while supplying the heat medium at the set temperature in the same manner as described above.

An example of the method for forming a first barrier layer by a vacuum plasma CVD method is given above, and, as the method for forming a first barrier layer, a plasma CVD method without the need for vacuum is preferred and an atmospheric pressure plasma CVD method is further preferred.

The atmospheric pressure plasma CVD method by which plasma CVD treatment is carried out at near atmospheric pressure has high productivity without the need for pressure reduction as well as a high film formation rate due to high plasma density in comparison with a plasma CVD method under vacuum, and further provides an extremely homogeneous film since the mean free step of a gas is very short on a high pressure condition under atmospheric pressure in comparison with the conditions of an ordinary CVD method.

In the case of the atmospheric pressure plasma treatment, nitrogen gas or an element from Group 18 of the periodic table, specifically, helium, neon, argon, krypton, xenon, radon, or the like is used as a discharge gas. Of these, nitrogen, helium, and argon are preferably used, and, particularly, nitrogen is preferred also in view of the low cost.

<Atmospheric Pressure Plasma Treatment in which Two or More Electric Fields with Different Frequencies Are Superposed>

Preferred embodiments of the atmospheric pressure plasma treatment will be described below.

The atmospheric pressure plasma treatment preferably employs a manner in which two or more electric fields having different frequencies are formed in the discharge space by forming an electric field obtained by superposing a first high frequency electric field and a second high frequency electric field as described in WO 2007/026545.

Specifically, it is preferable that the frequency of the second high frequency electric field $\omega 2$ be higher than the frequency of the first high frequency electric field $\omega 1$, the relationship among the strength of the first high frequency electric field V1, the strength of the second high frequency electric field V2, and the strength of the discharge starting electric field IV meet

$$V1 \geq IV > V2 \text{ or } V1 > IV \geq V2$$

and the power density of the second high frequency electric field b
e 1 W/cm$^2$ or more.

By adopting such electric discharge conditions, for example, even a discharge gas having a high discharge starting electric field, such as nitrogen gas, can start discharge, a high density and stable plasma state can be maintained, and thin film formation with high performance can be carried out.

When nitrogen is used as a discharge gas by the above-mentioned measurement, the strength of a discharge starting electric field IV (1/2Vp-p) is around 3.7 kV/mm; and, therefore, nitrogen gas can be excited to cause a plasma state by applying an electric field of which the strength of the first high frequency electric field meets $V1 \geq 3.7$ kV/mm in the above-described relationship.

As the frequency of the first power source, 200 kHz or less can be preferably used. Further, the waveform of the electric field may be a continuous wave or a pulse wave. The lower limit is desirably around 1 kHz.

On the other hand, as the frequency of the second power source, 800 kHz or more is preferably used. The higher the frequency of the second power source is, the higher the density of the plasma is, whereby a dense and high quality thin film can be obtained. The upper limit is desirably around 200 MHz.

The formation of high frequency electric fields from such two electric sources is necessary for starting the electric discharge of a discharge gas having a high strength of a discharge starting electric field by the first high frequency electric field, and a dense and high quality thin film can be formed by a higher plasma density caused by the high frequency and the high power density of the second high frequency electric field.

An atmospheric pressure or a near pressure thereof as used herein is around 20 kPa to 110 kPa and is preferably 93 kPa to 104 kPa for obtaining good effects described herein.

Further, the excited gas as used herein refers to a gas in which at least some of the molecules of the gas shift from a current state to a higher state by obtaining energy and corresponds to the gas containing excited gas molecules, radicalized gas molecules, or ionized gas molecules.

As for the first barrier layer according to the present invention, there is preferred a method of mixing a gas containing a source gas containing silicon with an excited discharge gas to form a secondary excited gas in discharge space in which a high frequency electric field is generated under atmospheric pressure or near pressure thereof and forming an inorganic film by exposing a substrate to the secondary excited gas.

More specifically, space between counter electrodes (discharge space) is made to be at atmospheric pressure or near pressure thereof as a first step, the discharge gas is introduced between the counter electrodes, a high-frequency voltage is applied between the counter electrodes to make the discharge gas in a plasma state, the discharge gas in the plasma state is subsequently mixed with the source gas outside the discharge space, and the substrate is exposed to this mixed gas (secondary excited gas) to form the first barrier layer on the substrate.

[Second Barrier Layer]

The second barrier layer according to the present invention is formed by laminating and coating a coating liquid containing a silicon compound on the first barrier layer formed by the chemical vapor deposition method and thereafter performing conversion treatment.

As a method for coating the silicon compound, any suitable wet type coating methods may be adopted. Specific examples include spin coating methods, roll coating methods, flow coating methods, inkjet methods, spray coating methods, printing methods, dip coating methods, flow casting film formation methods, bar coating methods, gravure printing methods, and the like. A coated film thickness maybe suitably set depending on the purpose. For example, the coated film thickness is appropriately set so that the thickness after drying is preferably around 1 nm to 100 $\mu$m, further preferably around 10 nm to 10 $\mu$m, most preferably around 10 nm to 1 $\mu$m.

(Silicon Compound)

As the silicon compound according to the present invention, which is not particularly limited as long as the coating liquid containing the silicon compound can be prepared, a polysilazane such as perhydropolysilazane or organopolysilazane; a polysiloxane such as silsesquioxane; or the like is preferred in view of a film formation property, a few defects such as cracking, and a small amount of residual organic matter.

Examples of the silicon compound according to the present invention may include perhydropolysilazane, organopolysilazane, silsesquioxane, tetramethylsilane, trimethylmethoxysilane, dimethyldimethoxysilane, methyltrimethoxysilane, trimethylethoxysilane, dimethyldiethoxysilane, methyltriethoxysilane, tetramethoxysilane, tetramethoxysilane, hexamethyldisiloxane, hexamethyldisilazane, 1, 1- dimethyl- 1- silacyclobutane, trimethylvinylsilane, methoxydimethylvinylsilane, trimethoxyvinylsilane, ethyltrimethoxysilane, dimethyldivinylsilane, dimethylethoxyethynylsilane, diacetoxydimethylsilane, dimethoxymethyl- 3, 3, 3- trifluoropropylsilane, 3, 3, 3- trifluoropropyltrimethoxysilane, aryltrimethoxysilane, ethoxydimethylvinylsilane, arylaminotrimethoxysilane, N- methyl- N- trimethylsilylacetamide, 3- aminopropyltrimethoxysilane, methyltrivinylsilane, diacetoxymethylvinylsilane, methyltriacetoxysilane, aryloxydimethylvinylsilane, diethylvinylsilane, butyltrimethoxysilane, 3- aminopropyldimethylethoxysilane, tetravinylsilane, triacetoxyvinylsilane, tetraacetoxysilane, 3- trifluoroacetoxypropyltrimethoxysilane, diaryldimethoxysilane, butyldimethoxyvinylsilane, trimethyl- 3- vinylthiopropylsilane, phenyltrimethylsilane, dimethoxymethylphenylsilane, phenyltrimethoxysilane, 3- acryloxypropyldimethoxymethylsilane, 3- acryloxypropyltrimethoxysilane, dimethylisopentyloxyvinylsilane, 2- aryloxyethylthiomethoxytrimethylsilane, 3- glycidoxypropyltrimethoxysilane, 3- arylaminopropyltrimethoxysilane, hexyltrimethoxysilane, heptadecafluorodecyltrimethoxysilane, dimethylethoxyphenylsilane, benzoyloxytrimethylsilane, 3- methacryloxypropyldimethoxymethylsilane, 3- methacryloxypropyltrimethoxysilane, 3- isocyanatepropyltriethoxysilane, dimethylethoxy- 3- glycidoxypropylsilane, dibutoxydimethylsilane, 3- butylaminopropyltrimethylsilane, 3- dimethylaminopropyldiethoxymethylsilane, 2- (2- aminoethylthioethyl) triethoxysilane, bis (butylamino) dimethylsilane, divinylmethylphenylsilane, diacetoxymethylphenylsilane, dimethyl- p- tolylvinylsilane, p- styryltrimethoxysilane, diethylmethlylphenylsilane, benzyldimethylethoxysilane, diethoxymethylphenylsilane, decylmethyldimethoxysilane, diethoxy- 3- glycidoxypropyplmethylsilane, octyloxytrimethylsilane, phenyltrivinylsilane, tetraaryloxysilane, dodecyltrimethylsilane, diarylmethylphenylsilane, diphenylmethylvinylsilane, diphenylethoxymethylsilane, diacetoxydiphenylsilane, dibenzyldimethylsilane, diaryldiphenylsilane, octadecyltrimethylsilane, methyloctadecyldimethylsilane, docosylmethyldimethylsilane, 1, 3- divinyl- 1, 1, 3, 3- tetramethyldisiloxane, 1, 3- divinyl- 1, 1, 3, 3- tetramethyldisilazane, 1, 4- bis (dimethylvinylsilyl) benzene, 1, 3- bis (3- acetoxypropyl) tetramethyldisiloxane, 1, 3, 5- trimethyl- 1, 3, 5- trivinylcyclotrisiloxane, 1, 3, 5- tris (3, 3, 3- trifluoropropyl)- 1, 3, 5- trimethylcyclotr isiloxane, octamethylcyclotetrasiloxane, 1, 3, 5, 7- tetraethoxy- 1, 3, 5, 7- tetramethylcyclotetrasiloxan e, decamethylcyclopentasiloxane, and the like.

Examples of the silsesquioxane include Q8 series manufactured by Mayaterials, Inc.: Octakis (tetramethylammonium) pentacyclo- octasiloxane- octa kis (yloxide) hydrate; Octa (tetramethylammonium) silsesquioxane, Octakis (dimethylsiloxy) octasilsesquioxane, Octa[[3- [(3- ethyl- 3- oxetanyl) methoxy] propyl] dimethylsilo xy] octasilsesquioxane; Octaallyloxetane silsesquioxane, Octa[(3- Propylglycidylether) dimethylsiloxy] silsesquioxan e; Octakis[[3- (2, 3- epoxypropoxy) propyl] dimethylsiloxy] octas ilsesquioxane, Octakis[[2- (3, 4- epoxycyclohexyl) ethyl] dimethylsiloxy] oct asilsesquioxane, Octakis [2- (vinyl) dimethylsiloxy] silsesquioxane; Octakis (dimethylvinylsiloxy) octasilsesquioxane, Octakis[(3- hydroxypropyl) dimethylsiloxy] octasilsesquioxa ne, Octa[(methacryloylpropyl) dimethylsilyloxy] silsesquioxane, Octakis[(3- methacryloxypropyl) dimethylsiloxy] octasilsesq uioxane; hydrogenated silsesquioxane containing no organic group; and the like.

Especially, inorganic silicon compounds are particularly preferred and inorganic silicon compounds which are solid at ordinary temperature are more preferred. Perhydropolysilazane, hydrogenated silsesquioxane, and the like are more preferably used.

"Polysilazane" which is a polymer having a silicon-nitrogen bond is a ceramic precursor inorganic polymer comprising Si-N, Si-H, N-H, or the like, such as $SiO_2$, $Si_3N_4$, or an intermediate solid solution $SiO_xN_y$ therebetween.

For coating to prevent a film base from being damaged, a compound that is ceramized and converted into silica at comparatively low temperature (low-temperature ceramized polysilazane) is preferred, and, for example, a compound having a main skeleton comprising a unit represented by the following general formula (1) described in JP 8-112879-A is preferred.

[Formula (1)]

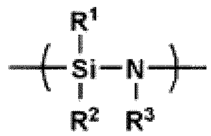

In the above-described general formula (1), $R^1$, $R^2$, and $R^3$ each independently represent a hydrogen atom, an alkyl group (alkyl group preferably having 1 to 30 carbon atoms, more preferably having 1 to 20 carbon atoms), an alkenyl group (alkenyl group preferably having 2 to 20 carbon atoms), a cycloalkyl group (cycloalkyl group preferably having 3 to 10 carbon atoms), an aryl group (aryl group preferably having 6 to 30 carbon atoms), a silyl group (silyl group preferably having 3 to 20 carbon atoms), an alkylamino group (alkylamino group preferably having 1 to 40 carbon atoms, more preferably 1 to 20 carbon atoms), or an alkoxy group (alkoxy group preferably having 1 to 30 carbon atoms). However, at least one of $R^1$, $R^2$, and $R^3$ is preferably a hydrogen atom.

The alkyl group in $R^1$, $R^2$, and $R^3$ described above is a straight- chain or branched- chain alkyl group. Specific examples of the alkyl group having 1 to 30 carbon atoms include a methyl group, an ethyl group, a n- propyl group, an isopropyl group, a n- butyl group, an isobutyl group, a sec- butyl group, a tert- butyl group, a n- pentyl group, an isopentyl group, a tert- pentyl group, a neopentyl group, a 1, 2- dimethylpropyl group, a n- hexyl group, an isohexyl group, a 1, 3- dimethylbutyl group, a 1- isopropylpropyl group, a 1, 2- dimethylbutyl group, a n- heptyl group, a 1, 4- dimethylpentyl group, a 3- ethylpentyl group, a 2- methyl- 1- isopropyl propyl group, a 1- ethyl- 3- methylbutyl group, a n- octyl group, a 2- ethylhexy group, a 3- methyl- 1- isopropylbutyl group, a 2- methyl- 1- isopropyl group, a 1- t- butyl- 2- methylpropyl group, a n- nonyl group, a 3, 5, 5- trimethylhexyl group, a n- decyl group, an isodecyl group, a n- undecyl group, a 1- methyldecyl group, a n- dodecyl group, a n- tridecyl group, a n- tetradecyl group, a n- pentadecyl group, a n- hexadecyl group, a n- heptadecyl group, a n- octadecyl group, a n- nonadecyl group, a n- eicosyl group, a n- heneicosyl group, a n- docosyl group, a n- tricosyl group, a n- tetracosyl group, a n- pentacosyl group, a n- hexacosyl group, a n- heptacosyl group, a n- octacosyl group, a n- triacontyl group, and the like.

Examples of the alkenyl group having 2 to 20 carbon atoms include a vinyl group, a 1-propenyl group, an allyl group, an isopropenyl group, a 1-butenyl group, a 2-butenyl group, a 1-pentenyl group, a 2-pentenyl group, and the like.

Examples of the cycloalkyl group having 3 to 10 carbon atoms include a cyclopropyl group, a cyclobutyl group, a cyclopentyl group, a cyclohexyl group, a cycloheptyl group, a cyclooctyl group, a cyclononyl group, a cyclodecyl group, and the like.

Examples of the aryl group having 6 to 30 carbon atoms include, but are not particularly limited to, non-fused hydrocarbon groups such as a phenyl group, a biphenyl group, and a terphenyl group; and fusedpolycyclic hydrocarbon groups such as a pentalenyl group, an indenyl group, a naphthyl group, an azulenyl group, a heptalenyl group, a biphenylenyl group, a fluorenyl group, an acenaphthylenyl group, a pleiadenyl group, an acenaphthenyl group, a phenalenyl group, a phenanthryl group, an anthryl group, a fluoranethenyl group, an acephenanthrylenyl group, an aceanthrylenyl group, a triphenylenyl group, a pyrenyl group, a chrysenyl group, and a naphthacenyl group.

Examples of the silyl group having 3 to 20 carbon atoms include alkyl/arylsilyl groups and specific examples thereof include a trimethylsilyl group, a triethylsilyl group, a triisopropylsilyl group, a t-butyldimethylsilyl group, a methyldiphenylsilylgroup, at-butyldiphenylsilylgroup, and the like.

Examples of the alkylamino group having 1 to 40 carbon atoms include, but are not particularly limited to, a dimethylamino group, a diethylamino group, a diisopropylamino group, a methyl-tert-butylamino group, a dioctylamino group, a didecylamino group, a dihexadecylamino group, a di-2-ethylhexyamino group, a di-2-hexyldecylamino group, and the like.

Examples of the alkoxy group having 1 to 30 carbon atoms include a methoxy group, an ethoxy group, a propoxy group, an isopropoxy group, a butoxy group, a pentyloxy group, a hexyloxy group, a 2-ethylhexyoxy group, an octyloxy group, a nonyloxy group, a decyloxy group, an undecyloxy group, a dodecyloxy group, a tridecyloxy group, atetradecyloxy group, a pentadecyloxy group, a hexadecyloxy group, a heptadecyloxy group, an octadecyloxy group, a nonadecyloxy group, an eicosyloxy group, a heneicosyloxy group, a docosyloxy group, a tricosyloxy group, a tetracosyloxy group, a pentacosyloxy group, a hexacosyloxy group, a heptacosyloxy group, an octacosyloxy group, a triacontyloxy group, and the like.

In accordance with the present invention, the perhydropolysilazane in which all of $R^1$, $R^2$, and $R^3$ are hydrogen atoms is particularly preferred from the viewpoint of denseness as an obtained gas barrier film.

The compound having the main skeleton comprising the unit represented by the above-described general formula (1) preferably has a number average molecular weight of 100 to 50000. The number average molecular weight can be measured by gel permeation chromatograph (GPC).

On the other hand, organopolysilazane in which a part of a hydrogen atom moiety bound to Si thereof is substituted by an alkyl group has an advantage that adhesion with the base which is an undercoat is improved and a hard and fragile ceramic film with polysilazane can be provided with toughness due to an alkyl group such as a methyl group to inhibit a crack from being generated even in the case of a larger (average) film thickness. These perhydropolysilazane and organopolysilazane may be appropriately selected or mixed and used, depending on the application.

Perhydropolysilazanes are estimated to have a structure in which there are a straight-chain structure and a ring structure including six- and eight-membered rings. As for the molecular weight thereof, they have a number average molecular weight (Mn) of around 600 to 2000 (in terms of polystyrene), and there are a liquid or solid substance, of which the state depends on the molecular weight. They are marketed in the state of solutions in which they are dissolved in organic solvents and the commercially available products can be used as polysilazane-containing coating liquids without being processed.

Other examples of polysilazanes ceramized at low temperature include a silicon alkoxide- added polysilazane obtained by reacting the polysilazane having the main skeleton comprising the unit represented by the above- described general formula (1) with silicon alkoxide (e.g., see JP- 5- 238827- A), a glycidol- added polysilazane obtained by reaction with glycidol (e.g., see JP- 6- 122852- A), an alcohol- added polysilazane obtained by reaction with alcohol (e.g., see JP- 6- 240208- A), a metal carboxylate- added polysilazane obtained by reaction with a metal carboxylate (e.g., see JP- 6- 299118- A), an acetylacetonato complex- added polysilazane obtained by reaction with an acetylacetonato complex containing a metal (see JP- 6- 306329- A), a metallic fine particles- added polysilazane obtained by adding metallic fine particles (e.g., see JP- 7- 196986- A), and the like. Alternatively, a commercially available product may also be used as a polysilazane.

It is not preferable to use such an alcohol-based organic solvent or an organic solvent containing water, as easily reacted with polysilazane, as an organic solvent which can be used to prepare a coating liquid containing polysilazane. Thus, hydrocarbon solvents such as aliphatic hydrocarbons, alicyclic hydrocarbons, and aromatic hydrocarbons; halogenated hydrocarbon solvents; and ethers such as aliphatic ethers and alicyclic ethers can be specifically used. Specifically, there are hydrocarbons such as pentane, hexane, cyclohexane, toluene, xylene, solvesso, and turpentine; halogen hydrocarbons such as methylene chloride and trichloroethane; ethers such as dibutyl ether, dioxane, and tetrahydrofuran; and the like. These organic solvents may be selected depending on properties such as solubility of polysilazane and rates of evaporation of organic solvents and a plurality of organic solvents may also be mixed.

The concentration of polysilazane in the polysilazane-containing coating liquid, which depends on the film thickness of the second barrier layer of interest and the pot life of the coating liquid, is preferably around 0.2 to 35 mass%.

Amine or a metal catalyst may also be added into the polysilazane-containing coating liquid in order to promote conversion into a silicon oxide compound. Specifically, this include AQUAMICA NAX120-20, NN110, NN310, NN320, NL110A, NL120A, NL150A, NP110, NP140, SP140, and the like, manufactured by AZ Electronic Materials.

(Operation for Removing Organic Solvent and Water from Coating Film Formed by Coating Silicon Compound)

It is preferable to remove water from a coating film formed by coating a silicon compound formed with a polysilazane-containing coating liquid or the like (hereinafter simply referred to as silicon compound coating film) prior to conversion treatment or during conversion treatment. Therefore, the production of the second barrier layer preferably includes a first step for the purpose of removing an organic solvent in the silicon compound coating film and a subsequent second step for the purpose of removing water in the silicon compound coating film. The removal of water prior to the conversion treatment or during the conversion treatment results in improvement in the efficiency of subsequent conversion treatment.

In the first step, drying conditions can be appropriately determined by a method such as heat treatment in order to mainly remove the organic solvent, and the condition of removing water is acceptable in this case. Although heat treatment temperature is preferably high temperature from the viewpoint of quick treatment, it is preferable to appropriately determine temperature and treatment time in consideration of heat damage to a resin filmbase. For example, when a polyethylene terephthalate base with a glass transition temperature (Tg) of 70°C is used as the resin base, the heat treatment temperature may be set at 200°C or less. The treatment time is preferably set to short time so that the solvent is removed and the heat damage to the base is reduced and may be set to 30 minutes or less when the heat treatment temperature is 200°C or less.

The second step is a step for removing water in the silicon compound coating film and a method for removing water is preferably in the form of removing moisture while maintaining a low-humidity environment. Since humidity in

the low-humidity environment varies with temperature, the preferred form of the relationship between the temperature and the humidity is indicated by defining dew-point temperature. Preferred dew-point temperature is 4°C or less (temperature of 25°C/humidity of 25%), more preferred dew-point temperature is-8°C (temperature of 25°C/humidity of 10%) or less, further preferred dew-point temperature is -31°C (temperature of 25°C/humidity of 1%) or less, and maintenance time is preferably appropriately set depending on the film thickness of the second barrier layer. It is preferable that the dew point temperature be -8°C or less and the maintenance time be 5 minutes or more on the condition of the film thickness of the second barrier layer of 1.0 μm or less. The lower limit of the dew-point temperature is not particularly limited but is typically -50°C or more, preferably -40°C or more. It is preferable that the dew point temperature be -8°C or less and the maintenance time be 5 minutes or more on the condition of the film thickness of the second barrier layer of 1.0 μm or less. Drying under reduced pressure may also be performed to make it easy to remove water. As pressure in the drying under reducedpressure, normal pressure to 0.1 MPa may be selected.

As the preferred conditions of the second step based on the conditions of the first step, the condition of removing water at a dew point of 4°C or less for a treatment time of 5 minutes to 120 minutes in the second step may be selected, for example, when a solvent is removed at a temperature of 60 to 150°C for a treatment time of 1 minute to 30 minutes in the first step. As for division of the first step and the second step, they can be distinguished by variation in dew point, and the division can be performed by a difference between dew points in step environments of 10°C or more.

Even after water has been removed in the second step, the silicon compound coating film is preferably subjected to conversion treatment while maintaining the state.

(Water Content in Silicon Compound Coating Film)

A water content in the silicon compound coating film can be measured according to an analytical method described below.

Headspace-Gas Chromatograph/Mass Spectrometry

Apparatus: HP6890GC/HP5973MSD
Oven: 40°C (2 min), then temperature is increased to 150°C at a rate of 10°C/min.
Column: DB-624 (0.25 mmid×30m)
Inlet: 230°C
Detector: SIM m/z=18
HS condition: 190°C·30 min

The water content ratio in the silicon compound coating film is defined as a value obtained by dividing a water content (g) obtained by the above-described analytical method by the volume (L) of the second barrier layer and is preferably 0.1% (g/L) or less in the state where water is removed in the second step, and the further preferred water content ratio is 0.01% (g/L) or less (not more than the detection limit).

In accordance with the present invention, the removal of water prior to conversion treatment or during conversion treatment is in preferred form from the viewpoint of promoting the reaction of the dehydration of the second barrier layer converted into silanol.

[Conversion treatment of Second Barrier Layer]

The conversion treatment according to the present invention refers to a reaction of converting a silicon compound into silicon oxide or silicon nitride oxide and specifically to treatment of forming an inorganic thin film with a level at which the gas barrier film of the present invention can contribute to expression of a gas barrier property (a moisture vapor transmission rate of $1\times10^{-3}$ g/($m^2$·24 h) or less) as a whole.

For the reaction of converting a silicon compound into silicon oxide or silicon nitride oxide, a known method based on the conversion reaction of the second barrier layer may be selected. The formation of a silicon oxide filmor a silicon nitride oxide layer by substitution reaction of the silicon compound requires a high temperature of 450°C or more and is difficult to adapt in a flexible base with plastic or the like.

Accordingly, a conversion reaction using plasma, ozone, or ultraviolet rays with which the conversion reaction is possible at lower temperature is preferred for producing the gas barrier film of the present invention from the viewpoint of adaptation to a plastic base.

(Plasma Treatment)

In accordance with the present invention, a known method can be used as plasma treatment which can be used as the conversion treatment, and mention may be preferably made of the above-mentioned atmospheric pressure plasma treatment and the like.

(Heat Treatment)

The conversion treatment can be carried out by heat treatment of a coating film containing a silicon compound in combination with excimer irradiation treatment described below and/or the like.

As the heat treatment, for example, a method of bringing a base into contact with a heat generator such as a heating block and heating a coating film by heat conduction, a method of heating atmosphere by an external heater with a resistance wire or the like, a method of using light in the infrared region with, e.g., an IR heater, and the like are included without particular limitation. A method capable of maintaining the smoothness of a coating film containing a silicon compound may also be selected appropriately.

The temperature of a coating film during the heat treatment is preferably appropriately adjusted in the range of 50°C to 250°C, further preferably in the range of 100°C to 200°C.

Heating time is preferably in the range of 1 second to 10 hours, further preferably in the range of 10 seconds to 1 hour.

In accordance with the present invention, a layer (second barrier layer) in itself formed from a coating film containing a silicon compound preferably expresses a gas barrier property (moisture vapor transmission rate of $1\times10^{-3}$ g/($m^2\cdot$24 h) or less) and excimer light treatment described below is particularly preferred as conversion means for obtaining such a second barrier layer.

(Ultraviolet Ray Irradiation Treatment)

In accordance with the present invention, treatment by ultraviolet ray irradiation is also preferred as one of conversion treatment methods. Ozone or an active oxygen atom generated by ultraviolet rays (synonymous with ultraviolet light) has a high oxidation capacity and can form a silicon oxide film or a silicon nitride oxide filmhavinghighdenseness and an insulation property at low temperature.

By this ultraviolet ray irradiation, the base is heated to excite and activate $O_2$ and $H_2O$, contributing to ceramization (silica conversion), an ultraviolet ray absorber, and polysilazane in itself, the polysilazane is therefore excited to promote the ceramization of the polysilazane and to result in the further densification of an obtained ceramic film. The ultraviolet ray irradiation is effectively carried out at any time as long as it is carried out after the formation of a coating film.

In the method according to the present invention, any commonly used apparatus for generating ultraviolet rays may be used.

The ultraviolet rays as used herein generally refer to electromagnetic waves having a wavelength of 10 to 400 nm, and ultraviolet rays of 210 to 375 nm are preferably used in the case of ultraviolet ray irradiation treatment other than vacuum ultraviolet ray (10 to 200 nm) treatment described below.

For irradiation with ultraviolet rays, it is preferable to set irradiation intensity and irradiation time in the ranges in which the base carrying the second barrier layer to be irradiated is not damaged.

When the case of using a plastic film as the base is taken as an example, for example, a distance between the base and an ultraviolet ray irradiation lamp can be set, so that intensity on a base surface is 20 to 300 mW/$cm^2$, preferably 50 to 200 mW/$cm^2$, to perform irradiation for 0.1 second to 10 minutes using the lamp with 2 kW (80 W/cm$\times$25 cm).

Generally, when the temperature of the base during ultraviolet ray irradiation treatment is 150°C or more, deterioration in the property of the base, such as deformation of the base or reduction in its strength, occurs in the case of a plastic film or the like. However, conversion treatment at higher temperature is possible in the case of a film with high heat resistance such as polyimide or a base with a metal or the like. Accordingly, the temperature of the base during the ultraviolet ray irradiation has no general upper limit and can be appropriately set by those skilled in the art depending on the kind of the base. Further, atmosphere for ultraviolet ray irradiation is not particularly limited but it may be carried out in the air.

Examples of such means for generating ultraviolet rays include, but are not limited to, metal halide lamps, high-pressure mercury lamps, low-pressure mercury vapor lamps, xenon arc lamps, carbon arc lamps, excimer lamps (single wavelength of 172 nm, 222 nm, or 308nm; for example, manufactured by Ushio Inc.), UV light lasers, and the like. Further, when the second barrier layer is irradiated with generated ultraviolet rays, the ultraviolet rays from a generation source are desirably reflected by a reflecting plate and hit the second barrier layer from the viewpoint of achieving improvement in efficiency and uniform irradiation.

The ultraviolet ray irradiation may be adapted to batch treatment or consecutive treatment and may be appropriately selected depending on the shape of the base used. For example, in the case of the batch treatment, the base (e.g., silicon wafer) having the second barrier layer on the surface thereof can be treated with an ultraviolet raybaking furnace including such an ultraviolet ray generation source as described above. As the ultraviolet ray baking furnace in itself, which is generally known, for example, an ultraviolet ray baking furnace manufactured by Eye Graphics Co., Ltd. may be used. Further, when the base having the second barrier layer on the surface thereof has a long film shape, it can be ceramized by being consecutively irradiated with ultraviolet rays in a drying zone including such an ultraviolet ray generation source as described above while conveying it. Time required for the ultraviolet ray irradiation, which depends on the base used and the composition and concentration of the second barrier layer, is generally 0.1 second to 10 minutes, preferably 0.5 second to 3 minutes.

(Vacuum Ultraviolet Ray Irradiation Treatment: Excimer Irradiation Treatment)

In accordance with the present invention, the most preferred conversion treatment method is treatment by vacuum ultraviolet ray irradiation (excimer irradiation treatment) . The treatment by the vacuum ultraviolet ray irradiation is a method for forming a silicon oxide film at comparatively low temperature (about 200°C or less) by making an oxidation reaction proceed by active oxygen or ozone while directly cutting an atomic bond by the action of only a photon, called a light quantum process, using the energy of light of 100 to 200 nm, higher than interatomic bonding force in a polysilazane compound, preferably using the energy of light with a wavelength of 100 to 180 nm. It is preferable to use heat treatment together as mentioned above when the excimer irradiation treatment is carried out, and the details of heat treatment conditions in this case are as mentioned above.

As a vacuum ultraviolet light source necessary therefor, a noble gas excimer lamp is preferably used.

A noble gas atom such as Xe, Kr, Ar, or Ne is not chemically bound to make a molecule and is therefore referred to as an inert gas. However, a noble gas atom (excited atom) gaining energy by discharge and/or the like can be bound to another atom to make a molecule. When the noble gas is xenon,

$$e+Xe \rightarrow e+Xe^*$$

$$Xe^*+Xe+Xe \rightarrow Xe_2^*+Xe$$

are established, excimer light of 172 nm is emitted when transition of $Xe_2^*$, which is an excited excimer molecule, to a ground state occurs.

Features of the excimer lamp include high efficiency due to concentration of emission on one wavelength to cause almost no emission of light other than necessary light. Further, the temperature of an object can be kept low since surplus light is not emitted. Furthermore, instant lighting and flashing are possible since time is not needed for starting/ restarting.

A method of using dielectric barrier discharge is known to provide excimer light emission. The dielectric barrier discharge is very thin discharge called micro discharge, like lightning, generated in the gas space, which is disposed between both electrodes via a dielectric (transparent quartz in the case of the excimer lamp), by applying a high frequency and a high voltage of several tens of kHz to the electrodes, and, when a streamer of the micro discharge reaches a tube wall (dielectric), a dielectric surface is charged and the micro discharge therefore becomes extinct. It is discharge in which the micro discharge spreads over the whole tube wall and generation and extinction thereof are repeated. Therefore, light flicker which can be recognized even by the naked eye occurs. Since a streamer at very high temperature locally directly reaches the tube wall, deterioration in the tube wall may also be accelerated.

For a method of efficiently obtaining excimer light emission, electrodeless electric field discharge, other than the dielectric barrier discharge, is also possible.

It is electrodeless electric field discharge by capacitive coupling and is also sometimes called RF discharge. Although a lamp, electrodes, and arrangement thereof may be basically the same as those in the dielectric barrier discharge, a high frequency applied between both electrodes illuminates at several of MHz. In the electrodeless electric field discharge, discharge uniform in terms of space and time is obtained as described above and a long-lasting lamp without flicker is therefore obtained.

In the case of the dielectric barrier discharge, since micro discharge occurs only between the electrodes, the outside electrode must cover the whole external surface and have a material, through which light passes, for taking out light to the outside, in order to effect discharge in the wholedischarge space. Therefore, the electrode in which thin metal wires are reticulated is used. This electrode easily damaged by ozone and/or the like generated by vacuum-ultraviolet light in oxygen atmosphere since wires which are as thin as possible are used so as not to block light.

For preventing this, it is necessary to make the periphery of the lamp, that is, the inside of an irradiation apparatus

have inert gas atmosphere such as nitrogen and to dispose a window with synthetic quartz to take out irradiated light. The window with synthetic quartz is not only an expensive expendable product but also causes the loss of light.

Since a double cylinder type lamp has an outer diameter of around 25 mm, a difference between the distances to an irradiated surface just under a lamp axis and on the side surface of the lamp is unneglectable to cause a difference in illuminance. Accordingly, even if such lamps are closely arranged, no uniform illumination distribution is obtained. The irradiation apparatus provided with the window with synthetic quartz enables equal distances in oxygen atmosphere and provides a uniform illumination distribution.

It is not necessary to reticulate an external electrode when electrodeless electric field discharge is used. Only by disposing the external electrode on a part of the external surface of the lamp, glow discharge spreads over the whole discharge space. For the external electrode, an electrode which serves as a light reflecting plate typically made of an aluminum block is used on the back surface of the lamp. However, since the outer diameter of the lamp is large as in the case of the dielectric barrier discharge, synthetic quartz is required for making a uniform illumination distribution.

The maximum feature of a narrow tube excimer lamp is a simple structure. Both ends of a quartz tube are only closed to seal a gas for excimer light emission therein. Accordingly, a very inexpensive light source can be provided.

The double cylinder type lamp is easily damaged in handling or transportation in comparison with the narrow tube lamp since processing of connection and closing of both ends of its inner and outer tube is carried out. The tube of the narrow tube lamp has an outer diameter of around 6 to 12 mm, and a high voltage is needed for starting when it is too thick.

As discharge form, any of dielectric barrier discharge and electrodeless electric field discharge can be used. As for the shape of the electrode, a surface contacting with the lamp may be planar; however, the lamp can be well fixed and the electrode closely contacts with the lamp to more stabilize discharge by the shape fitting with the curved surface of the lamp. Further, a light reflecting plate is also made when the curved surface is made to be a specular surface with aluminum.

A Xe excimer lamp is excellent in luminous efficiency since an ultraviolet ray with a short wavelength of 172 nm is radiated at a single wavelength. This light enables a high concentration of a radical oxygen atomic species or ozone to be generated with a very small amount of oxygen because of having a high oxygen absorption coefficient. Further, the energy of light with a short wavelength of 172 nm which dissociates the bond of organic matter is known to have a high capacity. Conversion of a polysilazane film can be realized in a short time by the high energy of this active oxygen or ozone and ultraviolet radiation. Accordingly, shortening of process time and reduction in the area of a facility, caused by a high throughput, and irradiation of an organic material, a plastic base, or the like, which is easily damaged by heat, are enabled in comparison with the low-pressure mercury vapor lamp which emits wavelengths of 185 nm and 254 nm and plasma cleaning.

The excimer lamp can be made to illuminate by input of a low power because of having high light generation efficiency. Further, it does not emit light with a long wavelength which becomes a factor for increasing temperature due to light but irradiates energy with a single wavelength in an ultraviolet range, and therefore has the feature of capable of suppressing increase in the surface temperature of an article to be irradiated. Therefore, it is suitable for a flexible film material such as polyethylene terephthalate which is considered to be subject to heat.

[Confirmation of Conversion Region in Second Barrier Layer]

In accordance with a preferred aspect of the present invention, as illustrated in Figure 1, the second barrier layer 4Ahas the low conversion region (non-conversion region) in the side closer to the surface of the base 2 and the high conversion region (conversion region) in the surface layer side, and the conversion region formed by the conversion treatment can be confirmed by various methods. A method of the confirmation by observing the cross section of the second barrier layer subjected to the conversion treatment with a transmission electron microscope (TEM) is most effective.

(Cross-Sectional TEM Observation)

A thin section is produced by an FIB processing apparatus described below, followed by performing cross-sectional TEM observation for the gas barrier film. In this case, a contrast difference between a part damaged by an electron beam and a not-damaged part is generated by continuously irradiating the sample with the electron beam. The conversion region according to the present invention is resistant to damage by the electron beam because of being densified by the conversion treatment while the non-conversion region is damaged by the electron beam to allow deterioration to be confirmed. The cross-sectional TEM observation allowing such confirmation as described above enables calculation of the film thicknesses of the conversion region and the non-conversion region.

<FIB Processing>

Apparatus: SMI2050 manufactured by SII
Processing ion: (Ga 30 kV)
Sample thickness: 100 nm to 200 nm

<TEM Observation>

Apparatus: JEM2000FX manufactured by JEOL Ltd.
(Acceleration voltage: 200 kV)
Electron beam irradiation time: 5 seconds to 60 seconds

A film thickness ratio of the film thickness of the conversion region, estimated in such a manner, to the thickness of the second barrier layer 4A is preferably 0.2 or more and 0.9 or less. It is more preferably 0.3 or more and 0.9 or less, further preferably 0.4 or more and 0.8 or less. Since the barrier performance and flexibility of the second barrier layer are improved in the case in which the film thickness of the conversion region based on the total film thickness of the second barrier layer 4A is 0.2 or more and the barrier performance and the flexibility are improved in the case of 0.9 or less, both cases are preferred.

As described in accordance with the present invention, breaking (cracking) due to stress concentration is prevented and both of a high barrier property and a stress relaxation function can be achieved by setting a ratio of the conversion region in the second barrier layer in the range defined as described above in the gas barrier layer obtained by subjecting the second barrier layer to conversion treatment. Particularly, it is preferable that an effect of the present invention be significantly exhibited since surface treatment can be efficiently carried out with vacuum-ultraviolet light in a short time by adopting vacuum ultraviolet treatment as a conversion treatment method.

(Method for Measuring Elasticity Modulus: Nano Indentation)

In accordance with a preferred aspect of the gas barrier film of the present invention, it is preferable that the first barrier layer 4B formed by a chemical vapor deposition method be constituted by silicon oxide or silicon oxynitride and the relationship of E1>E2>E3 be satisfied assuming that the elasticity modulus of the first barrier layer 4B is E1, the elasticity modulus of the conversion region in the second barrier layer 4A is E2, and the elasticity modulus of the non-conversion region in the second barrier layer 4A is E3.

The elasticity moduli of the conversion region and the non-conversion region in the first barrier layer and the second barrier layer described above can be determined by an elasticity modulus measurement method known in the art, such as a method of measurement by applying a constant strain under a constant frequency (Hz) by using VIBRON DDV-2, manufactured by Orientec Co. Ltd., a method of determination by a measurement value obtained from changing applied strain under a constant frequency by using RSA-II (manufactured by Rheometric Scientific, Inc.) as a measurement apparatus after forming the second barrier layer on the transparent substrate, or a method of measurement using a nano indenter applied with a nano indentation method, e.g., a nano indenter (Nano Indenter TMXP/DCM) manufactured by MTS Systems Corporation.

The method of measurement by using a nano indenter is preferred from the viewpoint of enabling high-accurate measurement of the elasticity modulus of each very thin layer according to the present invention.

As used herein, "nano indentation method" is a method including: pushing an indenter with a triangular pyramid shape having a tip radius of 0.1 to 1 μm by a very small load into the secondbarrier layer disposed on the transparent substrate as an article to be measured to apply the load; thereafter unloading by carrying back the indenter; making a load-displacement curve; and measuring an elasticity modulus (Reduced modulus) from the relationship between a load value and a push-in depth obtained by the load-displacement curve. The amount of displacement resolution can be measured with a high accuracy of 0.01 nm by this nano indentation method using a head assembly having a super low load such as a maximum load of 20 mN and a load resolution of 1 nN.

Particularly, as for the second barrier layer having different elasticity moduli in a cross sectional direction as described in the present invention, a method of pushing a very small indenter with a triangular pyramid shape from a cross section portion and measuring the elasticity modulus of a side opposite to a base side in the cross section portion is preferred, nano indenters which operate in a scanning electron microscope have been also developed from the viewpoint of more enhancing accuracy in such a case, and determination can also be performed by applying them.

As for the relationship of the elasticity modulus of each layer from the values of the measured elasticity moduli described above, the relationship of E1>E2>E3 is preferably satisfied. Stress concentration on the conversion region (E2) in the conversion treatment side and the first barrier layer (E1) during bending can be suppressed by satisfying this relationship to significantly improve bending resistance. Depending on the quality of a material constituting the first

barrier layer, for example, when it is silicon oxide or silicon oxynitride, E1 as an elasticity modulus value is preferably 10 to 100 GPa, further preferably 20 to 50 GPa, and E2 and E3 of the second barrier layer can be optionally adjusted in the range of satisfying the above-described relational expression under conversion treatment conditions.

[Film Density of Second Barrier Layer]

In accordance with the present invention, the first barrier layer is preferably formed with a film containing silicon oxide, silicon nitride, or a silicon nitride oxide compound, and the film density d1 of the conversion region in the treatment surface side of the second barrier layer and the film density d2 of the non-conversion region subjected to no conversion can be determined according to the following method.

(X-ray Reflectometry of Film Density Distribution)

- X-ray reflectometer: Film structure evaluating apparatus ATX-G, manufactured by Rigaku Denki Co., Ltd.
- X-ray source target: Copper (1.2 kW)
- Measurement: An X-rays reflectivity curve is measured by using a four-crystal monochromator, a density distribution profile model is made, fitting is performed, and a density distribution in a film thickness direction is calculated.

As for the order of the numerical values of the above-described film densities d1 and d2 in accordance with the present invention, it is preferable to satisfy the relationship of d1>d2.

In the second barrier layer according to a preferred aspect of the present invention, the conversion region is present, and the conversion region further has the following characteristics:

1) Any definite interface of the regions with different properties is not observed by the dislocation line observation of the cross section of the second barrier layer according to the present invention with a super high resolution transmission electron microscope (Transmission Electron Microscope; TEM) .

On the other hand, in the case of lamination on the regions with different properties by a vapor deposition method, an interface always exists due to their properties. Inaddition, a dislocation line such as screw dislocation or edge dislocation is generated due to fine heterogeneity occurring in the interface when vapor phase molecules are deposited in a lamination direction and is observed with the super high resolution TEM.

It is inferred that the regions without any interface and with different properties can be formed without generating any dislocation line prone to be generated during deposition of vapor phase molecules, due to the conversion treatment of a coated film, in the second barrier layer according to a preferred aspect of the present invention.

2) A region having high density is formed in the conversion region in the second barrier layer according to a preferred aspect of the present invention, and a microcrystalline region is further confirmed and a crystallized region is confirmed in the region having the highest density when a Si- O interatomic distance in the region having high density is measured by FT- IR analysis in a depth direction.

Crystallization of $SiO_2$ is typically confirmed in heat treatment 1000°C or more whereas crystallization of $SiO_2$ in the surface region of the second barrier layer according to the present invention can be achieved on a resin base even in low-temperature treatment at 200°C or less. Although a clear reason is unknown, the present inventors infer that this is because three to five cyclic structures contained in polysilazane have an interatomic distance advantageous for forming a crystal structure, a process of dissolution, rearrangement, and crystallization at ordinary 1000°C or more is unnecessary, the conversion treatment is involved in preexisting short-distance order, and ordering can be achieved with small energy. Particularly, in treatment of irradiation with vacuum ultraviolet rays, use of both of cutting of a chemical bond such as Si-OH by the vacuum ultraviolet ray irradiation and oxidation treatment with ozone generated in irradiation space is preferred because of enabling effective treatment.

Particularly, the conversion treatment by the vacuum ultraviolet ray irradiation is most preferred for forming the conversion region in the conversion treatment of the second barrier layer according to a preferred aspect of the present invention. Although a mechanism for forming the conversion region is not clear, the present inventors estimate that direct cutting of a silazane compound by light energy and surface oxidation reaction due to active oxygen or ozone generated in a vapor phase simultaneously proceed, a difference between conversion rates on the surface side and inside of the conversion treatment occurs, and, as a result, the conversion region is formed. Furthermore, examples of means for positively controlling the difference between conversion rates include controlling of the surface oxidation reaction due to active oxygen or ozone generated in a vapor phase. That is, the desired composition, film thickness and density of the conversion region can be obtained by condition- changing factors contributing to the surface oxidation reaction, such as oxygen concentration, treatment temperature, humidity, an irradiation distance, and irradiation time, during irradiation. Particularly, the form of condition- changing the oxygen concentration during the irradiation is preferred, and the content

of nitrogen in the surface side can be reduced to increase the film thickness by increasing the oxygen concentration with the condition- changing.

For example, when the film thickness of the second barrier layer is 50 to 1000 nm, the above-described conversion treatment conditions can be selected from a vacuum ultraviolet illuminance of 10 to 200 mJ/cm$^2$, an irradiation distance of 0.1 to 10 mm, an oxygen concentration of 0 to 5%, a dew-point temperature of 10 to -50°C, a temperature of 25 to 200°C, and a treatment time of 0.1 to 150 sec. The temperature is preferably 50 to 200°C, more preferably 70 to 200°C.

Higher irradiation intensity results in an increased probability of a collision between a photon and a chemical bond in polysilazane and also enables time of conversion reaction to be shortened. Further, since the number of photons entering into the inside is also increased, the thickness of the conversion film can also be increased and/or film quality can be enhanced (densification). However, when irradiation time is too long, flatness may be deteriorated or a material other than the barrier film may be damaged. Although the degree of proceeding of reaction is generally considered based on an integrated amount of light, represented by the product of irradiation intensity and irradiation time, the absolute value of irradiation intensity may also become important in the case of a material having the same composition but various structural forms, like silicon oxide.

Accordingly, in accordance with the present invention, it is preferable to carry out the conversion treatment of applying the maximum irradiation intensity of 100 to 200 mW/cm$^2$ at least once in the vacuum ultraviolet ray irradiation step. The treatment time can be shortened without sharply deteriorating conversion efficiency by 100mW/cm$^2$ or more while, by 200 mW/cm$^2$ or less, gas barrier performance can be efficiently kept (increase in gas barrier property is slowed down even by irradiation at more than 200 mW/cm$^2$), not only damage to a substrate but also damage to other members of a lamp and a lamp unit can be suppressed, and the life of the lamp in itself can also be prolonged.

(Surface Roughness: Smoothness)

The surface roughness (Ra) of the surface of the conversion treatment side of the second barrier layer according to the present invention is preferably 2 nm or less, further preferably 1 nm or less. The surface roughness in the range defined as described above is preferred since, in use as a resin base for an electronic device, light transmission efficiency is improved by a smooth film surface with a few recesses and projections and energy conversion efficiency is improved by reducing a leakage current between electrodes. The surface roughness (Ra) of the gas barrier layer according to the present invention can be measured by the following method.

<Method for Measuring Surface Roughness: AFM Measurement>

The surface roughness is roughness regarding the amplitude of fine recesses and projections, calculated from the profile curve with recesses and projections, consecutively measured by a detector having a tracer with a very small tip radius, by AFM (atomic force microscope), e.g., DI3100, manufactured by Digital Instruments, in which a section of several tens of μm in a measurement direction is measured many times by the tracer with a very small tip radius.

(Cutting Processability)

The gas barrier film of the present invention is excellent in cutting processing suitability. That is, even in the case of cutting, fraying, rupture, or the like of a cut plane does not occur and an effective area can be enlarged.

In a conventional gas barrier film, there has been a problem that a phenomenon that a cut end is vigorously cracked together with a film as in the case of glass by stress applied by cutting processing occurs, an effective area for a product is reduced due to cracking of a cut plane, and productivity is poor. Although the present inventors extensively researched the cause of the vigorous cracking of the conventional gas barrier film as in the case of glass during cutting, the mechanism thereof was not able to be clarified. However, it was found that, in accordance with a preferred aspect of the present invention, stress applied to an end during cutting processing can be dispersed particularly by using the second barrier layer having the conversion region and the non-conversion region in conversion treatment of the second barrier layer to improve the phenomenon of vigorous cracking as in the case of glass, and the present invention was thus accomplished.

(Cutting Method)

A cutting method, without particular limitation, is preferably carried out by ablation processing with a high energy laser such as an ultraviolet laser (e.g., wavelength of 266 nm), an infrared laser, or a carbon dioxide gas laser. Since a gas barrier film has an inorganic thin film which is easily broken, a crack may be generated in a cut part when the gas barrier film is cut with an ordinary cutter. Furthermore, disposition of a protective layer containing an organic component

in the surface of the first barrier layer can also suppress crazing during cutting.

[Constitution of Gas Barrier Film]

(Base: Base)

The base of the gas barrier film of the present invention (hereinafter also referred to as a base) is not particularly limited as long as it is formed with an organic material capable of holding a gas barrier layer having a gas barrier property (first barrier layer + second barrier layer).

Examples may include each resin film of an acrylic acid ester, a methacrylic acid ester, polyethylene terephthalate (PET), polybutylene terephthalate, polyethylene naphthalate (PEN), polycarbonate (PC), polyarylate, polyvinyl chloride (PVC), polyethylene (PE), polypropylene (PP), polystyrene (PS), nylon (Ny), aromatic polyamide, polyether ether ketone, polysulfone, polyether sulfone, polyimide, polyetherimide, or the like; a heat-resistant transparent film containing silsesquioxane having an organic-inorganic hybrid structure as a basic skeleton (product name Sila-DEC, manufactured by Chisso Corporation); and, in addition, resin films prepared by laminating two or more layers of the resins. With respect to the cost or the ease of acquisition, polyethylene terephthalate (PET), polybutylene terephthalate, polyethylene naphthalate (PEN), polycarbonate (PC), and the like are preferably used; and, further, with respect to optical transparency, heat resistance, and adhesiveness between the first barrier layer and the gas barrier layer, a heat-resistant transparent film containing silsesquioxane having an organic-inorganic hybrid structure as a basic skeleton may be preferably used. In addition, it is also preferable to use polyimide or the like as a heat-resistant base. This is because use of the heat-resistant base (ex. Tg>200°C) enables heating at a temperature of 200 °C or more in a device production step and achievement of the lower resistance of a pattern layer due to a transparent conductive layer or metal nanoparticles necessary for enlarging the area of the device and for improving the operation efficiency of the device. That is, this is because the initial characteristics of the device can be greatly improved. Further, the thickness of the base is preferably around 5 to 500 μm, further preferably 15 to 250 μm.

Further, the base according to the present invention is preferably transparent. This is because the base which is transparent and a layer form on the base which is also transparent enable a transparent gas barrier film to be made and therefore also a transparent base for an organic EL element or the like to be made.

Further, the base employing any resin as mentioned above may be a non- stretched film or a stretched film.

The base used in the present invention can be produced by a common method known in the art. For example, a substantially amorphous, non-oriented, and non-stretched base can be produced by melting a resin as a material in an extruder and extruding the melt through a ring die or a T-die to quench the melt. Further, a stretched base may be produced by stretching a non-stretchedbase in a base flow (longitudinal axis) direction or a direction perpendicular (transverse axis) to the base flow direction by a known method such as uniaxial stretching, tenter-type sequential biaxial stretching, tenter-type simultaneous biaxial stretching, or tubular simultaneous biaxial stretching. The stretching magnification in this case is preferably 2 to 10 times in each of the longitudinal axis direction and the transverse axis direction, although the stretching magnification may be appropriately selected in accordance with the resin as a raw material of the base.

Further, for the base according to the present invention, corona treatment may also be carried out prior to forming the first barrier layer.

(Intermediate Layer)

The gas barrier film of the present invention has one characteristic of having an intermediate layer between the base and the first barrier layer.

The intermediate layer according to the present invention is not particularly limited as long as the intermediate layer contains a resin as a main component and has a layer constitution. As used herein, the main component means that 50 mass% or more, preferably 75 mass% or more, more preferably 100 mass% in the whole layer is occupied. The presence of the intermediate layer can prevent contraction stress at the time of forming the second barrier layer from concentrating on the first barrier layer.

Further, as a resin used for the intermediate layer, a UV curable resin, a thermosetting resin, or the like may be used without particular limitation, and it is preferable to have a thermosetting resin from the viewpoint of improvement in durability due to improvement in gas barrier properties/ improvement in interlaminar adhesiveness. This is because the use of the thermosetting resin in the intermediate layer can suppress discoloration of the intermediate layer and peeling from the base or the first barrier layer even if heating is carried out at a high temperature of 200°C or more. Furthermore, by enabling high- temperature heating at 200°C or more, interlaminar adhesiveness between the first barrier layer (CVD layer) and the second barrier layer (TFB layer) is improved and gas barrier performance is also improved. As a result of elasticity modulus analysis, it is inferred that, since the elasticity moduli of both conversion

region and non- conversion region of the second barrier layer are high after the high- temperature heating, the film is changed to a denser film, a gas barrier property is improved, a polymerization reaction proceeds in the interface between the first barrier layer and the second barrier layer, and adhesiveness is also improved.

Examples of the thermosetting resin applicable to the intermediate layer include, but are not particularly limited to, thermosetting urethane resins comprising acrylic polyols and isocyanate prepolymers, phenolic resins, urea melamine resins, epoxy resins, unsaturated polyester resins, silicon resins (resins containing silsesquioxane having an organic-inorganic hybrid structure as a basic skeleton; and the like), and the like. Of these, the epoxy resins and the silicon resins are particularlypreferred and the epoxy resins are more preferred.

Further, as the UV curable resin used in the intermediate layer, a compound having an acrylate- based functional group is preferably used. Examples of the compound having an acrylate- based functional group include oligomers, prepolymers, and the like of polyfunctional (meth) acrylates of polyester resins, polyether resins, acrylic resins, epoxy resins, urethane resins, alkyd resins, spiroacetal resins, polybutadiene resins, polythiolpolyene resins, polyhydric alcohol resins, and the like.

Further, examples of the intermediate layer may include those commonly used as names of anchor coat layers, smooth layers, bleedout layers, hard coat layers, and the like. However, the intermediate layer may be a layer containing a binder resin (e.g., a thermosetting resin, a UV curable resin) without limitation to the names.

<Anchor Coat Layer>

It is preferable to form an anchor coat layer as the intermediate layer on the surface of the base according to the present invention for the purpose of improving adhesiveness with the first barrier layer. Examples of anchor coat agents used for the anchor coat layer include polyester resins, isocyanate resins, urethane resins, acrylic resins, ethylene vinyl alcohol resins, vinyl modified resins, epoxy resins, modified styrene resins, modified silicon resins, alkyl titanate, and the like, which may be used singly or in combination of two or more kinds thereof. Of these, the epoxy resins are particularly preferred. An additive known in the art can also be added to these anchor coat agents. In addition, the coating may be performed by coating such an anchor coat agent as described above on the base by a known method, such as roll coat, gravure coat, knife coat, dip coat, or spray coat, and drying to remove a solvent and a diluent. The amount of the coated anchor coat agent as described above is preferably around 0.1 to 5 g/$m^2$ (in a dry state).

<Smooth Layer>

Furthermore, it is desirable to dispose a smooth layer as the intermediate layer on the surface of the base according to the present invention. Particularly, the surface preferably has a pencil hardness of H or more, as defined in JIS K 5600- 5- 4. Further, it is preferable to dispose the such a smooth layer as to have a maximum cross- sectional height Rt (p) of 10 nm<Rt (p) <30 nm, as defined in JIS B 0601: 2001, as for the surface roughness of the intermediate layer.

The film thickness of the smooth layer is not limited but the film thickness of the smooth layer is preferably 0.1 μm to 10 μm, further preferably in the range of 0.5 μm to 6 μm, for covering the recesses and projections of the surface of the resin base to form the smooth surface and for securing flexibility.

Particularly, when the second barrier layer is formed on the first barrier layer by chemical vapor deposition by conversion of a coated film with a silicon compound as in the present invention, the second barrier layer has merits of repairing the defects of the first barrier layer and smoothing a surface but, on the other hand, also has such a demerit that, due to occurrence of contraction in a conversion process from the coated film to the high- density inorganic film having a high gas barrier property, a defect may occur by applying the stress thereof to the first barrier layer and the constitution of the present invention may not be sufficiently utilized.

As a result of extensive examination, the present inventors found that the disposition of such a smooth layer that a layer in the lower portion of the first barrier layer has a surface maximum elevation difference Rt of 10 nm<Rt<30 nm can prevent contraction stress during forming the second barrier layer from concentrating on the first barrier layer to most exert the effect of the constitution of the present invention.

Furthermore, a higher content of the inorganic component of the smooth layer is preferred from the viewpoint of adhesiveness between the first barrier layer and the base and from the viewpoint of increasing the hardness of the smooth layer and a composition ratio thereof in the whole smooth layer is preferably 10 mass% or more, further preferably 20 mass% or more. The smooth layer may have organic- inorganic hybrid composition like a mixture of an organic resinous binder (photosensitive resin) with inorganic particles or may be an inorganic layer which can be formed by a sol- gel method or the like.

The smooth layer is also disposed in order to flatten the roughened surface of a transparent resin film base, on which projections and/or the like are present, or to fill and flatten recesses and projections or pinholes generated in the first barrier layer which is transparent by the projections present on the transparent resin film base. Such a smooth layer is basically formed by curing a thermosetting resin or a photosensitive resin.

Examples of the thermosetting resin used in formation of the smooth layer include, but are not particularly limited to, thermosetting urethane resins comprising acrylic polyols and isocyanate prepolymers, phenolic resins, urea melamine resins, epoxy resins, unsaturated polyester resins, silicon resins (resins containing silsesquioxane having an organic-inorganic hybrid structure as a basic skeleton; and the like), and the like. Of these, the epoxy resins and the silicon resins are preferred and the epoxy resins are particularly preferred.

Further, examples of the photosensitive resin used in formation of the smooth layer include a resin composition comprising an acrylate compound having a radical reactive unsaturated compound; a resin composition comprising an acrylate compound and a mercapto compound having a thiol group; a resin composition in which a polyfunctional acrylate monomer such as epoxy acrylate, urethane acrylate, polyester acrylate, polyether acrylate, polyethylene glycolacrylate, or glycerol methacrylate is dissolved; and the like. Any mixture of such resin compositions as described above may also be used and is not particularly limited as long as the mixture is a photosensitive resin containing a reactive monomer having one or more photopolymerizable unsaturated bonds in a molecule.

Examples of the reactive monomer having one or more photopolymerizable unsaturated bonds in a molecule include methylacrylate, ethylacrylate, n- propylacrylate, isopropyl acrylate, n- butyl acrylate, isobutyl acrylate, tert- butyl acrylate, n- pentyl acrylate, n- hexyl acrylate, 2- ethyl hexyl acrylate, n- octyl acrylate, n- decyl acrylate, hydroxyethyl acrylate, hydroxypropyl acrylate, allyl acrylate, benzyl acrylate, butoxyethyl acrylate, butoxyethylene glycol acrylate, cyclohexyl acrylate, dicyclopentanyl acrylate, 2- ethylhexylacrylate, glycerolacrylate, glycidylacrylate, 2- hydroxyethyl acrylate, 2- hydroxypropyl acrylate, isobornyl acrylate, isodecyl acrylate, isooctyl acrylate, lauryl acrylate, 2- methoxyethyl acrylate, methoxy ethylene glycol acrylate, phenoxy ethyl acrylate, stearyl acrylate, ethylene glycol diacrylate, diethylene glycol diacrylate, 1, 4- butanediol diacrylate, 1, 5- pentanediol diacrylate, 1, 6- hexadiol diacrylate, 1, 3- propanediol acrylate, 1, 4- cyclohexanediol diacrylate, 2, 2- dimethylolpropane diacrylate, glycerol diacrylate, tripropylene glycol diacrylate, glycerol triacrylate, trimethylolpropane triacrylate, polyoxyethyl trimethylolpropane triacrylate, pentaerythritol triacrylate, pentaerythritol tetraacrylate, ethylene oxide modified pentaerythritol triacrylate, ethylene oxide modified pentaerythritol tetraacrylate, propione oxide modified pentaerythritol triacrylate, propione oxide modified pentaerythritol tetraacrylate, triethylene glycol diacrylate, polyoxypropyl trimethylolpropane triacrylate, butylene glycol diacrylate, 1, 2, 4- butanediol triacrylate, 2, 2, 4- trimethyl- 1, 3- pentadiol diacrylate, diallyl fumarate, 1, 10- decanediol dimethylacrylate, pentaerythritol hexaacrylate, and monomers obtained by substituting the above- described acrylates by methacrylates, γ- methacryloxypropyltrimethoxysilane, 1- vinyl- 2- pyrrolidone, and the like. The above- described reactive monomers may be used singly or as mixtures of two or more kinds thereof or as mixtures with other compounds.

As a composition of the photosensitive resin, a photopolymerization initiator is contained.

Examples of the photopolymerization initiator include benzophenone, methyl o- benzoylbenzoate, 4, 4- bis (dimethylamine) benzophenone, 4, 4- bis (diethylamine) benzophenone, α- aminoacetophenone, 4, 4- dichlorobenzophenone, 4- benzoyl- 4- methyldiphenyl ketone, dibenzyl ketone, fluorenone, 2, 2- diethoxyacetophenone, 2, 2- dimethoxy- 2- phenylacetophenone, 2- hydroxy- 2- methylpropiophenone, p- tert- butyldichloroacetophenone, thioxanthone, 2- methylthioxanthone, 2- chlorothioxanthone, 2- isopropylthioxanthone, diethylthioxanthone, benzyldimethyl ketal, benzylmethoxyethyl acetal, benzoin methyl ether, benzoin butyl ether, anthraquinone, 2- tert- butylanthraquinone, 2- amylanthraquinone, β- chloroanthraquinone, anthrone, benzanthrone, dibenzosuberone, methyleneanthrone, 4- azidobenzylacetophenone, 2, 6- bis (p- azidebenzylidene) cyclohexane, 2, 6- bis (p- azidebenzylidene)- 4- methylcyclohexanone, 2- phenyl- 1, 2- butadione- 2- (o- methoxycarbonyl) oxime, 1- phenyl- propanedione- 2- (o- ethoxycarbonyl) oxime, 1, 3- diphenyl- propanetrione- 2- (o- ethoxycarbonyl) oxime, 1- phenyl- 3- ethoxy- propanetrione- 2- (o- benzoyl) oxime, Michler's ketone, 2- methyl [4- (methylthio) phenyl]- 2- morpholino- 1- propane, 2- benzyl- 2- dimethylamino- 1- (4- morpholinophenyl)- butanone- 1, naphthalenesulfonyl chloride, quinolinesulfonyl chloride, n- phenylthioacridone, 4, 4- azobisisobutyronitrile, diphenyl disulfide, benzthiazole disulfide, triphenylphosphine, camphorquinone, carbon tetrabromide, tribromophenylsulfone, benzoin peroxide, and Eosine, as well as combinations of a photoreductive pigment such as Methylene Blue and a reducing agent such as ascorbic acid or triethanolamine, and the like, which photopolymerization initiators may be used singly or in combination of two or more kinds thereof.

The method for forming a smooth layer is not particularly limited, however, the formation is preferably performed by wet coating methods such as spin coating methods, spray coating methods, blade coating methods, and dip coating methods, and dry coating methods such as vapor deposition methods.

In the formation of the smooth layer, an additive such as an oxidation inhibitor, an ultraviolet ray absorber, or a plasticizer may be optionally added to the above-mentioned photosensitive resin. A resin or an additive suitable for improving the film forming property or for preventing occurrence of pinholes may also be used in any smooth layer irrespective of the laminate position of the smooth layer.

Examples of solvents used when the smooth layer is formed by using a coating liquid in which the photosensitive resin is dissolved or dispersed in such a solvent may include alcohols such as methanol, ethanol, n- propanol, isopropanol, ethylene glycol, and propylene glycol; terpenes, such as α- or β- terpineol, and the like; ketones such as acetone, methyl ethyl ketone, cyclohexanone, N- methyl- 2- pyrrolidone, diethyl ketone, 2- heptanone, and 4- heptanone; aromatic hydrocarbons such as toluene, xylene, and tetramethylbenzene; glycol ethers such as cellosolve, methyl cellosolve,

ethyl cellosolve, carbitol, methyl carbitol, ethyl carbitol, butyl carbitol, propylene glycol monomethyl ether, propylene glycol monoethyl ether, dipropylene glycol monomethyl ether, dipropylene glycol monoethyl ether, triethylene glycol monomethyl ether, and triethylene glycol monoethyl ether; acetic esters such as ethyl acetate, butyl acetate, cellosolve acetate, ethyl cellosolve acetate, butyl cellosolve acetate, carbitol acetate, ethyl carbitol acetate, butyl carbitol acetate, propylene glycol monomethyl ether acetate, propylene glycol monoethyl ether acetate, 2- methoxyethyl acetate, cyclohexyl acetate, 2- ethoxyethyl acetate, and 3- methoxybutyl acetate; diethylene glycol dialkyl ether, dipropylene glycol dialkyl ether, ethyl 3- ethoxypropanoate, methyl benzoate, N, N- dimethylacetamide, N, N- dimethylformamide, and the like.

As described above, as the smoothness of the smooth layer, a maximum cross-sectional height Rt(p), which is a value represented by surface roughness specified in JIS B 0601, is preferably 10 nm or more and 30 nm or less. In the case of less than 10 nm, a coating property may be deteriorated when coating means contacts with the surface of the smooth layer in a coating manner with a wire bar, a wireless bar, or the like in the step of coating a silicon compound described below. Further, in the case of more than 30 nm, it may be difficult to smooth recesses and projections after coating the silicon compound.

The surface roughness is roughness regarding the amplitude of fine recesses and projections, calculated from the profile curve with recesses and projections, consecutively measured by a detector having a tracer with a very small tip radius, by AFM (atomic force microscope), in which a section of several tens of μm in a measurement direction is measured many times by the tracer with a very small tip radius. Specifically, a measured range at one step is 80 μm×80 μm and three measurements are carried out on different measurement spots.

In accordance with one of preferred aspects of the smooth layer, when an optically photosensitive resin is used as the additive, for example, for the smooth layer, reactive silica particles into the surface of which a photosensitive group having photopolymerization reactivity is introduced (hereinafter also simply referred to as "reactive silica particles") are contained in the photosensitive resin. Examples of the photosensitive group having photopolymerizability mayinclude polymerizable unsaturated groups represented by a (meth) acryloyloxy group; and the like. The photosensitive resin may also contain a compound of which photopolymerization reaction is performed with the photosensitive group having photopolymerization reactivity introduced into the surface of the reactive silica particles, for example, an unsaturated organic compound having a polymerizable unsaturated group. Further, the photosensitive resin with a solid content adjusted by appropriately mixing such reactive silica particles or an unsaturated organic compound having a polymerizable unsaturated group with a general-purpose diluting solvent may be used.

As for the average particle diameter of the reactive silica particles, an average particle diameter of 0.001 to 0.1 μm is preferred. By adjusting the average particle diameter in such a range, a smooth layer having both an optical property in which an antiglare property and resolution are satisfied in a good balance, which is an effect of the present invention, and a hard-coat property becomes easier to form, by use in combination with a matting agent comprising inorganic particles with an average particle diameter of 1 to 10 μm described below. From the viewpoint of obtaining such an effect more easily, it is more preferable to use reactive silica particles having an average particle diameter of 0.001 to 0.01 μm.

Such inorganic particles as mentioned above are preferably contained in the smooth layer used in accordance with the present invention in the mass ratio of 10% or more. It is further preferable to contain 20% or more. Addition of 10% or more results in improvement in adhesiveness with the gas barrier layer.

In accordance with the present invention, there may be used as reactive silica particles a substance in which silica particles are chemically bonded by generating a silyloxy group between the silica particles via a hydrolysis reaction of a hydrolyzable silyl group of a hydrolyzable silane modified with a polymerizable unsaturated group.

Examples of the hydrolyzable silyl group include carboxylate silyl groups such as an alkoxy silyl group and an acetoxy silyl group; halogenated silyl groups such as a chloro silyl group; an amino silyl group; an oxime silyl group; a hydrido silyl group; and the like.

Examples of the polymerizable unsaturated group include an acryloyloxy group, a methacryloyloxy group, a vinyl group, a propenyl group, a butadienyl group, a styryl group, an ethynyl group, a cinnamoyl group, a malate group, an acrylamide group, and the like.

In accordance with the present invention, it is desirable that the thickness of the smooth layer be 0.1 to 10 μm, preferably 1 to 6 μm. The thickness of 1 μm or more results in sufficient smoothness for a film having a smooth layer and also in easy improvement in surface hardness while the thickness of 10 μm or less results in easy adjustment of the balance in the optical property of a smooth film and enables prevention of the curl of a smooth film when a smooth layer is disposed only on one surface of a transparent polymeric film.

<Bleedout Preventing Layer>

In the gas barrier film of the present invention, a bleedout preventing layer may be disposed as the intermediate layer. The bleedout preventing layer is disposed on the surface opposite to the surface of the base having the smooth

layer for the purpose of inhibiting the phenomenon of the contamination of the contact surface due to the migration of an unreacted oligomer and/or the like from the inside of the film base to the surface, when the film having the smooth layer is heated. As long as the bleedout preventing layer has this function, the bleedout preventing layer may have the same constitution as that of the smooth layer.

Further, since large film contraction occurs when conversion treatment is performed, it is preferable to suppress crosswise deformation thereof and to prevent crazing. To that end, a so- called hard coat layer having a high surface hardness or elasticity modulus can be disposed while the above- described bleedout preventing layer can serve as the role of the hard coat layer.

As an unsaturated organic compound having a polymerizable unsaturated group, which may be incorporated in the bleedout preventing layer, mention may be made of a polyvalent unsaturated organic compound having two or more polymerizable unsaturated groups in the molecule or a monovalent unsaturated organic compound having one polymerizable unsaturated group in the molecule.

Examples of the polyvalent unsaturated organic compound include ethylene glycol di (meth) acrylate, diethylene glycol di (meth) acrylate, glycerol di (meth) acrylate, glycerol tri (meth) acrylate, 1, 4- butanediol di (meth) acrylate, 1, 6- hexanediol di (meth) acrylate, neopentyl glycol di (meth) acrylate, trimethylolpropane tri (meth) acrylate, dicyclopentanyl di (meth) acrylate, pentaerythritol tri (meth) acrylate, pentaerythritol tetra (meth) acrylate, dipentaerythritol hexa (meth) acrylate, dipentaerythritol monohydroxypenta (meth) acrylate, ditrimethylolpropane tetra (meth) acrylate, diethylene glycol di (meth) acrylate, polyethylene glycol di (meth) acrylate, tripropylene glycol di (meth) acrylate, polypropylene glycol di (meth) acrylate, and the like.

Further, examples of the monovalent unsaturated organic compound include methyl (meth) acrylate, ethyl (meth) acrylate, propyl (meth) acrylate, butyl (meth) acrylate, 2- ethylhexy (meth) acrylate, isodecyl (meth) acrylate, lauryl (meth) acrylate, stearyl (meth) acrylate, allyl (meth) acrylate, cyclohexyl (meth) acrylate, methylcyclohexyl (meth) acrylate, isobornyl (meth) acrylate, 2- hydroxyethyl (meth) acrylate, 2- hydroxypropyl (meth) acrylate, glycerol (meth) acrylate, glycidyl (meth) acrylate, benzyl (meth) acrylate, 2- ethoxyethyl (meth) acrylate, 2- (2- ethoxyethoxy) ethyl (meth) acrylate, butoxyethyl (meth) acrylate, 2- methoxyethyl (meth) acrylate, methoxydiethylene glycol (meth) acrylate, methoxytriethylene glycol (meth) acrylate, methoxypolyethylene glycol (meth) acrylate, 2- methoxypropyl (meth) acrylate, methoxydipropylene glycol (meth) acrylate, methoxytripropylene glycol (meth) acrylate, methoxypolypropylene glycol (meth) acrylate, polyethylene glycol (meth) acrylate, polypropylene glycol (meth) acrylate, and the like.

As other additive agents, a matting agent may be incorporated. As a matting agent, inorganic particles having an average particle diameter of around 0.1 to 5 μm are preferred.

As such inorganic particles, one kind or two or more kinds in combination of silica, alumina, talc, clay, calcium carbonate, magnesium carbonate, barium sulfate, aluminum hydroxide, titanium dioxide, zirconium dioxide, and the like may be used.

The matting agent containing inorganic particles is desirably contained in a rate of 2 parts by mass or more, preferably 4 parts by mass or more, and more preferably 6 parts by mass or more, but 20 parts by mass or less, preferably 18 parts by mass or less, and more preferably 16 parts by mass or less, based on 100 parts by mass of the solid content of a hard coat agent.

In the bleedout preventing layer, a thermoplastic resin, a thermosetting resin, an ionizing radiation curable resin, a photopolymerization initiator, or the like as a component other than a hard coat agent and a matting agent, may also be incorporated. It is particularly preferable to incorporate a thermosetting resin.

Examples of the thermosetting resin include thermosetting urethane resins comprising acrylic polyols and isocyanateprepolymers, phenolicresins, ureamelamine resins, epoxy resins, unsaturated polyester resins, silicon resins, and the like.

Further, examples of the thermoplastic resin include cellulose derivatives such as acetyl cellulose, nitrocellulose, acetyl butyl cellulose, ethyl cellulose, and methyl cellulose; vinyl- based resins such as vinyl acetate and copolymers thereof, vinyl chloride and copolymers thereof, and vinylidene chloride and copolymers thereof; acetal- based resins such as polyvinyl formal and polyvinyl butyral; acrylic resins such as acryl resins and copolymers thereof and methacryl resins and copolymers thereof; polystyrene resins; polyamide resins; linear polyester resins; polycarbonate resins; and the like.

Further, as the ionizing radiation curable resin, there may be used a resin cured by irradiating an ionizing radiation curing coating mixed with one or two or more of photopolymerizable prepolymers, photopolymerizable monomers, and the like with ionizing radiation (ultraviolet rays or electron beams) . As the photopolymerizable prepolymer, there is particularly preferably used an acrylic prepolymer that has two or more acryloyl groups in one molecule and is provided with a three- dimensional network structure by crosslinking curing. As the acrylic prepolymer, urethane acrylate, polyester acrylate, epoxy acrylate, melamine acrylate, or the like may be used. Further, as the photopolymerizable monomers, the polyvalent unsaturated organic compounds described above and the like may be used.

Further, examples of the photopolymerization initiator include acetophenone, benzophenone, Michler's ketone, benzoin, benzyl methyl ketal, benzoin benzoate, hydroxycyclohexyl phenyl ketone, 2- methyl- 1- (4- (methylthio) phenyl)-2- (4- morpholinyl)- 1- pr opane, α- acyloxime ester, thioxanthones, and the like.

Such a bleedout preventing layer as described above can be formed by preparing a coating liquid by blending a hard coat agent, a matting agent, and optionally another component with an appropriately optionally used diluting solvent, coating the coating liquid on the surface of the base film by a coating method known in the art, and thereafter irradiating the liquid with ionizing radiation to cure the liquid. A method for irradiation with ionizing radiation can be performed by irradiation with ultraviolet rays in a wavelength region of 100 to 400 nm, preferably 200 to 400 nm, emitted from an ultra-high-pressure mercury lamp, a high-pressure mercury lamp, a low-pressure mercury lamp, a carbon arc, a metal halide lamp, or the like, or by irradiation with electron beams in a wavelength region of 100 nm or less, emitted from a scanning- or curtain-type electron beam accelerator.

It is desirable that the thickness of the bleedout preventing layer in accordance with the present invention be 1 to 10 μm, preferably 2 to 7 μm. The thickness of 1 μm or more easily allows sufficient heat resistance for a film while the thickness of 10 μm or less results in easy adjustment of the balance in the optical property of a smooth film and enables prevention of the curl of a barrier film when a smooth layer is disposed only on one surface of a transparent polymeric film.

«Package Form of Gas Barrier Film»

The gas barrier film of the present invention can be consecutively produced and wound up in roll form (so-called roll-to-roll production). In doing so, it is preferable to affix a protective sheet to a surface on which the gas barrier layer is formed and to wind up the gas barrier film. Particularly, a defect often occurs due to contaminants (e.g., particles) adhering to a surface when the gas barrier film of the present invention is used as a sealant for an organic thin film device, so that it is very effective to affix the protective sheet in a location with a high degree of cleanliness to prevent the adhesion of contaminants. Also, it is effective for preventing a flaw on the surface of the gas barrier layer, generated during winding up.

As the protective sheet, which is not particularly limited, there may be used common "protective sheet" or "release sheet" having a constitution in which a resin substrate with a film thickness of around 100 μm is provided with an adhesive layer with weak tackiness.

«Method for Measuring Characteristic Values of Gas Barrier Film»

Each characteristic value of the gas barrier film of the present invention can be measured according to the following method.

[Measurement of Moisture Vapor Transmission Rate]

For measuring a moisture vapor transmission rate according to the B method described in JIS K 7129 (1992) as mentioned above, various methods are proposed. For example, mentions is made of, as representatives, acupmethod, a dryness and moisture sensor method (Lassy method), and an infrared radiation sensor method (mocon method), but, in these methods, the measurement limit may be reached with improving a gas barrier property, so that methods described below are also proposed.

<Methods for Measuring Moisture Vapor Transmission Rate Other Than The Above>

1. Ca method

A method of utilization of a phenomenon that a metal Ca is deposited on a gas barrier film and the metal Ca is corroded with water passing through the film. Amoisturevapor transmission rate is calculated from a corrosion area and time to arrive thereat.

2. A method proposed by MORESCO Corporation (News Release on December 8, 2009) : A method of delivery between a sample space under atmospheric pressure and a mass spectrometer in an ultra-high vacuum through a cold trap for moisture vapor.

3. HTO method (General Atomics (U.S.)): A method of calculating a moisture vapor transmission rate by using tritium.

4. Method proposed by A-Star (Singapore) (International Publication No. WO 2005/95924): A method of calculating a moisture vapor transmission rate from a variation in electrical resistance and a 1/f fluctuation component existing therein by using a material (e.g., Ca, Mg) with electrical resistance varied by moisture vapor or oxygen in a sensor.

In the gas barrier film of the present invention, a method for measuring a moisture vapor transmission rate is not particularly limited but measurement by a Ca method described below, as the method for measuring a moisture

vapor transmission rate in accordance with the present invention, was carried out.

<Ca Method Used in the Present Invention>

Vapor deposition apparatus: Vacuum deposition apparatus JEE-400, manufactured by JEOL Ltd.
Constant temperature-constant humidity oven: Yamato Humidic Chamber IG47M
Metal corroded by reaction with water: Calcium (granular)
Moisture vapor impermeable metal: Aluminum (φ3-5 mm, granular)
Production of Cell for Evaluation of Moisture Vapor Barrier Property

Metal calcium was evaporated on the surface of the gas barrier layer of a barrier film sample using a vacuum deposition apparatus (vacuum deposition apparatus JEE-400, manufactured by JEOL Ltd.), while masking other than the portions to be evaporated (9 portions of 12 mm×12 mm) on the barrier film sample before a transparent conductive film was formed. Then, the mask was removed while the vacuum state was maintained, and aluminum was evaporated from another metal evaporation source onto the whole surface of one side of the sheet. After the aluminum sealing, the vacuum state was released, and, promptly, the aluminum sealed surface was faced with quartz glass having a thickness of 0.2 mm through a UV curable resin for sealing (manufactured by Nagase ChemteX Corporation) under dried nitrogen atmosphere, followed by being irradiated with ultraviolet light to produce the evaluation cells. In order to confirm the change in gas barrier property before and after the bending, cells for evaluation of a moisture vapor barrier property were produced also using gas barrier films which were not subjected to the above-described bending treatment.

The obtained samples with both sealed surfaces were stored under a high temperature and a high humidity of 60°C and 90% RH, and the amount of water permeated into the cell was calculated from the amount of corrosion of metal calcium based on the method described in JP- 2005- 283561- A.

In order to confirm that there is no moisture permeation from a surface other than the barrier film surface, a sample in which metal calcium was evaporated on a 0.2 mm thick quartz glass plate instead of the barrier film sample was stored under the same high temperature and high humidity of 60°C and 90% RH, as a comparative sample, to confirm that there was no corrosion of metal calcium even after a lapse of 1000 hours.

The gas barrier film of the present invention preferably has a lower moisture vapor transmission rate, for example, preferably of 0.001 to 0.00001 $g/m^2 \cdot 24$ h, more preferably 0.0001 to 0.00001 $g/m^2 \cdot 24$ h.

[Measurement of Oxygen Transmission Rate]

The measurement is performed using an oxygen transmission rate measuring apparatus (model name: "OXTRAN" (registeredtrademark) ("OXTRAN" 2/20)) manufactured by MOCON (U.S.) under the conditions of a temperature of 23°C and a humidity of 0% RH based on the B method (isopiestic method) described in JIS K7126 (1987). Further, the measurement is each performed once for two test pieces and the average value of two measured values is regarded as the value of an oxygen transmission rate.

The gas barrier film of the present invention preferably has a lower oxygen transmission rate, for example, more preferably of less than 0.001 $g/m^2 \cdot 24$ h·atm (not more than the detection limit).

«Electronic Device»

The gas barrier film of the present invention can be applied to an electronic device. The gas barrier film can be preferably used not only in an organic thin film device such as an organic thin film photoelectric conversion element or an organic electroluminescence element but also in a display electronic device such as flexible LCD or electronic paper for which a manufacturing method includes high temperature treatment.

[Organic Photoelectric Conversion Element]

The gas barrier film of the present invention can be used as various materials for sealing and films for sealing and, for example, can be used in a film for sealing an organic photoelectric conversion element.

When the gas barrier film of the present invention is used in an organic photoelectric conversion element, such a constitution that the gas barrier film is used as a base to receive sunlight from the arrangement side of the gas barrier film is enabled since the gas barrier film of the present invention is transparent. That is, for example, a transparent conductive thin film such as ITO can be disposed as a transparent electrode on the gas barrier film to constitute a resin base for an organic photoelectric conversion element. In addition, the ITO transparent conductive film disposed on the

base is used as an anode, a porous semiconductor layer is disposed thereon, a cathode including a metal film is further formed to form an organic photoelectric conversion element, another sealing material (which may be the same) is overlapped thereon, the gas barrier film base is adhered to the periphery thereof to seal the element, thereby enabling the organic photoelectric conversion element to be sealed, and, as a result, the influence of a gas such as moisture or oxygen in outside air on the organic photoelectric conversion element can be blocked.

The resin base for an organic photoelectric conversion element is obtained by forming a transparent conductive film on the gas barrier layer of the gas barrier film formed in such a manner.

Formation of a transparent conductive film can be conducted by using a vacuum deposition method, a sputtering method, or the like and it can also be produced by a coating method such as a sol-gel method using, e.g., a metal alkoxide of indium, tin, or the like. As for the (average) film thickness of the transparent conductive film, the transparent conductive film in the range of 0.1 to 1000 nm is preferred.

Subsequently, the gas barrier film of the present invention and an organic photoelectric conversion element employing a resin base for an organic photoelectric conversion element in which a transparent conductive film is formed thereon will be described.

[Sealing Film and Method for Producing Sealing Film]

In accordance with the present invention, the gas barrier film of the present invention can be used as a substrate for a sealing film.

Regarding the gas barrier film of the present invention, on a gas barrier layer unit, a transparent conductive layer is further formed as an anode, a layer constituting an organic photoelectric conversion element and a layer to be a cathode are laminated on the anode, and another additional gas barrier film is overlapped thereon as a sealing film, followed by adhering to enable sealing.

Further, particularly, a metal foil on which resin laminate (polymer film) is formed cannot be used as a gas barrier film on the light ejecting side but is preferably used as a sealing film when it is a sealing material which is inexpensive and has further low moisture vapor permeability and is not intended to be used for ejection of light (not to be require transparency) .

In accordance with the present invention, a metal foil refers to a metallic foil or film formed by rolling or the like, and it is distinguished from a metal thin film formed by sputtering, vapor deposition, or the like, or from a conductive film formed from a fluid electrode material such as a conductive paste.

Examples of the metal foil, of which the kind of the metal is not particularly limited, include a copper (Cu) foil, an aluminum (Al) foil, a gold (Au) foil, a brass foil, a nickel (Ni) foil, a titanium (Ti) foil, a copper alloy foil, a stainless steel foil, a tin (Sn) foil, a high nickel alloy foil, and the like. Among these various metal foils, particularly preferable metal foils include an Al foil.

The thickness of the metal foil is preferably 6 to 50 μm. In the case of less than 6 μm, pinholes may be opened during use depending on a material used in the metal foil to prevent a necessary barrier property (moisture vapor transmission rate, oxygen transmission rate) from being obtained. In the case of more than 50 μm, a cost maybe increased or the thickness of an organic photoelectric conversion element may be increased depending on a material used in the metal foil, so that the number of the merits of the film may be reduced.

In a metal foil laminated with a resin film (a polymer film), various materials described in "Kinousei Housouzairyo No Shintenkai" (New Development of Functionalized Wrapping Material) (Toray Research Center, Inc.) may be used for the resin film, examples of which include polyethylene-based resins, polypropylene-based resins, polyethylene terephthalate-based resins, polyamide-based resins, ethylene-vinyl alcohol copolymer-based resins, ethylene-vinyl acetate copolymer-based resins, acrylonitrile-butadiene copolymer-based resins, cellophane-based resins, vinylon-based resins, vinylidene chloride-based resins, and the like. A resin such as a polypropylene-based resin or a nylon-based resin may be stretched, or, further, may be coated with a vinylidene chloride-based resin. With respect to a polyethylene-based resin, a low density resin or a high density resin may also be used.

Although will be mentioned later, as a method for sealing two films, for example, a method of laminating a resin layer which can be thermally fused using a commonly used impulse sealer and sealing the resin layer with an impulse sealer by fusing is preferred; and, in this case, the (average) film thickness is desirably 300 μmor less since, as for sealing between gas barrier films, when the (average) film thickness of the film is more than 300 μm, handleability of the film during a sealing operation is deteriorated and thermal fusion with an impulse sealer or the like is precluded.

[Sealing of Organic Photoelectric Conversion Element]

In accordance with the present invention, the organic photoelectric conversion element can be sealed by: forming each layer of an organic photoelectric conversion element on a resin base for an organic photoelectric conversion element produced by forming a transparent conductive layer on the resin film (gas barrier film) having the gas barrier

layer unit of the present invention; and thereafter covering the cathode surface with the above-described sealing film under an environment purged with an inert gas.

As the inert gas, a noble gas such as He or Ar is preferably used besides $N_2$, a noble gas obtained by mixing He and Ar is also preferred, and the ratio of a noble gas to the gas phase is preferably 90 to 99.9% by volume. The storage stability is improved by sealing under an environment purged with an inert gas.

When an organic photoelectric conversion element is sealed using the metal foil laminated with a resin film (polymer film), it is preferable to form a ceramic layer on a metal foil and to adhere the surface of the ceramic layer onto the cathode of the organic photoelectric conversion element, but not the surface of the laminated resin film. When the polymer film side of the sealing film is adhered onto the cathode of the organic photoelectric conversion element, it may occasionally happen that electrical conduction partially occurs.

As a method of adhering a sealing film onto the cathode of an organic photoelectric conversion element, mention is made of a method of laminating a resin film which is commonly used and can be thermally fused with an impulse sealer, for example, a film which is can be thermally fused, such as an ethylene-vinyl acetate copolymer (EVA) or polypropylene (PP) film or a polyethylene (PE) film, followed by sealing by fusing with an impulse sealer.

As an adhesion method, a dry lamination method is excellent in view of workability. In this method, a curable adhesive layer of around 1.0 to 2.5 μm is generally used. However, since the adhesive may tunnel, bleed out, or cause wrinkles by shrinking when the applied amount of the adhesive is too much, the applied amount of the adhesive is preferably adjusted within 3 to 5 μm as a dried (average) film thickness.

Hot melt lamination is a method to melt a hot melt adhesive and apply it onto a base to form an adhesive layer, and, in this method, the thickness of the adhesive layer can be set generally in a wide range of 1 to 50 μm. As a base resin for a generally used hot melt adhesive, EVA, EEA, polyethylene, butyl rubber, or the like is used, rosin, a xylene resin, a terpene-based resin, a styrene-based resin, or the like is used as a tackifying agent, and a wax or the like is used as a plasticizer.

An extrusion lamination method is a method to apply a resin melted at high temperature onto a based using a die, and it is possible to set the thickness of the resin layer generally in a wide range of 10 to 50 μm.

As a resin used for the extrusion lamination, LDPE, EVA, PP, or the like is generally used.

[Ceramic Layer]

In the gas barrier film of the present invention, a ceramic layer formed of a compound with an inorganic oxide, a nitride, a carbide, or the like can be disposed from the viewpoint of, e.g., further enhancement of a gas barrier property when the organic photoelectric conversion element is sealed, as mentioned above.

Specifically, it can be formed with $SiO_x$, $Al_2O_3$, $In_2O_3$, $TiO_x$, ITO (tin-indium oxide), AlN, $Si_3N_4$, $SiO_xN$, $TiO_xN$, SiC, or the like.

The ceramic layer may be laminated by a known procedure such as a sol-gel method, a vapor deposition method, CVD, PVD, or a sputtering method.

For example, it can also be formed using polysilazane by the same method as in the case of the second barrier layer. In this case, it can be formed by coating a composition comprising polysilazane to form a polysilazane coating, followed by being converted into ceramic.

Further, as for the ceramic layer according to the present invention, composition of silicon oxide or a metal oxide containing silicon oxide as a main component, or a mixture of a metal carbide, a metal nitride, a metal sulfide, a metal halide, and the like (such as a metal oxynitride or a metal oxide- halide), or the like can be separately produced by selecting conditions of an organometallic compound which is a source material (also referred to as raw material), a decomposition gas, decomposition temperature, an input power, and the like in an atmospheric pressure plasma method.

Silicon oxide is generated, for example, by using a silicon compound as a source compound and oxygen as a decomposition gas. Further, silicon nitride oxide is generated by using silazane or the like as a source compound. This is because very active charged particles/active radicals are present at high density in plasma space, a multi-stage chemical reaction is therefore promoted at a very high speed in the plasma space, and elements present in the plasma space are converted into a thermodynamically stable compound in a very short time.

Such a source material for forming a ceramic layer may be in any gas, liquid, or solid state under ordinary temperature and normal pressure as long as it is a silicon compound. It can be introduced without being processed into discharge space when it is gas whereas it is vaporized by means such as heating, bubbling, decompression, or ultrasonic irradiation and is usedwhenitisliquidorsolid. Further, itmayalsobediluted with a solvent and used, and, as the solvent, organic solvents such as methanol, ethanol and n-hexane, and mixed solvents thereof may be used. Since these diluent solvents are decomposed in a molecular or atomic state during plasma discharge treatment, their influences can be almost disregarded.

Examples of such silicon compounds include silane, tetramethoxysilane, tetraethoxysilane, tetra- n- propoxysilane, tetraisopropoxysilane, tetra- n- butoxysilane, tetra- t- butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3, 3, 3- trifluoropropyl) trimethoxysilane, hexamethyldisiloxane, bis (dimethylamino) dimethylsilane, bis (dimethylamino) methylvinylsilane, bis (ethylamino) dimethylsilane, N, O- bis (trimethylsilyl) acetamide, bis (trimethylsilyl) carbodiimide, diethylaminotrimethylsilane, dimethylaminodimethylsilane, hexamethyldisilazane, heaxamethylcyclotrisilazane, heptamethyldisilazane, nonamethyltrisilazane, octamethylcyclotetrasilazane, tetrakisdimethylaminosilane, tetraisocyanatesilane, tetramethyldisilazane, tris (dimethylamino) silane, triethoxyfluorosilane, allyldimethylsilane, allyltrimethylsilane, benzyltrimethylsilane, bis (trimethylsilyl) acetylene, 1, 4- bistrimethylsilyl- 1, 3- butadiine, di- t- butylsilane, 1, 3- disilabutane, bis (trimethylsilyl) methane, cyclopentadienyltrimethylsilane, phenyldimethylsilane, phenyltrimethylsilane, propargyltrimethylsilane, tetramethylsilane, trimethylsilylacetylene, 1- (trimethylsilyl)- 1- propine, tris (trimethylsilyl) methane, tris (trimethylsilyl) silane, vinyltrimethylsilane, hexamethyldisilane, octamethylcyclotetrasiloxane, tetramethylcyclotetrasiloxane, hexamethylcyclotetrasiloxane, M silicate 51, and the like.

Further, examples of decomposition gases for decomposing these source gases containing silicon to obtain a ceramic layer include hydrogen gas, methane gas, acetylene gas, carbon monoxide gas, carbon dioxide gas, nitrogen gas, ammonium gas, nitrogen monoxide gas, nitrogen oxide gas, nitrogen dioxide gas, oxygen gas, moisture vapor, fluorine gas, hydrogen fluoride, trifluoroalcohol, trifluorotoluene, hydrogen sulfide, sulfur dioxide, carbon disulfide, chlorine gas, and the like.

A ceramic layer containing silicon oxide and a nitride, a carbide, or the like can be obtained by appropriately selecting a source gas containing silicon and a decomposition gas.

In the atmospheric pressure plasma method, these reactive gases are mixed with a discharge gas which easily become generally in a plasma state and the gas is fed into a plasma discharge generator. As such a discharge gas, nitrogen gas and/or an element from Group 18 of the periodic table, specifically, helium, neon, argon, krypton, xenon, radon, or the like is used. Of these, particularly, nitrogen, helium, and argon are preferably used.

A film is formed by mixing the above-described discharge gas and reactive gas and supplying the mixture as a thin film forming (mixing) gas to an atmospheric pressure plasma discharge generator (plasma generator). Although the rates of the discharge gas and the reactive gas depend on the property of the film to be obtained, the reactive gas is supplied at a rate of the discharge gas to the whole mixed gas, of 50% or more.

In the laminated ceramic layer constituting the gas barrier resin base according to the present invention, the ceramic layer mainly composed of silicon oxide according to the present invention containing at least any one of an O atom and a N atom and a Si atom can be obtained by combining, for example, the above-described organosilicic compound with further an oxygen gas and a nitrogen gas at a specified rate.

The thickness of the ceramic layer according to the present invention is desirably within the range of 10 to 2000 nm in consideration of a gas barrier property and light transmissiveness while it is preferably 10 to 200 nm for exerting preferable performance in a good balance on the whole further in consideration of flexibility.

Subsequently, each layer of an organic photoelectric conversion element material (constitution layer) constituting an organic photoelectric conversion element will be described.

[Constitution of Organic Photoelectric Conversion Element and Solar Cell]

Preferred aspects of the organic photoelectric conversion element of the present invention will be explained, however, the present invention is not limited thereto.

The organic photoelectric conversion element is not particularly limited, and it is preferably an element which has an anode, a cathode and at least one electric power generation layer (a mixed layer of a p-type semiconductor and an n-type semiconductor, also referred to as a bulk heterojunction layer or an i layer) sandwiched between both, and generates electric current when irradiated with light.

Preferred specific examples of the layer constitution of the organic photoelectric conversion element will be described below. (i) Anode/electric power generation layer/cathode; (ii) anode/hole transport layer/electric power generation layer/cathode; (iii) anode/hole transport layer/electric power generation layer/electron transport layer/cathode; (iv) anode/hole transport layer/p-type semiconductor layer/electric power generation layer/n-type semiconductor layer/electron transport layer/cathode; (v) anode/hole transport layer/first light-emitting layer/electron transport layer/intermediate electrode/hole transport layer/second light-emitting layer/electron transport layer/cathode.

The electric power generation layer needs to contain a p-type semiconductor material which can convey a hole, and an n-type semiconductor material which can convey an electron, and these materials may form a heterojunction with substantially two layers or may form a bulk heterojunction with one layer inside of which is of a mixed state, while the bulk heterojunction is preferred because of high photoelectric conversion efficiency. The p-type semiconductor material and the n-type semiconductor material used in the electric power generation layer will be described later.

As the same as the case of an organic EL element, the efficiency of taking out holes and electrons from the anode/cathode, respectively, can be improved by sandwiching the electric power generation layer with a hole transport layer and an electron transport layer and, therefore, the constitutionshavingthose ((ii) and (iii)) aremorepreferred. The

electric power generation layer itself may also be of a constitution in which the electric power generation layer is sandwiched between a layer containing a p-type semiconductor material and a layer containing an n-type semiconductor material as in (iv) (also referred to as p-i-n constitution) in order to improve the rectification property of holes and electrons (selectivity of carriers taken out). In order to raise the utilization efficiency of sunlight, it may also be of a tandem constitution (constitution in (v)) in which sunlight with different wavelengths is absorbed by respective electric power generation layers.

In order to improve the utilization rate of sunlight (photoelectric conversion efficiency), it is also possible to adopt a constitution of a back contact type organic photoelectric conversion element in which a hole transport layer 14 and an electron transport layer 16 are formed on a pair of comb electrodes, respectively, and a photoelectric conversion portion 15 is arranged thereon, instead of the sandwich structure in an organic photoelectric conversion element 10 as illustrated later in Figure 3.

Further, detailed preferred aspects of the organic photoelectric conversion elements of the present invention will be described below.

Figure 3 is a cross-sectional view illustrating an example of a solar cell including a bulk heterojunction type organic photoelectric conversion element.

In Figure 3, in a bulk heterojunction type organic photoelectric conversion element 10, a transparent electrode 12, a hole transport layer 17, an electric power generation layer 14 of a bulk heterojunction layer, an electron transport layer 18, and a counter electrode 13 are sequentially laminated on one surface of a substrate 11.

The substrate 11 is a member which holds the transparent electrode 12, the electric power generation layer 14, and the counter electrode 13 which are laminated sequentially. In this embodiment, light to be photoelectrically converted enters from the side of the substrate 11 and, accordingly, the substrate 11 is a member which can transmit light to be photoelectrically converted, namely, a transparent member with respect to the wavelength of light to be photoelectrically converted. As the substrate 11, for example, a glass substrate, a resin substrate, or the like is used. The substrate 11 is not always necessary and the organic bulk heterojunction type organic photoelectric conversion element 10 may also be constituted by forming the transparent electrode 12 and the counter electrode 13 on both sides of the electric power generation layer 14, for example.

The electric power generation layer 14 is a layer which converts light energy into electric energy, and is constituted of a bulk heterojunction layer in which a p-type semiconductor material and an n-type semiconductor material are uniformly mixed. A p-type semiconductor material functions as a relatively electron donating material (donor), and an n-type semiconductor material functions as a relatively electron accepting material (acceptor).

In Figure 3, light incident from the transparent electrode 12 through the substrate 11 is absorbed by an electron acceptor or an electron donor in the bulk heterojunction layer of the photoelectric conversion layer 14, an electron is transferred from the electron donor to the electron acceptor to form a pair of a hole and an electron (charge separation state). The generated electric charge is transported by an internal electric field, for example, the electric potential difference of the transparent electrode 12 and the counter electrode 13 when the work functions of the transparent electrode 12 and the counter electrode 13 are different, an electron passes between electron acceptors while a hole passes between electron donors, and the electron and the hole each are transported to different electrodes, and a photocurrent is detected. For example, when the work function of the transparent electrode 12 is larger than the work function of the counter electrode 13, the electron is transported to the transparent electrode 12 and the hole is transported to the counter electrode 13. In addition, if the size of a work function is reversed, the electron and the hole will be transported to the reverse direction to that described above. Moreover, the transportation directions of an electron and a hole are also controllable by applying a potential between the transparent electrode 12 and the counter electrode 13.

In addition, although not described in Figure 3, it may also have another layer such as a hole-blocking layer, an electron-blocking layer, an electron injection layer, a hole injection layer, or a smoothing layer.

More preferred constitution is a constitution in which the above-mentioned electric power generation layer 14 is composed of three layered constitution of so-called p-i-n as illustrated in Figure 4. The usual bulk heterojunction layer is a single layer i containing a p-type semiconductor material and an n-type semiconductor material mixed with each other; and, by sandwiching the i layer 14i between a p layer 14p composed of a p-type semiconductor material single substance and an n layer 14n composed of an n-type semiconductor material single substance, the rectifying property of a hole and an electron becomes higher, the loss caused by the recombination or the like of a hole and an electron which effect charge separation is reduced, and still higher photoelectric conversion efficiency can be acquired.

Furthermore, it is also possible to make a tandem type constitution produced by laminating such photoelectric conversion elements for the purpose of improving a sunlight utilization factor (photoelectric conversion efficiency).

Figure 5 is a cross-sectional view illustrating an example of a solar cell including an organic photoelectric conversion element including a tandem-type bulk heterojunction layer.

In the case of a tandem type constitution, after laminating a transparent electrode 12 and a first electric power generation layer 14' successively on a substrate 11, a charge recombination layer 15 is laminated, thereafter, a second electric power generation layer 16 and then a counter electrode 13 are laminated to achieve a tandem type constitution. The second electric power generation layer 16 may be a layer which absorbs the same spectrum as an absorption

spectrum of the first electric power generation layer 14', or it maybe a layer which absorbs a different spectrum, however, it is preferably a layer which absorbs a different spectrum. Moreover, both first electric power generation layer 14' and second electric power generation layer 16 may also be of the three layered lamination constitution of p-i-n as mentioned above.

Materials constituting these layers will be explained below.

[Organic Photoelectric Conversion Element Material]

(P-Type Semiconductor Material)

Examples of p-type semiconductor materials used in an electric power generation layer (bulk heterojunction layer) in an organic photoelectric conversion element include various condensed polycyclic aromatic low molecular weight compounds and conjugated polymers and oligomers.

Examples of the condensed polycyclic aromatic low molecular weight compounds include compounds such as anthracene, tetracene, pentacene, hexacene, heptacene, chrysene, picene, fulminene, pyrene, peropyrene, perylene, terylene, quoterylene, coronene, ovalene, circumanthracene, bisanthene, zethrene, heptazethrene, pyanthrene, violanthene, isoviolanthene, circobiphenyl, and anthradithiophene; porphyrin, copper phthalocyanine; tetrathiafulvalene (TTF)-tetracyanoquinodimethane (TCNQ) complex, bis (ethylenedithio) tetrathiafulvalene (BEDT- TTF)- perchloric acid complex; and derivatives and precursors thereof.

Examples of the derivatives containing the condensed polycyclic compounds described above include pentacene derivatives having a substituent described in WO 03/16599, WO 03/28125, U.S. Pat. No. 6, 690, 029, JP- 2004-107216- A, and the like; pentacene precursors described in US 2003/136964; acene- based compounds substituted by a trialkylsilylethynyl group described in J. Amer. Chem. Soc., vol, vol 127. No 14. 4986, J. Amer. Chem. Soc., vol. 123, p 9482, J. Amer. Chem. Soc., vol. 130 (2008), No. 9, 2706, and the like; and the like.

Examples of the conjugated polymers include polythiophenes such as poly-3-hexylthiohene (P3HT) and oligomers thereof, polythiophenes having a polymerizable group described in Technical Digest of the International PVSEC-17, Fukuoka, Japan, 2007, P. 1225, polythiophene-thienothiophene copolymers described in Nature Material, (2006) vol. 5, p 328, polythiophene-diketopyrrolopyrrole copolymers described in International Publication No. WO 2008/000664, polythiophene-thizolothiazole copolymers described in Adv Mater, 2007 p 4160, polythiophene copolymers such as PCPDTBT described in Nature Mat., vol. 6 (2007), p 497, polypyrroles and oligomers thereof, polyanilines, polyphenylenes and oligomers thereof, polyphenylenevinylenes and oligomers thereof, polythienylenevinylenes and oligomers thereof, polyacethylene, polydiacetylene, polymer materials such as o-conjugated polymers such as polysilane and polygerman.

As oligomer materials rather than polymer materials, oligomers such as: α- sexithionenea, ω- dihexyl- α- sexithionene, α, ω- dihexyl- α- quinquethionene, and α, ω- bis (3- butoxypropyl)- α- sexithionene, which are thiophene hexamers, can be preferably used.

Among these compounds, preferred are compounds which have such high solubility into an organic solvent that a solution process can be carried out and which forma crystalline thin film and can realize a high mobility after drying.

When an electron transporting layer is formed on an electric power generation layer by a coating method, since there may occur the problem that the solution for the electron transporting layer may dissolve the electric power generation layer, there can also be used such a material as to be insoluble after forming a layer in a solution process.

Examples of such materials may include materials insoluble through cross- linked polymerization after being coated, such as polythiophenes having a polymerizable group as described in Technical Digest of the International PVSEC- 17, Fukuoka, Japan, 2007, p 1225; materials insoluble (to be pigments) by reaction of a soluble substituent by applying energy such as heat as described in US 2003/136964, JP- 2008- 16834- A, and the like; and the like.

(N-Type Semiconductor Material)

Examples of n-type semiconductor materials used in the bulk heterojunction layer in the organic photoelectric conversion element may include, but are not particularly limited to, e.g., fullerene, octaazaporphyrin, etc., a perfluoro compound of a p-type semiconductor, of which hydrogen atoms are replaced with fluorine atoms (such as perfluoropentacene or perfluorophthalocyanine), and a polymer compound which contains an aromatic carboxylic acid anhydride and its imide as a skeleton, such as naphthalenetetracarboxylic anhydride, naphthalenetetracarboxylic diimide, perylenetetracarboxylic anhydride, or perylenetetracarboxylic diimide.

However, preferred is a fullerene derivative which enables high speed (~50 fs) and effective charge separation with varieties of p- type semiconductor materials. Examples of the fullerene derivative may include fullerene C60, fullerene C70, fullerene C76, fullerene C78, fullerene C84, fullerene C240, fullerene C540, mixed fullerene, fullerene nano- tube, multilayered nano- tube, single- layered nano- tube, nano- horn (cone type), and the like, and a fullerene derivative

obtained by substituting a part thereof with a hydrogen atom, a halogen atom, a substituted or unsubstituted alkyl group, an alkenyl group, an alkynyl group, an aryl group, a heteroaryl group, a cycloalkyl group, a silyl group, an ether group, a thioether group, an amino group, a silyl group, or the like.

Among these, it is preferable to use a fullerene derivative which has an improved solubility by having a substituent, such as [6, 6]- phenyl C61- butyric acid methyl ester (abbreviated name: PCBM), [6, 6]- phenyl C61- butyric acid- n- butyl ester (PCBnB), [6, 6]- phenyl C61- butyric acid- isobutyl ester (PCBiB), [6, 6]- phenyl C61- butyric acid n-hexyl ester (PCBH), bis- PCBM described in Adv. Mater., vol. 20 (2008), p 2116, amino fullerene described in JP- 2006-199674- A, metallocene fullerene described in JP- 2008- 130889- A, and fullerene having a cyclic ether group described in U.S. Pat. No. 7329709.

(Hole Transport Layer, Electron-Blocking Layer)

The organic photoelectric conversion element 10 preferably has the hole transport layer 17 in the middle between the bulk heterojunction layer and the anode, since it becomes possible to more effectively take out charges generated in the bulk heterojunction layer.

For the hole transport layer 17, there can be used, for example: PEDOT, such as BaytronP (trade name) manufactured by Starck Vitec Co.; polyaniline and its dope material; a cyan compound described in WO 2006/019270; and the like. In addition, the hole transport layer which has a LUMO level shallower than the LUMO level of the n- type semiconductor material used in a bulk heterojunction layer is imparted with an electron- blocking function having an rectifying effect by which the electron generated in the bulk heterojunction layer is not passed to the anode side. Such a hole transport layer is also called an electron- blocking layer, and it is more preferable to use a hole transport layer having such a function. Examples of these materials include triaryl amine- based compounds as descriJP- 5- 271166-A, metal oxides such as molybdenum oxide, nickel oxide and tungsten oxide, and the like. Moreover, the layer which includes a single substance of a p- type semiconductor material used in the bulk heterojunction layer can also be used. As means for forming these layers, although any one of a vacuum deposition method and a solution coating method can be used, preferably used is a solution coating method. When a coated film is formed in an under layer before forming the bulk heteroj unction layer, it will have an effect of leveling the coating surface, an effect such as leaking is reduced, and it is therefore preferable.

(Electron Transport Layer/Hole-Blocking Layer)

The organic photoelectric conversion element 10 preferably has the electron transport layer 18 in the middle between the bulk heterojunction layer and the cathode, since it becomes possible to more effectively take out charges generated in the bulk heterojunction layer.

As the electron transport layer 18, there can be used: octaazaporphyrin and a perfluoro compound of a p-type semiconductor (such as perfluoro pentacene or perfluoro phthalocyanine), and, similarly, the electron transport layer which has a HOMO level deeper than the HOMO level of the p-type semiconductor material used for a bulk heterojunction layer is imparted with a hole blocking function having an rectifying effect by which the hole generated in the bulk heterojunction layer is not passed to the cathode side. Such an electron transport layer is also called a hole-blocking layer, and it is more preferable to use the electron transport layer which have such a function. As such materials, there can be used phenanthrene-based compounds such as bathocuproine; n-type semiconductor materials such as naphthalenetetracarboxylic acid anhydride, naphthalenetetracarboxylic acid diimide, perylenetetracarboxylic acid anhydride and perylenetetracarboxylic acid diimide; n-type inorganic oxides such as titanium oxide, zinc oxide and gallium oxide; alkali metal compounds such as lithium fluoride, sodium fluoride and cesium fluoride; and the like. Moreover, the layer including a single substance of an n-type semiconductor material used in the bulk heterojunction layer can also be used. As means for forming these layers, although any one of a vacuum deposition method and a solution coating method can be used, preferably used is the solution coating method.

(Other Layers)

It is also preferable to have a constitution containing various intermediate layers in an element for the purpose of improvement in energy conversion efficiency and improvement in lifetime of the element. Examples of the interlayer may include hole-blocking layers, electron-blocking layers, hole injection layers, electron injection layers, exciton blocking layers, UV absorption layers, light reflection layers, wavelength conversion layers, and the like.

(Transparent Electrode (First Electrode))

In the organic photoelectric conversion element, the transparent electrode may be a cathode or an anode and

can be selected according to the constitution of the organic photoelectric conversion element, but the transparent electrode is preferably used as an anode. For example, when the transparent electrode is used as an anode, it is preferably an electrode which transmits light of 380 to 800 nm. As materials, there can be used, for example, transparent conductive metal oxides such as indium tin oxide (ITO), $SnO_2$, and ZnO; metal thin films such as gold, silver, and platinum; metal nanowires; and carbon nanotubes.

Also usable is a conductive polymer selected from the group consisting of derivatives of: polypyrrole, polyaniline, polythiophene, polythienylene vinylene, polyazulene, polyisothianaphthene, polycarbazole, polyacethylene, polyphenylene, polyphenylene vinylene, polyacene, polyphenyl acetylene, polydiacetylene,andpolynaphthalene. A transparent electrode can also be constructed by combining a plurality of these conductive compounds.

(Counter Electrode (Second Electrode))

A counter electrode may also be a sole layer of a conductive material, however, in addition to materials with conductivity, a resin may also be used in combination to hold the materials. As a conductive material for the counter electrode, there is used a material in which a metal, an alloy, or an electric conductive compound, having a small work function (4 eV or less), or a mixture thereof is used as an electrode material. Specific examples of such electrode materials include sodium, sodium-potassium alloy, magnesium, lithium, magnesium/copper mixtures, magnesium/silver mixtures, magnesium/aluminum mixtures, magnesium/indium mixtures, aluminum/aluminum oxide ($Al_2O_3$) mixtures, indium, lithium/aluminum mixtures, rare earth metals, and the like. Among these, from the viewpoints of a taking out property of an electron and resistance to oxidation and/or the like, preferable is a mixture of these metals and the second metal which is a metal that has a larger work function and is more stable than these metals, for example, a magnesium/silver mixture, a magnesium/aluminum mixture, a magnesium/indium mixture, an aluminum/aluminum oxide ($Al_2O_3$) mixture, a lithium/aluminum mixture, aluminum, or the like. The counter electrode can be produces by forming a thin film by using a method such as vapor deposition or sputtering of the electrode materials. Further, the (average) film thickness is generally selected from 10 nm to 5 $\mu$m, and preferably from 50 to 200 nm.

When a metallic material is used as a conductive material for a counter electrode, light reaching the counter electrode side is reflected and it is reflected to the first electrode side, this light becomes possible to be reused, it is again absorbed by a photoelectric conversion layer, and this is preferable because this results in more improvement in its photoelectric conversion efficiency.

The counter electrode 13 may also be made of: a metal (for example, gold, silver, copper, platinum, rhodium, ruthenium, aluminum, magnesium, indium, or the like), nanoparticles made of carbon, nanowires, and a nano structure; and a dispersion of nanowires is preferable, since it can form a transparent counter electrode having high electrical conductivity by a coating method.

When the counter electrode side is made light transmissive, after thinly producing a film of a conductive material suitable for a counter electrode, for example, aluminum and aluminum alloy, silver, a silver compound, and the like, having a (average) film thickness of around 1 to 20 nm, a light transmissive counter electrode can be produced by disposing a film of a conductive light transmissive material cited for the description of the above-described transparent electrode.

(Intermediate Electrode)

As a material for an intermediate electrode which is needed in a tandem constitution as described in the above-mentioned (v) (or in Figure 5), preferable is a layer using the compound having both transparency and electrical conductivity, and materials used for the above-mentioned transparent electrode are usable (a transparent metal oxide such as ITO, AZO, FTO, or titanium oxide; a very thin metal layers made of such as Ag, Al, and Au; a layer containing nanoparticles and nanowires; a conductive polymer material such as PEDOT: PSS or polyaniline; and the like).

In addition, among the aforementioned hole transport layer and electron transport layer, there may be a combination used as an intermediate electrode (electric charge recombination layer) when they are suitably combined and laminated with each other, and, when such a constitution is employed, it is preferable since a step for forming one layer can be eliminated.

(Metal Nanowire)

A conductive fiber can be used in the organic photoelectric conversion element, an organic or inorganic fiber coated with a metal, a conductive metal oxide fiber, a metal nanowire, a carbon fiber, a carbon nanotube, or the like can be used as the conductive fiber, and a metal nanowire is preferred.

Generally, a metal nanowire indicates a linear structure composed of a metallic element as a main component. In particular, the metal nanowire in accordance with the present invention means a linear structure having a diameter

of a nanometer (nm) size.

In order to form a long conductive path by one metal nanowire and to express an appropriate light scattering property, a metal nanowire according to the present invention preferably has an average length of 3 μm or more, further preferably 3 to 500 μm, and particularly preferably 3 to 300 μm. In addition, the relative standard deviation of the length is preferably 40% or less. Moreover, from the viewpoint of transparency, the average diameter is preferably smaller while the average diameter is preferably larger from the viewpoint of electrical conductivity. In accordance with the present invention, the average diameter of the metal nanowire is preferably from 10 to 300 nm, and more preferably from 30 to 200 nm. In addition, the relative standard deviation of the diameter is preferably 20% or less.

There is no restriction in particular to the metal composition of the metal nanowire according to the present invention, and it can be composed of one or a plurality of metals of noble metal elements or base metal elements; it preferably contains at least one metal belonging to the group consisting of noble metals (for example, gold, platinum, silver, palladium, rhodium, iridium, ruthenium, osmium, and the like), iron, cobalt, copper, and tin; and at least silver is preferably included in it from the viewpoint of electrical conductivity. Moreover, for the purpose of achieving compatibility of conductivity and stability (sulfuration or oxidation resistance and migration resistance of metal nanowire), it also preferably contains silver and at least one metal belonging to the noble metals except silver. When the metal nanowire according to the present invention contains two or more metallic elements, for example, metal composition may be different between the surface and the inside of the metal nanowire or the whole metal nanowire may have the same metal composition.

In accordance with the present invention, there is no limitation in particular to means for producing a metal nanowire but, for example, a known method such as a liquid phase method or a gas phase method may be used. There is also no limitation in particular to a specific production method, a known production method may be used. For example, a method for producing an Ag nanowire may be referred to Adv. Mater. , 2002, 14, 833- 837; Chem. Mater., 2002, 14, 4736- 4745, and the like; a method for producing an Au nanowire may be referred to JP- 2006- 233252- A and the like; a method for producing a Cu nanowire may be referred to JP- 2002- 266007- A and the like; and a method for producing a Co nanowire may be referred to JP- 2004- 149871- A and the like. Particularly, the methods for producing Ag nanowires, reported in Adv. Mater. and Chem. Mater. as mentioned above, may be preferably applied as a method for producing a metal nanowire according to the present invention, since it is possible to easilyproduce an Ag nanowire in an aqueous system and the electrical conductivity of silver is maximum of all metals.

In accordance with the present invention, a three-dimensional conductive network is formed by mutual contact of nanowires and high conductivity is expressed; light can penetrate the window part of the conductive network where no metal nanowire is present, and further, it becomes possible to perform efficiently the generation of electricity from the organic photoelectric conversion layer portion by the scattering effect of the metal nanowires. It is a preferable embodiment to arrange a metal nanowire in a portion closer to the organic electric power generation layer portion in the first electrode because the scattering effect can be effectively utilized.

(Optical Function Layer)

The organic photoelectric conversion element of the present invention may include various optical function layers for the purpose of efficiently receiving sunlight. As an optical function layer, there may be disposed, for example, an anti-reflection film; a light condensing layer such as a microlens array; a light diffusion layer which can scatter light reflected by the cathode and can make the light incident again on the electric power generation layer; and the like.

As anti-reflection layers, various known anti-reflection layers can be disposed; for example, when a transparent resin film is a biaxial stretching polyethylene terephthalate film, it is preferable to set the refractive index of the adhesion assisting layer, which is adjacent to the film, to be from 1.57 to 1.63 since this will improve transmittance by decreasing the interface reflection between the film substrate and the adhesion assisting layer. As a method of adjusting a refractive index, it can be carried out by appropriately adjusting the ratio of a binder resin to an oxide sol having a comparatively high refractive index such as a tin oxide sol or a cerium oxide sol and by coating it. Although the adhesion assisting layer may be a single layer, in order to improve an adhesion property, a constitution of two or more layers may also be used.

Regarding the light condensing layer, it is possible to increase an amount of the receiving light from a specific direction or, conversely, to reduce the incident angle dependency of sunlight by performing processing to dispose a structure on a microlens array on the sunlight receiving side of the supporting substrate or by using in combination with a so-called light condensing sheet.

As an example of a microlens array, there is made an arrangement in which the quadrangular pyramidal forms having a side of 30 μm and a vertex angle of 90 degrees are two-dimensionally arranged on the light taking out side of a substrate. The side is preferably in the range of 10 to 100 μm. When it is less than this range, the effect of diffraction will occur to result in coloring, while when it is more than this range, the thickness becomes large, whereby it is not preferable.

Further, examples of light scattering layers may include various anti- glare layers; layers in which nanoparticles,

nanowires, and the like made of metals, various inorganic oxides, and the like are distributed in colorless transparent polymers; and the like.

(Film Production Method and Surface Treatment Method)

<Method for Forming Various Layers>

Examples of methods for forming a bulk heterojunction layer in which an electron acceptor and an electron donor are mixed, a transport layer and an electrode may include vapor deposition methods, coating methods (including cast methods and spin coat methods), and the like. Of these, examples of methods for forming a bulk heterojunction layer may include vapor deposition methods, coating methods (including cast methods and spin coat methods), and the like. Among these, a coating method is preferred in order to increase the area of the interface which carries out charge separation of the above-mentioned hole and electron and to produce an element having high photoelectric conversion efficiency. Further, the coating method is also excellent in production velocity.

Although there is no limitation in the coating method to be used in this case, examples of the method include spin coating methods, cast methods from a solution, dip coating methods, blade coating methods, wire bar coating methods, gravure coating methods, spray coating methods, and the like. Furthermore, pattering can also be carried out by printing methods such as inkjet methods, screen printing methods, letterpress printing methods, intaglio printing methods, offset printing methods, flexographic printing methods, and the like.

After coating, it is preferable to heat the film in order to remove the residual solvent, water, and a gas, as well as to improve the mobility and to shift the absorption in the longer wavelength due to crystallization of a semiconductor material. When annealing treatment is carried out at a predetermined temperature during a production step, aggregation or crystallization is microscopically promoted and a suitable phase separation structure can be made in a bulk heterojunction layer. As a result, the carrier mobility of the bulk heterojunction layer can be improved and high efficiency can be obtained.

The electric power generation layer (bulk heteroj unction layer) 14 may be constituted by a single layer containing a uniform mixture of an electron acceptor and an electron donor or may be constituted by a plurality of layers each having a different mixing ratio of an electron acceptor and an electron donor. In this case, the formation is enabled by using such a material which becomes insoluble after coating as mentioned above.

<Patterning>

There is no limitation in particular in the method and the process of patterning an electrode, an electric power generation layer, a hole transport layer, an electron transport layer, and the like in the production of the organic photoelectric conversion element of the present invention, and a known procedure can be applied appropriately.

In the case of a soluble material for abulkheterojunction layer, a transport layer, or the like, only a unnecessary part maybe wiped off after complete coating such as die coating or dip coating or it may be directly patterned during coating by using a method such as an inkjet method or a screen printing method.

In the case of an insoluble material such as an electrode material, mask deposition of an electrode can be performed during vacuum deposition or it can be patterned by a known method such as etching or lift-off. Further, it may also be possible to form a pattern by transferring the pattern formed on another substrate.

Although the constitution of the organic photoelectric conversion element and the solar cell was described above as an example of applications of the gas barrier film according to the present invention, the applications of the gas barrier film according to the present invention are not limited thereto but it can also be advantageously applied to other electronic devices such as organic EL elements.

Example

The present invention will be specifically explained with reference to examples below but the present invention is not limited thereto. In addition, in examples, the expression of "part(s)" or "%" is used but, unless otherwise specified, represents "part(s) by mass" or "mass%".

Example 1

«Production of Sample 1 (Gas Barrier Film)»

[Formation of First Barrier Layer 1]

A first barrier layer 1 (100 nm) of silicon oxide was formed on a transparent resin base with a hard coat layer (intermediate layer) (polyethylene terephthalate (PET) film with clear hard coat layer (CHC), manufactured by Kimoto Co., Ltd.; the hard coat layer is constituted by a UV cured resin containing an acryl resin as a main component; the thickness of PET is 125 μm; the thickness of CHC is 6 μm) by an atmospheric pressure plasma method using an atmospheric pressure plasma film production apparatus (atmospheric pressure plasma CVD apparatus in roll- to- roll form, illustrated in Figure 3 in JP- 2008- 56967- A) under the following thin film formation conditions:

(Mixed Gas Compositions)

Discharge gas: Nitrogen gas 94.9% by volume
Thin film formation gas: Tetraethoxysilane 0.1% by volume
Additive gas: Oxygen gas 5.0% by volume
(Film Formation Conditions)

<First Electrode Side>

Type of power source: Haiden Laboratory 100 kHz (Continuous mode) PHF-6k
Frequency: 100 kHz
Output density: 10 $W/cm^2$
Electrode temperature: 120°C

<Second Electrode Side>

Type of power source: Pearl Kogyo Co., Ltd., 13.56 MHz, CF-5000-13M
Frequency: 13.56 MHz
Output density: 10 $W/cm^2$
Electrode temperature: 90°C

The first barrier layer 1 formed according to the above-described method was constituted by silicon oxide ($SiO_2$) and had a film thickness of 100 nm and an elasticity modulus E1 of 30 GPa equally in a film thickness direction.

[Formation of Second Barrier Layer 1]

A 10 mass% solution of perhydropolysilazane (AQUAMICA NN120-10, non-catalyst type, manufactured by AZ Electronic Materials) in dibutyl ether was coated on the first barrier layer 1 formed by the above-described method with a wireless bar to have a (average) film thickness of 0.10 μm after drying to obtain a coated sample.

[First Step: Drying Treatment]

The resultant coated sample was treated under an atmosphere at a temperature of 85°C and a humidity of 55% RH for 1 minute to obtain the dried sample.

[Second Step: Dehumidification Treatment]

The dried sample was further maintained under an atmosphere at a temperature of 25°C and a humidity of 10% RH (dew-point temperature of -8°C) for 10 minutes to perform dehumidification treatment. The water content of the

layer obtained in such a manner was 0.01% or less (not more than the detection limit).

[Conversion treatment A]

The sample subjected to the dehumidification treatment was subjected to conversion treatment under the following conditions. The conversion treatment was carried out at a dew-point temperature of -8°C.

(Conversion treatment Apparatus)

Apparatus: Excimer irradiation apparatus MODEL: MECL- M- 1- 200, manufactured by M.D.COM. Inc.
Wavelength: 172 nm
Lamp filler gas: Xe

(Conversion treatment Conditions)

The sample fixed on operation stage was subjected to conversion treatment under the following conditions to form a second barrier layer 1.

Excimer light intensity: 130 mW/cm$^2$ (172 nm)
Distance between sample and light source: 1 mm
Stage heating temperature: 70°C
Oxygen concentration in irradiation apparatus: 1.0%
Excimer irradiation time: 5 seconds

The sample 1 which was a gas barrier film was produced in the manner described above.

[Confirmation of Conversion region]

As a result of observation of the cross section of the sample 1 produced as described above with TEM according to a method mentioned later, a conversion region was confirmed to be present in the second barrier layer 1 from its surface to 30 nm in the depth direction.

«Production of Sample 2»

[Formation of First Barrier Layer 2]

A first barrier layer 2 of silicon oxynitride (100 nm) was formed in the same manner except that the film production conditions in the formation of the barrier layer 1 in the above-described sample 1 were changed as described below.

(Mixed Gas Compositions)

Discharge gas: Nitrogen gas 94.9% by volume
Thin film formation gas: Tetraethoxysilane 0.1% by volume
Additive gas: Hydrogen gas 1.0% by volume

(Film Formation Conditions)

<First Electrode Side>

Type of power source: Haiden Laboratory 100 kHz

(Continuous mode) PHF-6k

Frequency: 100 kHz
Output density: 12 W/$cm^2$
Electrode temperature: 120°C

<Second Electrode Side>

Type of power source: Pearl Kogyo Co., Ltd., 13.56 MHz, CF-5000-13M
Frequency: 13.56 MHz
Output density: 12 W/$cm^2$
Electrode temperature: 90°C

The resultant first barrier layer 2 was silicon oxynitride (SiON) and has a film thickness of 100 nm and a nitrogen content of 0.8% by element ratio. It had an elastic modulus of 45 GPa equally in a film thickness direction (=E1).

[Formation of Second Barrier Layer 2]

Subsequently, a 10 mass% solution of perhydropolysilazane (AQUAMICA NN120- 10, non- catalyst type, manufactured by AZ Electronic Materials) in dibutyl ether was coated on the resultant first barrier layer 2 with a wireless bar to have a (average) film thickness of 0.10 μm after drying to obtain a coated sample.

[First Step: Drying Treatment]

The resultant coated sample was treated under an atmosphere at a temperature of 85°C and a humidity of 55% RH for 1 minute to obtain the dried sample.

[Second Step: Dehumidification Treatment]

The dried sample was further maintained under an atmosphere at a temperature of 25°C and a humidity of 10% RH (dew-point temperature of -8°C) for 10 minutes to perform dehumidification treatment. The water content of the layer obtained in such a manner was 0.01% or less (not more than the detection limit).

[Conversion treatment B]

The sample subjected to the dehumidification treatment was subjected to conversion treatment under the following conditions. The conversion treatment was carried out at a dew-point temperature of -8°C.

(Conversion treatment Apparatus)

Apparatus: Excimer irradiation apparatus MODEL: MECL- M- 1- 200, manufactured by M.D.COM. Inc.
Wavelength: 172 nm
Lamp filler gas: Xe

(Conversion treatment Conditions)

The sample fixed on operation stage was subjected to conversion treatment under the following conditions to form a second barrier layer 2.

Excimer light intensity: 130 mW/$cm^2$ (172 nm)
Distance between sample and light source: 1 mm

Stage heating temperature: 90°C
Oxygen concentration in irradiation apparatus: 0.1%
Excimer irradiation time: 3 seconds

The sample 2 of a gas barrier film was produced in the manner described above.
As a result of observation of the cross section of the sample 2 with TEM, a conversion region was confirmed to be formed with a thickness of 60 nm from the surface of the second barrier layer 2.

«Production of Sample 3»

[Formation of First Barrier Layer 3]

A first barrier layer 3 was formed on a transparent resin base (polyethylene terephthalate (PET) film with clear hard coat layer (CHC) manufactured by Kimoto Co., Ltd. (PET thickness 125 μm, CHC thickness 6 μm)) using a plasma CVD apparatus, Model PD-270STP, manufactured by Samco Inc., under the following thin film formation conditions.

(Thin Film Formation Conditions)

Oxygen pressure: 53.2 Pa
Reactive gas: Tetraethoxysilane (TEOS) 5 sccm (standard cubic centimeter per minute) Concentration 0.5%
Power: 100 W at 13.56 MHz
Base retention temperature: 120°C

The resultant first barrier layer 3 was silicon oxide ($SiO_2$) and had a film thickness of 100 nm and an elasticity modulus of 30 GPa equally in a film thickness direction (=E1).

[Formation of Second Barrier Layer 3]

Subsequently, a second barrier layer 3 subjected to the same treatment as in the formation of the second barrier layer 1 was formed on the resultant first barrier layer 3 to produce a sample 3 of a gas barrier film.
As a result of observation of the cross section of the sample 3 with TEM, a conversion region was confirmed to be formed in a region of 30 nm in depth from the surface of the second barrier layer 3.

«Production of Sample 4»

[Formation of First Barrier Layer 4]

A first barrier layer 4 (100 nm) of silicon oxynitride was formed by the same formation method as in the first barrier layer 1 in the sample 2.

[Formation of Second Barrier Layer 4]

A second barrier layer 4 was formed on the first barrier layer 4 to produce a sample 4, which was a gas barrier film, in the same manner except that the conversion treatment A used in the conversion treatment of the second barrier layer 1 in the production of the sample 1 was changed to conversion treatment C described below.

[Conversion treatment C]

The sample subjected to dehumidification treatment was subjected to plasma treatment under the following conditions to form the second barrier layer 4. Further, a base retention temperature during film production was 120°C.
Treatment was carried out using a roll electrode type discharge treatment apparatus. A plurality of bar-shaped electrodes facing the roll electrode were placed in parallel to the direction of conveying the film, a gas and a power were input into each electrode portion, and treatment was appropriately carried out so that a coated surface was irradiated with plasma for 20 seconds, as described below.
In addition, as for a dielectric coating each electrode described above of the plasma discharge treatment apparatus, the dielectric coated with alumina having an edge thickness of 1 mm by ceramic spraying processing was

used for both electrodes facing each other.

Further, the distance between the electrodes after coated was set to 0.5 mm. The metal matrix coated with the dielectric was of a jacket type made of stainless steel having a cooling function with cooling water, and the discharge was carried out while controlling the electrode temperature with the cooling water. A high frequency power source (100 kHz) manufactured by OYO Electric Co., Ltd. and a high frequency power source (13.56 MHz) manufactured by Pearl Kogyo Co., Ltd. were used as the power sources used in this case.

Discharge gas: $N_2$ gas
Reactive gas: oxygen gas of 7% based on all the gases
Power of low frequency side power source: 6 W/cm$^2$ at 100 kHz
Power of high frequency side power source: 10 W/cm$^2$ at 13.56 MHz
Plasma treatment time; 20 seconds

As a result of observation of the cross section of the sample 4 with TEM, a conversion region was confirmed to be present in a region of 10 nm in a depth direction from the surface of the second barrier layer 4.

«Production of Sample 5»

[Formation of First Barrier Layer 5]

A first barrier layer 5 (100 nm) of silicon oxynitride was formed by the same manner as the formation of the first barrier layer 1 in the sample 2.

[Formation of Second Barrier Layer 5]

A second barrier layer 5 was formed on the first barrier layer 5 to produce a sample 5, which was a gas barrier film, in the same manner except that the film thickness of the second barrier layer was 0.06 μm and the conversion treatment A was changed to conversion treatment D described below in the formation of the second barrier layer 1 of the sample 1.

[Conversion treatment D]

The sample subjected to dehumidification treatment was subjected to conversion treatment under the following conditions to form the second barrier layer 5. Further, the conversion treatment was carried out at a dew-point temperature of -8°C.

<Conversion treatment Apparatus>

Apparatus: Ultraviolet irradiation apparatus, Model UVH-0252C, manufactured by Ushio Inc.

<Conversion treatment Conditions>

The sample fixed on an operation stage was subjected to conversion treatment under the following conditions.

UV light intensity: 2000 mW/cm$^2$ (365 nm)
Distance between sample and light source: 30 mm
Stage heating temperature: 40°C
Oxygen concentration in irradiation apparatus: 5%
UV irradiation time: 180 seconds

As a result of observation of the cross section of the sample 5 with TEM, a conversion region in the second barrier layer 5 was confirmed to be present with a thickness of 55 nm from the surface in a depth direction.

«Production of Sample 6: Comparative Example»

Under the conditions of Example 1 described in JP- 2009- 255040- A, two second barrier layers with a thickness

of 100 nm were laminated and the resultant was regarded as a sample 6. In the sample 6, as a result of observation of the cross section thereof with TEM, no conversion region was confirmed.

«Production of Sample 7: Comparative Example»

A first barrier layer (silicon oxide) with a thickness of 100 nm was formed by a plasma CVD method under the conditions described in Example 1 in JP-3511325-B and a second barrier layer with a thickness of 0.1 μm was formed on the first barrier layer in the same manner to obtain a sample 7. As a result of observation of the cross section of the sample 7 with TEM, the presence of a conversion region was not confirmed.

«Production of Sample 8: Comparative Example»

A flattened film to be laminated on the barrier film described in Examples in JP- 2008- 235165- A was made to be a sample 8 in the same manner except that the coating conditions used for forming the second barrier layer 1 of the sample 1 was applied and the conversion treatment was further replaced by heat treatment at 90°C for 10 minutes. As a result of observation of the cross section of the sample 8 with TEM, the presence of a conversion region was not confirmed.

«Measurement of Characteristic Values of Gas Barrier Film, and Performance Evaluation»

Measurement of the characteristic values and performance evaluation of each sample as each gas barrier film which was produced as described above were carried out by the following method.

[Measurement of Film Thickness of Conversion region]

The ultra-thin section of each gas barrier film produced as described above was produced by an FIB processing apparatus described below, followed by performing TEM observation. At this time, when the sample was continuously irradiated with electron beams, there was made a contrast difference betweenapart (non-conversion region) damaged by the electron beams and a part (conversion region) which was not so, the thickness of the conversion region was calculated by measuring its region.

(FIB Processing)

Apparatus: SMI2050 manufactured by SII
Processing ions: (Ga 30 kV)
Sample thickness: 200 nm

(TEM Observation)

Apparatus: JEM2000FX manufactured by JEOL Ltd.

(Acceleration voltage: 200 kV)

Electron beam irradiation time: 30 seconds

[Measurement of Elasticity Moduli of Conversion regions and Non-Conversion regions in First Barrier Layer and Second Barrier Layer]

The cross section of each gas barrier film was exposed by FIB processing in the same manner as described above, followed by using a nano indenter (Nano Indenter TMXP/DCM) manufactured by MTS Systems Corporation to push the super-minute indenter with a triangular pyramid shape into each region of a cross section portion and by measuring the elasticity moduli of the conversion regions and the non-conversion regions in the first barrier layer and

the second barrier layer.

[Evaluation of Moisture Vapor Barrier Property]

The moisture vapor barrier property of each gas barrier film was evaluated according to the following measurement method.

(Apparatus)

Vapor deposition apparatus: Vacuum deposition apparatus JEE-400, manufactured by JEOL Ltd.
Constant temperature-constant humidity oven: Yamato Humidic Chamber IG47M
Metal corroded by reaction with water: Calcium (granular)
Moisture vapor impermeable metal: Aluminum (φ3-5 mm, granular)

(Production of Cell for Evaluation of Moisture Vapor Barrier Property)

Metal calcium was evaporated on the surface of the gas barrier layer of a sample using a vacuum deposition apparatus (vacuum deposition apparatus JEE-400, manufactured by JEOL Ltd.), while masking other than the portions to be evaporated (9 portions of 12 mm×12 mm) on the gas barrier film sample before a transparent conductive film was formed. Then, the mask was removed while the vacuum state was maintained, and aluminum was evaporated from another metal evaporation source onto the whole surface of one side of the sheet. After the aluminum sealing, the vacuum state was released, and, promptly, the aluminum sealed surface was faced with quartz glass having a thickness of 0.2 mm through a UV curable resin for sealing (manufactured by Nagase ChemteX Corporation) under dried nitrogen atmosphere, followed by being irradiated with ultraviolet light to produce the evaluation cells. In order to confirm the change in gas barrier property before and after the bending, cells for evaluation of a moisture vapor barrier property were produced also using gas barrier films which were not subjected to the above-described bending treatment.

The obtained samples with both sealed surfaces were stored under a high temperature and a high humidity of 60°C and 90% RH, and the amount of water permeated into the cell was calculated from the amount of corrosion of metal calcium based on the method described in JP- 2005- 283561- A.

In order to confirm that there is no moisture permeation from a surface other than the barrier film surface, a sample in which metal calcium was evaporated on a 0.2 mm thick quartz glass plate instead of the gas barrier film sample was stored under the same high temperature and high humidity of 60°C and 90% RH, as a comparative sample, to confirm that there was no corrosion of metal calcium even after a lapse of 1000 hours.

The water content of each gas barrier film measured as described above was classified into the following 5 stage ranks to evaluate the moisture vapor barrier property.

5: Water content of less than $1\times10^{-4}$ g/m$^2$/day
4: Water content of $1\times10^{-4}$ g/m$^2$/day or more and less than $1\times10^{-3}$ g/m$^2$/day
3: Water content of $1\times10^{-3}$ g/m$^2$/day or more and less than $1\times10^{-2}$ g/m$^2$/day
2: Water content of $1\times10^{-2}$ g/m$^2$/day or more and less than $1\times10^{-1}$ g/m$^2$/day
1: Water content of $1\times10^{-1}$ g/m$^2$/day or more

[Evaluation of Bending Resistance]

Bending of each gas barrier film was repeated 100 times at an angle of 180 degrees so that it had a radius of curvature of 10 mm, a moisture vapor transmission rate was thereafter measured by the same method as described above, the degree of deterioration resistance was measured according the following expression based on a variation in moisture vapor transmission rate before and after the bending treatment, and bending resistance was evaluated according to the following criteria.

Degree of deterioration resistance= (Moisture vapor transmittance after bending test/ Moisture vapor transmittance before bending test) ×100 (%)

5: Degree of deterioration resistance of 90% or more
4: Degree of deterioration resistance of 80% or more and less than 90%
3: Degree of deterioration resistance of 60% or more and less than 80%

2: Degree of deterioration resistance of 30% or more and less than 60%
1: Degree of deterioration resistance of less than 30%

[Evaluation of Cutting Processing Suitability]

Each gas barrier film was cut in a B5 size using a disc cutter DC-230 (CADL), each cut end was thereafter observed with a loupe, the total number of occurrences of cracking in four sides was confirmed, and cutting processing suitability was evaluated according to the following criteria.

5: No occurrence of cracking was confirmed.
4: The number of occurrences of cracking is 1 or more and 2 or less.
3: The number of occurrences of cracking is 3 or more and 5 or less.
2: The number of occurrences of cracking is 6 or more and 10 or less.
1: The number of occurrences of cracking is 11 or more.

The characteristic values and evaluation results of each gas barrier film obtained as described above are listed in Table 1 and Table 2.

[Table 1]

| Gas Barrier Film No. | Method for Forming First Barrier Layer | Second Barrier Layer | | | | | Elasticity Modulus (GPa) | | | Remarks |
|---|---|---|---|---|---|---|---|---|---|---|
| | | Conversion Means | Film Thickness (nm) | | | Conversion region Ratio (%) | First Barrier Layer E1 | Second Barrier Layer | | |
| | | | Total Film Thickness | Conversion region | Non-Conversion region | | | Conversion region E2 | Non-Conversion region E3 | |
| 1 | Atmospheric Pressure Plasma CVD | Excimer Irradiation | 100 | 30 | 70 | 30 | 30 | 20 | 15 | The Present Invention |
| 2 | Atmospheric Pressure Plasma CVD | Excimer Irradiation | 100 | 60 | 40 | 60 | 45 | 30 | 15 | The Present Invention |
| 3 | Vacuum CVD | Excimer Irradiation | 100 | 30 | 70 | 30 | 30 | 30 | 25 | The Present Invention |
| 4 | Atmospheric Pressure Plasma CVD | Atmospheric Pressure Plasma Treatment | 100 | 10 | 90 | 10 | 30 | 15 | 10 | The Present Invention |
| 5 | Atmospheric Pressure Plasma CVD | UV Lamp Treatment | 60 | 55 | 5 | 92 | 45 | 35 | 20 | The Present Invention |
| 6 | - | Excimer Irradiation | 100 | 0 | 100 | 0 | - | - | - | Comparative Example |
| 7 | Vacuum CVD | Heat Treatment | 100 | 0 | 100 | 0 | 30 | - | 30 | Comparative Example |
| 8 | Atmospheric Pressure Plasma CVD | Heat Treatment | 100 | 0 | 100 | 0 | 30 | - | 30 | Comparative Example |

[Table 2]

| Gas Barrier Film No. | Moisture Vapor Barrier Property | Bending Resistance | Cutting Processing Suitability | Remarks |
|---|---|---|---|---|
| 1 | 5 | 5 | 4 | The Present Invention |
| 2 | 5 | 5 | 5 | The Present Invention |
| 3 | 5 | 4 | 4 | The Present Invention |
| 4 | 4 | 4 | 4 | The Present Invention |
| 5 | 3 | 4 | 3 | The Present Invention |
| 6 | 3 | 3 | 1 | Comparative Example |
| 7 | 3 | 2 | 1 | Comparative Example |
| 8 | 2 | 2 | 2 | Comparative Example |

As is clear from the results described in Table 1 and Table 2, the gas barrier films 1 to 5 of the present invention are found to be superior in moisture vapor barrier property as well as to be superior in bending resistance and cutting processing suitability, to the gas barrier films 6 to 8 of Comparative Examples. In addition, the moisture vapor transmission rate of the gas barrier film 5 was $1\times10^{-3}$ g/m$^2$/day, the moisture vapor transmission rate of the gas barrier film 6 was $9\times10^{-3}$ g/m$^2$/day, and the moisture vapor transmission rate of the gas barrier film 7 was $7\times10^{-3}$ g/m$^2$/day.

Example 2

«Production of Organic Photoelectric Conversion Element»

On each of the gas barrier films 1 to 8 produced in Example 1, on which an indium-tin oxide (ITO) transparent conductive film of 150 nm was deposited, (sheet resistance of 10 Ω/□), a first electrode was formed by patterning in 2 mm width using a usual photolithography technique and wet etching. The patterned first electrode was cleaned in sequential steps of ultrasonic cleaning with a surfactant and ultrapure water and ultrasonic cleaning with ultrapure water, followed by drying under a nitrogen blow, and, finally, cleaned by ultraviolet/ozone cleaning.

On this transparent substrate, Baytron P4083 (manufactured by Starck Vitec, Co.), which was a conductive polymer, was coated and dried to have a (average) film thickness of 30 nm, followed by being subjected to heat treatment at 150°C for 30 minutes to form a hole transport layer.

After that, each substrate was carried into a nitrogen chamber and operation was carried out under a nitrogen atmosphere.

First, the above- described substrate was heat- treated at 150°C for 10 minutes under a nitrogen atmosphere. Then, a liquid obtained by mixing, in chlorobenzene, 3.0% by mass of 1: 0.8 mixture of P3HT (manufactured by Plextronics, Inc.: regioregular- poly- 3- hexylthiophene) and PCBM (manufactured by Frontier Carbon Corporation: 6, 6- phenyl- C61- butyric acid methyl ester) was prepared, coated, while filtering with a filter, so that the (average) film thickness was 100 nm, and dried while left unattended at room temperature. Subsequently, heat treatment was carried out at 150°C for 15 minutes, whereby a photoelectric conversion layer was formed.

Next, the substrate on which the above- described series of function layers were formed was moved into the chamber of a vacuum deposition apparatus, and, after the pressure of the inside of the vacuum deposition apparatus was decreased to $1\times10^{-4}$ Pa or less, lithium fluoride of 0.6 nm was thereafter laminated at a deposition rate of 0.01 nm/sec, and, subsequently, metallic Al of 100 nm was laminated at a deposition rate of 0.2 nm/sec through a shadow mask having a width of 2 mm (vapor deposition was conducted by orthogonally crossing the masks so that the light-receiving section became 2×2 mm), whereby a second electrode was formed. The obtained organic photoelectric conversion elements were moved to a nitrogen chamber, sealing was conducted using a cap for sealing and UV cured resin, and the organic photoelectric conversion elements 1 to 13, each element having a light- receiving section with a 2×2 mm size, were produced.

[Sealing of Organic Photoelectric Conversion Element]

Under an environment purged with a nitrogen gas (inert gas), using two sheets of gas barrier films 1 to 8, the surface on which the gas barrier layer was disposed was coated with an epoxy-based photo-curable adhesive as a sealant. The organic photoelectric conversion elements corresponding to the gas barrier films 1 to 8 obtained by the above-mentioned method were sandwiched between the adhesive-coated surfaces of the two sheets of the gas barrier films 1 to 8 coated with the above-described adhesive and were tightly adhered, followed by irradiated with UV light from the substrate side of one side to be cured to each make the organic photoelectric conversion elements 1 to 8.

«Evaluation of Organic Photoelectric Conversion Element»

The durability of the organic photoelectric conversion elements produced as described above was evaluated by the following method.

[Evaluation of Durability]

<Energy Conversion Efficiency>

Irradiation with light having an intensity of 100 mW/cm$^2$ from a solar simulator (AM 1.5 G filter) was carried out; and, by evaluating an IV property while placing a mask with an effective area of 4.0 mm$^2$ on a light-receiving section, a short-circuit current density Jsc (mA/cm$^2$), an open voltage Voc (V), and a fill factor FF (%) were determined to evaluate an average of the four energy conversion efficiencies PCE (%) calculated according to the following expression 1 for each of the four light-receiving sections formed on the same element.

Expression 1

$$PCE(\%) = [Jsc(mA/cm^2) \times Voc(V) \times FF(\%)] / 100\ mW/cm^2$$

The conversion efficiency as an initial cell property was measured, and the degree of time degradation of the property was evaluated from the residual ratio of the conversion efficiency after an accelerated test of storing under an environment at a temperature of 60°C and a humidity of 90% RH for 1000 hours.

$$\text{Residual ratio of conversion efficiency} = \text{Conversion efficiency after accelerated test} / \text{Initial conversion efficiency} \times 100\ (\%)$$

5: The residual ratio of conversion efficiency of 90% or more
4: The residual ratio of conversion efficiency of 70% or more and less than 90%
3: The residual ratio of conversion efficiency of 40% or more and less than 70%
2: The residual ratio of conversion efficiency of 20% or more and less than 40%
1: The residual ratio of conversion efficiency of less than 20%

The results obtained as described above are listed in Table 3.

[Table 3]

| Organic Conversion Photoelectric Element No. | Gas Barrier Film No. | Durability | Remarks |
|---|---|---|---|
| 1 | 1 | 5 | The Present Invention |
| 2 | 2 | 5 | The Present Invention |
| 3 | 3 | 5 | The Present Invention |
| 4 | 4 | 4 | The Present Invention |
| 5 | 5 | 3 | The Present Invention |
| 6 | 6 | 2 | Comparative Example |
| 7 | 7 | 1 | Comparative Example |
| 8 | 8 | 2 | Comparative Example |

As is clear from the results described in Table 3, it is found that occurrence of performance degradation is precluded even under a severe environment in the organic photoelectric conversion elements 1 to 5 of the present invention produced using the gas barrier films of the present invention in comparison with the organic photoelectric conversion elements 6 to 8 of Comparative Examples.

Example 3

«Production of Gas Barrier Film»

Production]

[Production of Sample 3-1]

A gas barrier film was produced in the same manner as in the case of the sample 2 described in Example 1 except that the resin base was changed from polyethylene terephthalate to polyimide-based heat-resistant film (NEOPULIM L3430, manufactured by Mitsubishi Gas Chemical Company, Inc., thickness 200 μm) and there was disposed, as an intermediate layer (smooth layer), a cured film obtained by curing a UV curable acryl resin (OPSTAR Z7501, manufactured by JSR Corporation) with ultraviolet rays, then coating the resultant to be 5 μm, which was cured by UV light irradiation at 1 J/cm$^2$ using a high-pressure mercury lamp in a $N_2$-purged atmosphere in the production of the sample 2 described in Example 1, ITO of 100 nm was thereafter formed on a gas barrier unit by a sputtering method (room temperature), heat treatment was carried out at 220°C for 1 hr in the air in order to decrease the resistivity of ITO, and a sample 3-1 which was a gas barrier film was produced. When the surface specific resistance of an ITO surface was measured after the heat treatment, it was 20 Ω/□, so that it was confirmed that it became a surface with low resistance.

[Production of Sample 3-2]

A sample 3-2 which was a gas barrier film was produced in the same manner except that an intermediate layer was formed using an intermediate layer coating liquid described below in the production of the above-described sample 3-1.

<Production of Intermediate Layer Coating Liquid>

There were mixed 8.0 g of trimethylolpropane triglycidyl ether (EPOLIGHT 100MF, manufactured by Kyoeisha Chemical Co. , Ltd.), 5.0 g of ethylene glycol diglycidyl ether (EPOLIGHT 40E, manufactured by Kyoeisha Chemical Co., Ltd.), 12.0 g of silsesquioxane having an oxetanyl group: OX- SQ- H (manufactured by Toagosei Co., Ltd.) (which becomes an organic- inorganic hybrid resin by heat- curing), 32.5 g of 3- glycidoxypropyltrimethoxysilane, 2.2 g of Al (III) acetylacetonate, 134.0 g of methanol silica sol (manufactured by Nissan Chemical Industries, Ltd., solid content concentration of 30 mass%), 0.1 g of BYK333 (manufactured by BYK- Chemie GmbH), 125.0 g of butyl cellosolve, and 15.0 g of 0.1 mol/L aqueous hydrochloric acid, and the mixture was stirred sufficiently. The resultant was further left at rest and degassed at room temperature to obtain an intermediate layer coating liquid.

<Formation of Intermediate Layer 1>

One surface of the above-described base was subjected to corona discharge treatment by a usual method, then coated with the intermediate layer coating liquid prepared as described above so that the film thickness after drying was 4.0 μm, and dried at 80°C for 3 minutes. Heat treatment was further performed at 120°C for 10 minutes to form an intermediate layer 1.

<Surface Roughness of Intermediate Layer>

The surface roughness of the obtained intermediate layer 1 was about 20 nm by Rz specified in JIS B 0601.
The surface roughness was measured using AFM (atomic force microscope) SPI3800NDFM manufactured by SII. A measured range at one step was 80 μm×80 μm, three measurements were carried out on different measurement spots, and the average of Rt values obtained in the respective measurements was regarded as a measured value.

[Production of Sample 3-3]

A sample 3-3 which was a gas barrier film was produced in the same manner except that an intermediate layer 2 was also formed on the surface opposite to the surface on which the intermediate layer 1 of the base was formed in the same manner as in the case of the intermediate layer 1 in the production of the above-described sample 3-2.

[Production of Sample 3-4]

A sample 3-4 which was a gas barrier film was produced in the same manner except that the film base was changed to a highly transparent polyimide-based heat-resistant film (manufactured by Toyobo Co., Ltd., Type HM, Tg=225°C, thickness 18 μm) in the production of the above-described sample 3-2.

[Production of Sample 3-5]

A sample 3-5 which was a gas barrier film was produced in the same manner except that the intermediate layer 2 was also formed on the surface opposite to the surface on which the intermediate layer 1 of the base was formed in the same manner as in the case of the intermediate layer 1 in the production of the above-described sample 3-4.

[Production of Sample 3-6]

A sample 3-6 which was a gas barrier film was produced in the same manner except that a thermosetting epoxy-based resin (manufactured by DIC Corporation; EPICLON EXA-4710, added with 2 phr of curing agent, imidazole (2E4MZ)) was used instead of the intermediate layer 1 and an intermediate layer 3 was used under the curing conditions of 200°C and 1 hr in the production of the above-described sample 3-2.

[Production of Sample 3-7]

A sample 3-7 which was a gas barrier film was produced in the same manner except that an intermediate layer 4 was also formed on the surface opposite to the surface on which the intermediate layer 3 of the base was formed in the same manner as in the case of the intermediate layer 3 in the production of the above-described sample 3-6.

<Surface Roughness of Intermediate Layer 3 or 4>

The surface roughness of each of the formed intermediate layer 3 and 4 was about 25 nm by Rz specified in JIS B 0601.
The surface roughness was measured using AFM (atomic force microscope) SPI3800NDFM manufactured by SII. A measured range at one step was 80 μm×80 μm, three measurements were carried out on different measurement spots, and the average of Rt values obtained in the respective measurements was regarded as a measured value.

«Evaluation of Gas Barrier Film»

For each sample produced as described above, the measurement of the film thickness of the conversion region, the measurement of the elasticity modulus, and the evaluation of the moisture vapor barrier property, the bending resistance and the cutting processing suitability were carried out in the same manner as the method described in Example

1 while the below-mentioned evaluation of film surface durability was carried out.

(Evaluation of Film Surface Durability)

Film surface quality (delamination, deformation, discoloration, crazing) of each sample was evaluated by visual observation before and after the heat treatment at 220°C to evaluate film surface durability according to the following criteria:

○: Deterioration is hardly observed in any items before and after heat treatment.
Δ: There is any item in which slight deterioration occurs before and after heat treatment.
×: There are one or more items in which obvious deterioration is visually observed.

The constitutions and characteristic values of the samples 3-1 to 3-7 are listed in Table 4 and each evaluation result is listed in Table 5.

[Table 4]

| Sample No. | Base Film | | Intermediate Layer | | *1 | Second Barrier Layer | | | | | | Elasticity Modulus (GPa) | | | Remarks |
|---|---|---|---|---|---|---|---|---|---|---|---|---|---|---|---|
| | | | | | | | | Film Thickness (nm) | | | | | Second Barrier Layer | | |
| | Type | Tg (°C) | Material | Arrangement Position | | Formation Source Material | Conversion Means | Total Film Thickness | Conversion region | Non-Conversion region | Conversion region Ratio (%) | First Barrier Layer E1 | Conversion region E2 | Non-Conversion region E3 | |
| 3-1 | *B | 303 | *D | One Surface | *2 | PHPS | *3 | 100 | 60 | 40 | 60 | 45 | 35 | 25 | The Present Invention |
| 3-2 | *B | 303 | *E | One Surface | *2 | PHPS | *3 | 100 | 60 | 40 | 60 | 45 | 35 | 25 | The Present Invention |
| 3-3 | *B | 303 | *E | Both Surfaces | *2 | PHPS | *3 | 100 | 60 | 40 | 60 | 45 | 35 | 25 | The Present Invention |
| 3-4 | *C | 225 | *E | One Surface | *2 | PHPS | *3 | 100 | 60 | 40 | 60 | 45 | 35 | 25 | The Present Invention |
| 3-5 | *C | 225 | *E | Both Surfaces | *2 | PHPS | *3 | 100 | 60 | 40 | 60 | 45 | 35 | 25 | The Present Invention |
| 3-6 | *B | 303 | *F | One Surface | *2 | PHPS | *3 | 100 | 60 | 40 | 60 | 45 | 35 | 25 | The Present Invention |

(continued)

| Sample No. | Base Film | | Intermediate Layer | | *1 | Second Barrier Layer | | | | | | Elasticity Modulus (GPa) | | | Remarks |
|---|---|---|---|---|---|---|---|---|---|---|---|---|---|---|---|
| | | | | | | Formation Source Material | Conversion Means | Film Thickness (nm) | | | Conversion region Ratio (%) | First Barrier Layer E1 | Second Barrier Layer | | |
| | Type | Tg (°C) | Material | Arrangement Position | | | | Total Film Thickness | Conversion region | Non-Conversion region | | | Conversion region E2 | Non-Conversion region E3 | |
| 3-7 | *B | 303 | *F | Both Surfaces | *2 | PHPS | *3 | 100 | 60 | 40 | 60 | 45 | 35 | 25 | The Present Invention |

*A: Polyethylene terephthalate film *1: Method for forming first barrier layer
*B: Polyimide *2: Atmospheric plasma CVD method
*C: Highly transparent polyimide *3: Excimer irradiation
*D: UV cured resin PHPS: Perhydropolysilazane
*E: Heat-cured organic-inorganic hybrid resin
*F: Heat-cured epoxy-based resin

[Table 5]

| Sample No. | Moisture Vapor Barrier Property | Bending Resistance | Cutting Processing Suitability | Film Surface Durability | Remarks |
|---|---|---|---|---|---|
| 3-1 | 4 | 4 | 5 | Δ | The Present Invention |
| 3-2 | 5 | 5 | 4 | ○ | The Present Invention |
| 3-3 | 5 | 5 | 4 | ○ | The Present Invention |
| 3-4 | 4 | 5 | 4 | ○ | The Present Invention |
| 3-5 | 5 | 5 | 4 | ○ | The Present Invention |
| 3-6 | 5 | 5 | 5 | ○ | The Present Invention |
| 3-7 | 5 | 5 | 5 | ○ | The Present Invention |

«Production of Photoelectric Conversion Element»

Photoelectric conversion elements 3-1 to 3-7 were produced in the same manner as the method described in Example 2 using the samples 3-1 to 3-7 which were the gas barrier films produced by the above-described method. A temperature humidity cycle test for the produced photoelectric conversion elements 3-1 to 3-7 was conducted under the conditions in conformity with JIS C8938 (1995), photoelectric conversion efficiency was measured after humidity conditioning at 60°C and 90% RH for 1000 hr, the degree of the deterioration of the conversion efficiency before and after the temperature humidity cycle test (durability 2) was evaluated in the same manner as the method described in Example 2, and the obtained results are listed in Table 6.

[Table 6]

| Photoelectric Conversion Element No. | Gas Barrier Film Sample No. | Durability 2 | Remarks |
|---|---|---|---|
| 3-1 | 3-1 | 4 | The Present Invention |
| 3-2 | 3-2 | 5 | The Present Invention |
| 3-3 | 3-3 | 5 | The Present Invention |
| 3-4 | 3-4 | 4 | The Present Invention |
| 3-5 | 3-5 | 4 | The Present Invention |
| 3-6 | 3-6 | 5 | The Present Invention |
| 3-7 | 3-7 | 5 | The Present Invention |

As is clear from the results described in Table 6, the photoelectric conversion elements produced using the gas barrier films of the present invention are found to be excellent in durability 2.

Example 4

A temperature humidity cycle test for the photoelectric conversion elements 3-1 to 3-7 produced using the samples 3-1 to 3-7 which were the gas barrier films produced in Example 3 was conducted under the conditions in conformity with JIS C8938 (1995), photoelectric conversion efficiency was measured after humidity conditioning at 25°C

and 50% RH for 15 hr, the degree of the deterioration of the conversion efficiency before and after the temperature humidity cycle test (durability 3) was evaluated in the same manner as the method described in Example 2, and the obtained results are listed in Table 7.

[Table 7]

| Photoelectric Conversion Element No. | Gas Barrier Film Sample No. | Durability 3 | Remarks |
|---|---|---|---|
| 3-1 | 3-1 | 4 | The Present Invention |
| 3-2 | 3-2 | 4 | The Present Invention |
| 3-3 | 3-3 | 5 | The Present Invention |
| 3-4 | 3-4 | 4 | The Present Invention |
| 3-5 | 3-5 | 5 | The Present Invention |
| 3-6 | 3-6 | 4 | The Present Invention |
| 3-7 | 3-7 | 5 | The Present Invention |

As is clear from the results described in Table 7, the photoelectric conversion elements produced using the gas barrier films of the present invention are found to be excellent in durability.

In each evaluation as described above, as is clear from the results of Examples 3 and 4, it was found that use of a heat-resistant base and a thermosetting smooth layer enables not only improvement in initial properties of a device due to reduction in resistance of the conductive layer but also simultaneous improvement in durability of a device due to improvement in gas barrier property and interlaminar adhesiveness. It was further found that durability is improved under a severe environment like high temperature and high humidity by disposing a gas barrier layer on both front and back surfaces of a base.

The present application is based on Japanese Patent Application No. 2010-271234 filed on December 6, 2010, of which the disclosure is incorporated by reference in their entirety.

Reference Signs List

1 Gas barrier film
2 Base
3 Intermediate layer
4 Gas barrier layer unit
4A Second barrier layer
4B First barrier layer
L Conversion treatment means
10 Bulk heteroj unction type organic photoelectric conversion element
11 Substrate
12 Transparent electrode
13 Counter electrode
14 Electric power generation layer
14p p layer
14i i layer
14n n layer
14' First electric power generation layer
15 Charge recombination layer
16 Second electric power generation layer
17 Hole transport layer
18 Electron transport layer
101 Plasma CVD apparatus usable in the present invention
102 Vacuum tank
103 Cathode electrode
105 Susceptor

106 Heat medium circulating system
107 Vacuum pumping system
108 Gas introduction system
109 High frequency power source
110 Substrate
160 Heating cooling apparatus

**Claims**

1. A gas barrier film, comprising a gas barrier layer unit on at least one surface side of a base, wherein the gas barrier layer unit comprises a first barrier layer formed by a chemical vapor deposition method, a second barrier layer obtained by performing conversion treatment to a coating film formed by coating a silicon compound onto the first barrier layer and an intermediate layer between the first barrier layer and the base.

2. The gas barrier film according to claim 1, wherein the first barrier layer formed by the chemical vapor deposition method comprises at least one selected from silicon oxide, silicon oxynitride, and silicon nitride.

3. The gas barrier film according to claim 1 or 2, wherein the second barrier layer formed on the first barrier layer is obtained by performing conversion treatment to a coating film formed by coating a polysilazane-containing liquid and comprises a non-conversion region in the base surface side and a conversion region in a surface layer side.

4. The gas barrier film according to clam 3, wherein a thickness ratio of the thickness of the conversion region located in the surface layer side of the second barrier layer to the total film thickness of the second barrier layer is 0.2 or more and 0.9 or less.

5. The gas barrier film according to claim 3 or 4, wherein the first barrier layer formed by the chemical vapor deposition method comprises silicon oxide or silicon oxynitride; and, assuming that the elasticity modulus of the first barrier layer is E1, the elasticity modulus of the conversion region in the second barrier layer is E2, and the elasticity modulus of the non-conversion region in the second barrier layer is E3, a relationship of $E1>E2>E3$ is satisfied.

6. A method for producing a gas barrier film according to any one of claims 3 to 5, wherein the conversion treatment performed when the second barrier layer is formed is treatment of irradiation with a vacuum ultraviolet ray including a wavelength component of 180 nm or less.

7. An electronic device, wherein the gas barrier film according to any one of claims 1 to 5 is used.

FIG.1

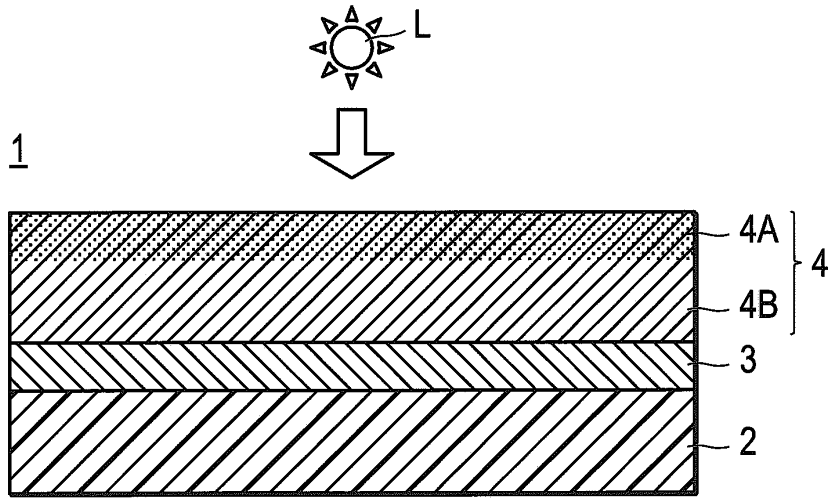


FIG.2

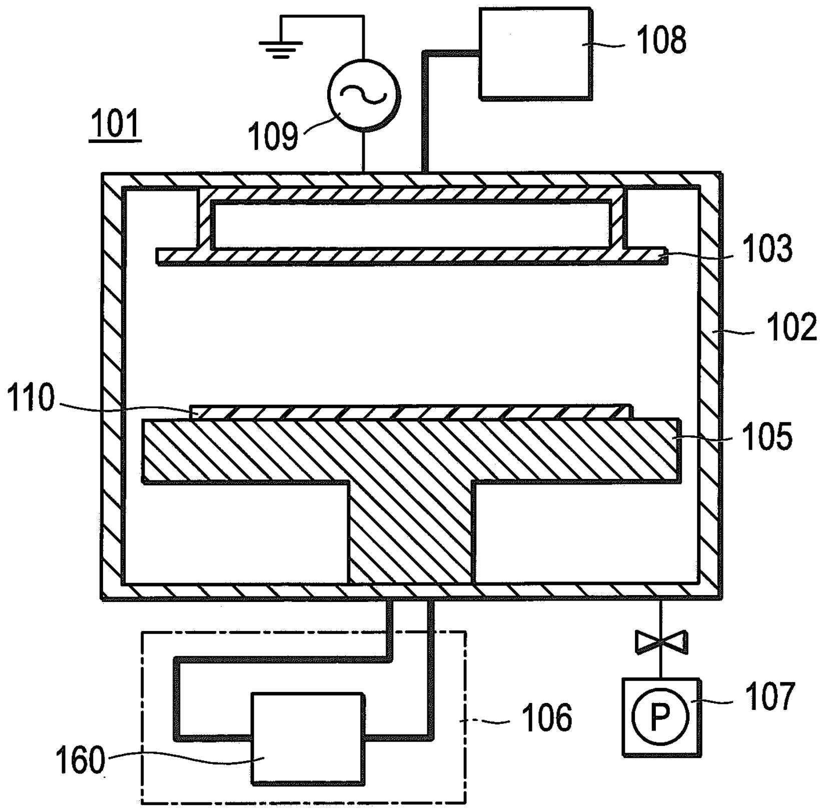

FIG.3

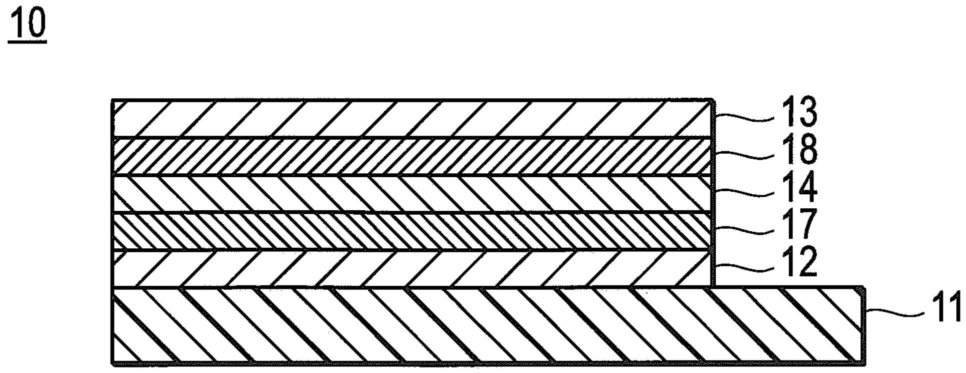


FIG.4

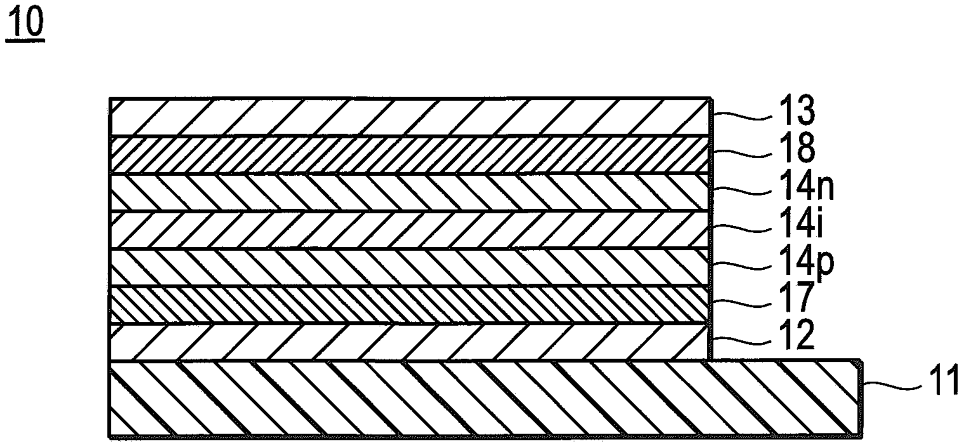

FIG.5

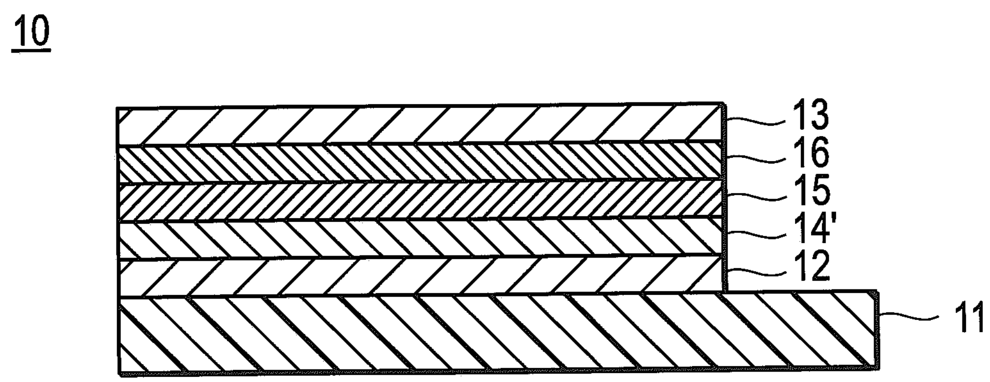

**INTERNATIONAL SEARCH REPORT**

International application No.
PCT/JP2011/077668

A. CLASSIFICATION OF SUBJECT MATTER
*B32B9/00*(2006.01)i

According to International Patent Classification (IPC) or to both national classification and IPC

B. FIELDS SEARCHED

Minimum documentation searched (classification system followed by classification symbols)
B32B9/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| E,A | WO 2012/014653 A1 (Konica Minolta Holdings, Inc.), 02 February 2012 (02.02.2012), entire text (Family: none) | 1-7 |
| P,A | WO 2011/007543 A1 (Mitsui Chemicals, Inc.), 20 January 2011 (20.01.2011), entire text (Family: none) | 1-7 |
| A | JP 3511325 B2 (Mitsui Chemicals, Inc.), 29 March 2004 (29.03.2004), entire text & JP 8-281861 A | 1-7 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 27 February, 2012 (27.02.12) | 06 March, 2012 (06.03.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009255040 A
- JP 3511325 B
- JP 2008235165 A
- WO 2007026545 A
- JP 8112879 A
- JP 5238827 A
- JP 6122852 A
- JP 6240208 A
- JP 6299118 A
- JP 6306329 A
- JP 7196986 A
- WO 200595924 A
- JP 2005283561 A
- WO 0316599 A
- WO 0328125 A
- US 6690029 B
- JP 2004107216 A
- US 2003136964 A
- WO 2008000664 A
- JP 2008016834 A
- JP 2006199674 A
- JP 2008130889 A
- US 7329709 B
- WO 2006019270 A
- JP 2006233252 A
- JP 2002266007 A
- JP 2004149871 A
- JP 2008056967 A
- JP 2010271234 A


### Non-patent literature cited in the description


- *JIS K 7129,* 1992
- *JIS K7126,* 1987
- *J. Amer. Chem. Soc.,* vol. 127 (14), 4986
- *J. Amer. Chem. Soc.,* vol. 123, 9482
- *J. Amer. Chem. Soc.,* 2008, vol. 130, 2706
- *Technical Digest of the International PVSEC-17, Fukuoka, Japan,* 2007, 1225
- *Nature Material,* 2006, vol. 5, 328
- *Adv Mater,* 2007, 4160
- *Nature Mat.,* 2007, vol. 6, 497
- *Adv. Mater.,* 2008, vol. 20, 2116
- *Adv. Mater.,* 2002, vol. 14, 833-837
- *Chem. Mater.,* 2002, vol. 14, 4736-4745